# EUROPEAN PATENT APPLICATION

(11) **EP 4 219 631 A1**
(43) Date of publication of application: **02.08.2023**
(21) Application number: 21872486.2
(22) Date of filing: 22.09.2021
(51) Int. Cl.: C09B 35/025, C08F 220/06, C08F 220/32, C08F 222/40, G03F 7/004, G02B 5/20, C09B 67/20

(54) **COLORING COMPOSITION**

(30) Priority: 28.09.2020 JP 2020162452
(71) Applicant: SUMITOMO CHEMICAL COMPANY, LIMITED, Tokyo 103-6020 (JP); Dongwoo Fine-Chem Co., Ltd., Iksan-si, Jeollabuk-do 54631 (KR); Sumika Technology Co., Ltd., Tainan City 74144 (TW)
(72) Inventor: MANABE, Hitomi, Osaka-shi, Osaka 554-8558 (JP); TAKAISHI, Yu, Osaka-shi, Osaka 554-8558 (JP); TSUJIUCHI, Sho, Osaka-shi, Osaka 554-8558 (JP); TOGAI, Manabu, Osaka-shi, Osaka 554-8558 (JP)
(74) Representative: Vossius & Partner Patentanwälte Rechtsanwälte mbB
(86) International application number: PCT/JP2021/034779
(87) International publication number: WO 2022/065357

(57) **Abstract**

The present invention addresses the problem of providing a colored composition capable of forming a color filter having excellent UV ashing resistance. This problem is solved by a colored composition comprising an alkali soluble resin and a colorant containing a compound represented by formula (I):

A-L¹-B (I)

wherein L¹ represents a group represented by formula (ph1), A represents a group represented by formula (ia), and B represents a group represented by formula (ib).

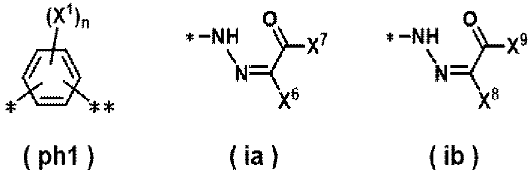

## Description

### TECHNICAL FIELD

The present invention relates to a colored composition, a color filter formed from the colored composition, and a display device comprising the color filter.

### BACKGROUND ART

A color filter used for display devices such as a liquid crystal display device, an electroluminescence display device, and a plasma display, and solid-state image sensors such as a CCD sensor and a CMOS sensor is produced from a colored resin composition. A compound represented by formula (x1) is known as a colorant for such a colored resin composition (Patent Document 1).

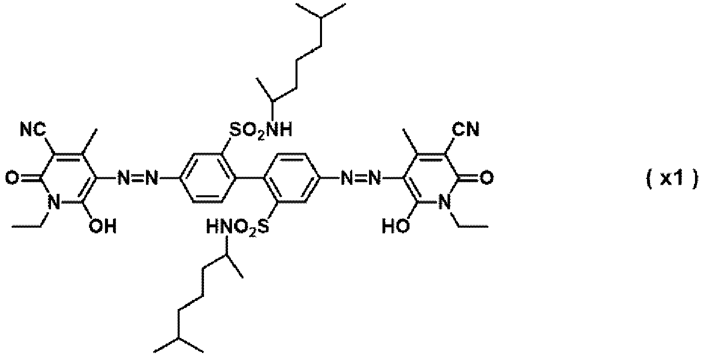

### PRIOR ART DOCUMENT

### PATENT DOCUMENT

Patent Document 1: JP 2015-61907 (A)

### SUMMARY OF THE INVENTION

### PROBLEMS TO BE SOLVED BY THE INVENTION

However, a color filter formed from a colored resin composition using the above conventionally known compound may fail to sufficiently satisfy UV ashing resistance. The present invention addresses the problems of providing a colored composition capable of forming a color filter having excellent UV ashing resistance.

### SOLUTIONS TO THE PROBLEMS

The gist of the present invention is as follows.
[1] A colored composition comprising a colorant and an alkali soluble resin,
   wherein the colorant comprises a compound represented by formula (I):

   A-L¹-B (I)

   wherein
   L¹ represents a group represented by formula (ph1);
   A represents a group represented by formula (ia); and
   B represents a group represented by formula (ib), 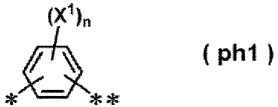 wherein
   X¹ represents a substituent or a hydrocarbon group optionally having a substituent, -CH₂- contained in the hydrocarbon group may be replaced with -O-, -CO- or -NH-, and -CH= contained in the hydrocarbon group may be replaced with -N=;
   n represents an integer of 0 to 4, when n is an integer of 2 or more, X¹s are the same or different, and when n is an integer of 2 or more and X¹s are bonded to adjacent carbon atoms, X¹s bonded to the adjacent carbon atoms may be combined with each other to form a ring; and
   * represents a point of attachment to A, and ** represents a point of attachment to B, 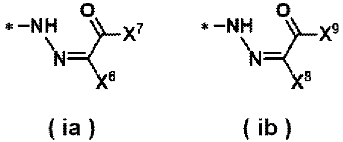 wherein
   X⁶ to X⁹ each independently represent a hydrocarbon group optionally having a substituent, -CH₂- contained in the hydrocarbon group may be replaced with -O-, -CO- or -NH-, -CH= contained in the hydrocarbon group may be replaced with -N=, and -C< contained in the hydrocarbon group may be replaced with -N<;
   X⁶ and X⁷ may be combined with each other to form a ring, and X⁸ and X⁹ may be combined with each other to form a ring; and
   * represents a point of attachment to L¹.
[2] The colored composition according to [1], wherein L¹ is a group represented by formula (ph2): 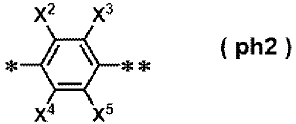 wherein
   X² to X⁵ each independently represent a hydrogen atom, a C₁-C₄ alkyl group, an amino group, an amido group, a carboxyl group, a C₁-C₄ alkoxy group, a C₁-C₄ alkylthio group, a cyano group, or a halogen atom;
   X² and X³, and X⁴ and X⁵ may be combined with each other to form a ring; and
   * represents a point of attachment to A, and ** represents a point of attachment to B.
[3] The colored composition according to [1] or [2], wherein the group represented by the formula (ia) and the group represented by the formula (ib) are each independently any of groups represented by formulas (t1) to (t5): 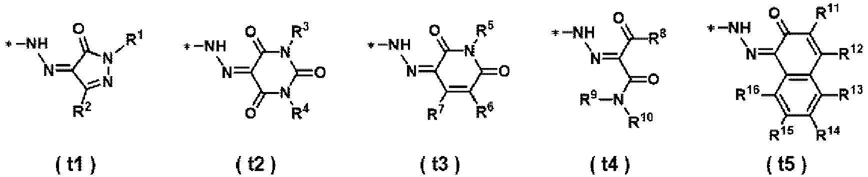 wherein
   R¹ to R¹⁶ each independently represent a hydrogen atom, a hydrocarbon group optionally having a substituent, a heterocyclic group, a cyano group, or a halogen atom; and
   * represents a point of attachment to L¹.
[4] The colored composition according to any one of [1] to [3], further comprising a polymerizable compound and a polymerization initiator.
[5] A color filter formed from the colored composition according to any one of [1] to [4].
[6] A display device comprising the color filter according to [5].

### EFFECT OF THE INVENTION

A colored composition of the present invention can provide a color filter having excellent UV ashing resistance.

### MODE FOR CARRYING OUT THE INVENTION

The colored composition of the present invention contains a colorant comprising a compound represented by formula (I) (hereinafter, the colorant is sometimes referred to as a colorant (A)) and an alkali soluble resin (hereinafter, sometimes referred to as a resin (B)).

The colored composition of the present invention preferably further contains a polymerizable compound (hereinafter, sometimes referred to as a polymerizable compound (C)) and a polymerization initiator (hereinafter, sometimes referred to as a polymerization initiator (D)).

The colored composition of the present invention preferably further contains a solvent (hereinafter, sometimes referred to as a solvent (E)).

The colored composition of the present invention may contain a leveling agent (hereinafter, sometimes referred to as a leveling agent (F)).

Herein, compounds exemplified as each component may be used singly or in combination of a plurality thereof unless otherwise noted.

### <Colorant (A)>

The colorant (A) contains a compound represented by formula (I) (hereinafter sometimes referred to as compound (I)). When the colorant (A) contains the compound (I), the color filter produced has improved UV ashing resistance, and preferably improved UV ashing resistance and improved heat resistance.

A-L¹-B (I)

wherein
L¹ represents a group represented by formula (ph1);
A represents a group represented by formula (ia); and
B represents a group represented by formula (ib), 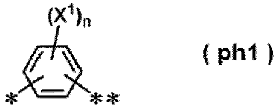 wherein
   X¹ represents a substituent or a hydrocarbon group optionally having a substituent, -CH₂- contained in the hydrocarbon group may be replaced with -O-, -CO- or -NH-, and -CH= contained in the hydrocarbon group may be replaced with -N=;
   n represents an integer of 0 to 4, when n is an integer of 2 or more, X¹s are the same or different, and when n is an integer of 2 or more and X¹s are bonded to adjacent carbon atoms, X¹s bonded to the adjacent carbon atoms may be combined with each other to form a ring; and
   * represents a point of attachment to A, and ** represents a point of attachment to B, 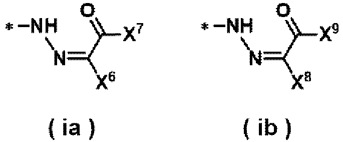 wherein
   X⁶ to X⁹ each independently represent a hydrocarbon group optionally having a substituent, -CH₂- contained in the hydrocarbon group may be replaced with -O-, -CO- or -NH-, -CH= contained in the hydrocarbon group may be replaced with -N=, and -C< contained in the hydrocarbon group may be replaced with -N<;
   X⁶ and X⁷, and X⁸ and X⁹ may be combined with each other to form a ring; and
   * represents a point of attachment to L¹.

Hereinafter, the compound (I) will be described in detail. The compound (I) includes a compound having a resonance structure of formula (I), a tautomer of formula (I), and a compound obtained by rotating each group in formula (I) around a bonding axis of a single bond. Examples of the tautomer of formula (I) include a compound represented by formula (I) in which A is a group represented by formula (iia); a compound represented by formula (I) in which B is a group represented by formula (iib); and a compound represented by formula (I) in which A is a group represented by formula (iia) and B is a group represented by formula (iib). 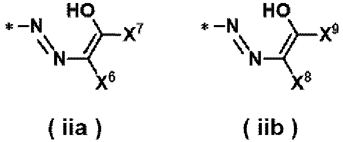 In formulas (iia) and (iib), X⁶ to X⁹ and * are the same as mentioned above.

Examples of the substituent represented by X¹ in formula (ph1) (hereinafter sometimes referred to as substituent A) include an amino group, an amido group, a carboxyl group, a C₁-C₄ alkoxy group, a C₁-C₄ alkylthio group, a cyano group, and a halogen atom.

The hydrocarbon group represented by X¹ may be an aliphatic hydrocarbon group or an aromatic hydrocarbon group. The aliphatic hydrocarbon group may be saturated or unsaturated and may be chain or cyclic (alicyclic hydrocarbon group). The alicyclic hydrocarbon group may be monocyclic or polycyclic.

Examples of the saturated chain hydrocarbon group (hereinafter, sometimes referred to as an alkyl group) include straight-chain alkyl groups such as methyl, ethyl, propyl, butyl, pentyl, hexyl, heptyl, octyl, nonyl, and decyl; and branched-chain alkyl groups such as isopropyl, isobutyl, sec-butyl, tert-butyl, 1,3-dimethylbutyl, 2-ethylbutyl, and 2-ethylhexyl.

Examples of the unsaturated chain hydrocarbon group include alkenyl groups such as ethenyl, propenyl (for example, 1-propenyl and 2-propenyl), and butenyl (for example, 1-butenyl and 3-butenyl); and alkynyl groups such as ethynyl, propynyl (for example, 1-propynyl and 2-propynyl), and butynyl (for example, 1-butynyl and 3-butynyl).

The saturated or unsaturated chain hydrocarbon group preferably has 1 to 10 carbon atoms, more preferably 1 to 6 carbon atoms, and still more preferably 1 to 4 carbon atoms.

Examples of the saturated alicyclic hydrocarbon group include cycloalkyl groups such as cyclopropyl, 1-methylcyclopropyl, cyclobutyl, cyclopentyl, cyclohexyl, and 2-methylcyclohexyl.

Examples of the unsaturated alicyclic hydrocarbon group include cycloalkenyl groups such as cyclohexenyl (for example, cyclohex-1-en-1-yl, cyclohex-2-en-1-yl, and cyclohex-3-en-1-yl), cycloheptenyl, and cyclooctenyl.

Examples of the alicyclic hydrocarbon group also include saturated polycyclic hydrocarbon groups such as norbornyl, adamantyl, and bicyclo[2.2.2]octyl; and unsaturated polycyclic hydrocarbon groups such as norbornenyl.

The alicyclic hydrocarbon group preferably has 3 to 12 carbon atoms, more preferably 3 to 10 carbon atoms, and still more preferably 3 to 8 carbon atoms.

Examples of the aromatic hydrocarbon group include phenyl, o-tolyl, m-tolyl, p-tolyl, 2,4-dimethylphenyl, 2,6-dimethylphenyl, 2,4,6-trimethylphenyl, 2,4-diisopropylphenyl, 2,6-diisopropylphenyl, 4-vinylphenyl, o-tert-butylphenyl, m-tert-butylphenyl, p-tert-butylphenyl, 3,5-di(tert-butyl)phenyl, 1-naphthyl, 2-naphthyl, and a group formed by removing one hydrogen atom from tetralin.

The aromatic hydrocarbon group preferably has 6 to 18 carbon atoms, more preferably 6 to 12 carbon atoms, and still more preferably 6 to 10 carbon atoms.

The hydrocarbon group represented by X¹ may be a group obtained by combining two or more of the above-mentioned hydrocarbon groups, and examples thereof include an aralkyl group; an alkyl group to which an alicyclic hydrocarbon group is bonded; an aromatic hydrocarbon group to which a cycloalkyl group is condensed; and an alkyl group to which an aromatic hydrocarbon group to which a cycloalkyl group is condensed is bonded.

Examples of the aralkyl group include benzyl, (4-methylphenyl)methyl, and phenethyl. The aralkyl group preferably has 7 to 18 carbon atoms, more preferably 7 to 12 carbon atoms, and still more preferably 7 to 10 carbon atoms.

Examples of the alkyl group to which an alicyclic hydrocarbon group is bonded include cyclopropylmethyl, cyclopropylethyl, cyclobutylmethyl, cyclohexylmethyl, cyclohexylethyl, and adamantylmethyl. This preferably has 4 to 20 carbon atoms, more preferably 4 to 15 carbon atoms, and still more preferably 4 to 10 carbon atoms.

Examples of the aromatic hydrocarbon group to which a cycloalkyl group is condensed include a group formed by removing one hydrogen atom from the benzene ring of indan, a group formed by removing one hydrogen atom from the benzene ring of 1-methyl-indan, and a group formed by removing one hydrogen atom from 2-methyl-indan.

Examples of the alkyl group to which an aromatic hydrocarbon group to which a cycloalkyl group is condensed is bonded include a group formed by bonding a C₁-C₄ alkyl group to the benzene ring of indan, a group formed by bonding a C₁-C₄ alkyl group to the benzene ring of 1-methyl-indan, and a group formed by bonding a C₁-C₄ alkyl group to the benzene ring of 2-methyl-indan.

Examples of the substituent that the hydrocarbon group represented by X¹ optionally has (hereinafter sometimes referred to as substituent B) include an amino group, an amido group, a carboxyl group, a C₁-C₄ alkoxy group, a C₁-C₄ alkylthio group, a cyano group, a halogen atom, and a hydroxy group.

The amino group as the substituent A and the substituent B may be an unsubstituted amino group or a substituted amino group. The substituted amino group preferably has one or two hydrocarbon groups. Examples of the hydrocarbon group include the same groups as those mentioned for the hydrocarbon group represented by X¹ described above, and an alkyl group is preferred. The hydrocarbon group has preferably 1 to 10 carbon atoms, more preferably 1 to 4 carbon atoms. Examples of the substituted amino group include N-methylamino, N,N-dimethylamino, N-ethylamino, N,N-diethylamino, N-propylamino, N,N-dipropylamino, N-isopropylamino, N,N-diisopropylamino, N-phenylamino, N,N-diphenylamino, and N,N-ethylmethylamino.

The amido group as the substituent A and the substituent B means a group obtained by removing one hydrogen atom bonded to a nitrogen atom in an amide. Examples of the amide group include formamide, acetamide, propylamide, butylamide, benzamide, trifluoroacetamide, and pentafluorobenzamide. The amide group preferably has 2 to 20 carbon atoms, more preferably 2 to 10 carbon atoms, and still more preferably 2 to 6 carbon atoms.

Examples of the alkoxy group as the substituent A and the substituent B include methoxy, ethoxy, propoxy, n-butoxy, and tert-butoxy. The alkoxy group preferably has 1 to 4 carbon atoms and more preferably 1 or 2 carbon atoms.

Examples of the alkylthio group as the substituent A and the substituent B include methylthio, ethylthio, propylthio, and n-butylthio. The alkylthio group preferably has 1 to 4 carbon atoms and more preferably 1 or 2 carbon atoms.

Examples of the halogen atom as the substituent A and the substituent B include a fluorine atom, a chlorine atom, a bromine atom, and an iodine atom. Among these, a fluorine atom, a chlorine atom, or a bromine atom is preferable, and a chlorine atom is more preferable.

X¹ is preferably a C₁-C₁₀ alkyl group, a C₁-C₄ alkoxy group, a cyano group, or a halogen atom, and more preferably a C₁-C₄ alkyl group, a C₁-C₄ alkoxy group, a cyano group, or a halogen atom.

n is preferably an integer of 0 to 2.

In formula (ph1), when n is an integer of 2 or more, a plurality of X¹s may be the same or different.

When n is an integer of 2 or more and a plurality of X¹s are bonded to adjacent carbon atoms on the phenylene group in formula (ph1), X¹s bonded to adjacent carbon atoms may be combined with each other to form a ring. Examples of the ring formed by combining X¹s bonded to adjacent carbon atoms with each other include rings represented by the following formulas. In the formulas, * indicates a point of attachment to each of adjacent carbon atoms on the phenylene group in formula (ph1).

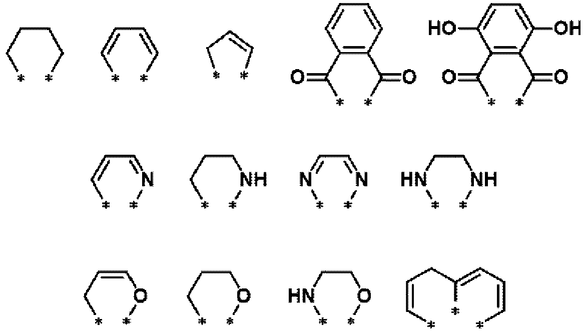

Although the positions of attachment to A and B in formula (ph1) are not particularly limited, formula (ph1) preferably has points of attachment to A and B at the 1st and 4th positions from the viewpoint of availability of raw materials.

L¹ in the compound (I) is preferably a group represented by formula (ph2). 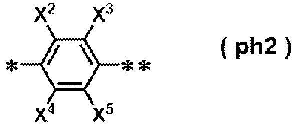 In formula (ph2), X² to X⁵ each independently represent a hydrogen atom, a C₁-C₄ alkyl group, an amino group, an amido group, a carboxyl group, a C₁-C₄ alkoxy group, a C₁-C₄ alkylthio group, a cyano group, or a halogen atom. X² and X³, and X⁴ and X⁵ may be combined with each other to form a ring. * represents a point of attachment to A, and ** represents a point of attachment to B.

Examples of the C₁-C₄ alkyl group represented by X² to X⁶ include methyl, ethyl, propyl, n-butyl, isobutyl, and tert-butyl. Among these, methyl or ethyl is preferable.

Examples of the amino group represented by X² to X⁵ include the groups described as the amino group as the substituent A and the substituent B, and the preferred mode is also the same.

Examples of the amido group represented by X² to X⁵ include the groups described as the amido group as the substituent A and the substituent B, and the preferred mode is also the same.

Examples of the alkoxy group represented by X² to X⁵ include the groups described as the alkoxy group as the substituent A and the substituent B, and the preferred mode is also the same.

Examples of the alkylthio group represented by X² to X⁵ include the groups described as the alkylthio group as the substituent A and the substituent B, and the preferred mode is also the same.

Examples of the halogen atom represented by X² to X⁵ include the atoms described as the halogen atom as the substituent A and the substituent B, and the preferred mode is also the same.

Examples of the ring formed by combining X² and X³, and X⁴ and X⁵ with each other include the rings described as the ring formed by combining X¹s with each other.

The group represented by formula (ph2) is preferably any of groups represented by formulas (ph2-1) to (ph2-12), and more preferably any of groups represented by formulas (ph2-1) to (ph2-11). In the formulas, * represents a point of attachment to A, and ** represents a point of attachment to B.

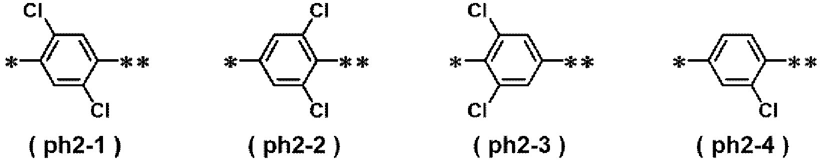

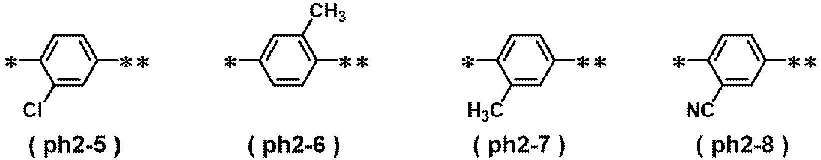

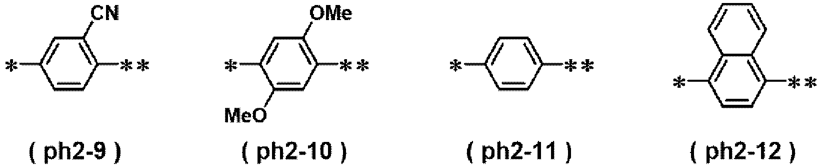

Examples of the hydrocarbon group represented by X⁶ to X⁹ in formulas (ia) and (ib) include the groups described as the hydrocarbon group represented by X¹ mentioned above. -CH₂- contained in the hydrocarbon group represented by X⁶ to X⁹ may be replaced with -O-, -CO-, or -NH-, -CH= contained in the hydrocarbon group represented by X⁶ to X⁹ may be replaced with -N=, and -C< contained in the hydrocarbon group represented by X⁶ to X⁹ may be replaced with -N<.

X⁶ and X⁷ may be combined with each other to form a ring, and X⁸ and X⁹ may be combined with each other to form a ring. The present invention includes also an embodiment in which -CH₂- contained in the ring formed by X⁶ and X⁷ combined with each other and the ring formed by X⁸ and X⁹ combined with each other is replaced with -O-, -CO-, or -NH-; an embodiment in which -CH= contained in the above rings is replaced with -N=; and an embodiment in which -C< contained in the above rings is replaced with -N<.

Examples of a group obtained by combining X⁶ and X⁷ with each other to form a ring in formula (ia) and a group obtained by combining X⁸ and X⁹ with each other to form a ring in formula (ib) include groups represented by the following formulas. In the formulas, * represents a point of attachment to L¹. At least one hydrogen atom in the group represented by each of the following formulas may be replaced with substituent C described below.

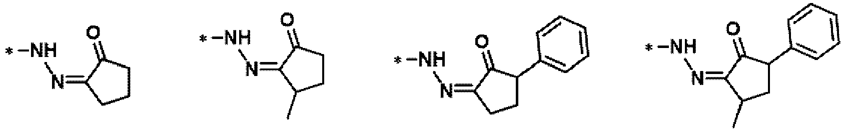

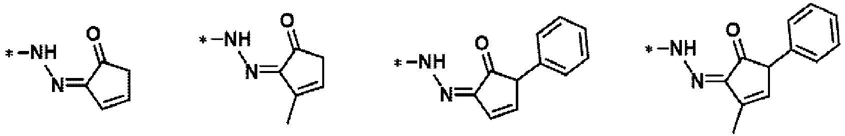

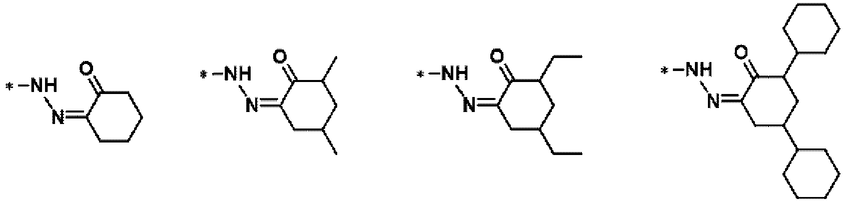

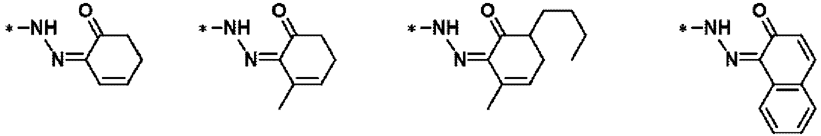

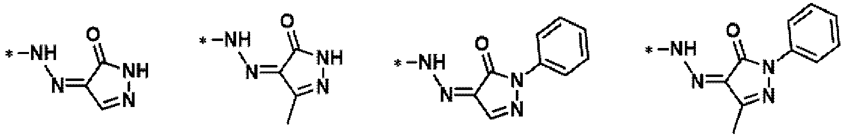

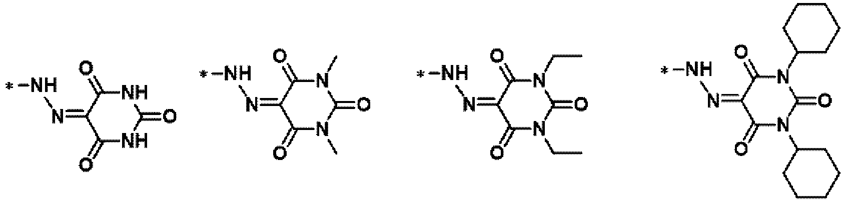

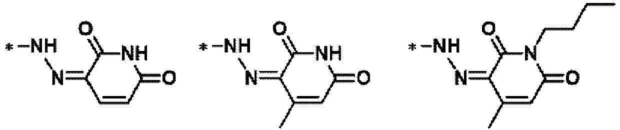

Examples of the substituent that the hydrocarbon group represented by X⁶ to X⁹ optionally has (hereinafter sometimes referred to as substituent C) include a hydroxy group, a C₁-C₄ alkoxy group, a C₁-C₄ alkylthio group, a carboxyl group, an amino group, an amide group, a cyano group, a halogen atom, -SO₃H, -SO₃M, -SO₃T_{0.5}, and -SO₂N(R¹⁷)₂. M represents an alkali metal atom, T represents an alkaline-earth metal atom, and R¹⁷ represents a hydrogen atom or a hydrocarbon group.

Examples of the alkoxy group as the substituent C include the groups described as the alkoxy group as the substituent A and the substituent B, and the preferred mode is also the same.

Examples of the alkylthio group as the substituent C include the groups described as the alkylthio group as the substituent A and the substituent B, and the preferred mode is also the same.

Examples of the amino group as the substituent C include the groups described as the amino group as the substituent A and the substituent B, and the preferred mode is also the same.

Examples of the amide group as the substituent C include the groups described as the amide group as the substituent A and the substituent B, and the preferred mode is also the same.

Examples of the halogen atom as the substituent C include the atoms described as the halogen atom as the substituent A and the substituent B. Among these, a chlorine atom, a bromine atom, and a fluorine atom are preferable.

Examples of the alkali metal atom represented by M include sodium and potassium.

Examples of the alkaline-earth metal atom represented by T include magnesium, calcium, and barium. When any of X⁶ to X⁹ is a hydrocarbon group having one -SO₃T_{0.5}, the compound (I) has the following structure.

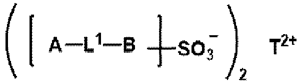

In the above formula, L¹, A, B, and T have the same meanings as above; and -SO₃⁻ substitutes for any of the hydrogen atoms in the hydrocarbon group represented by X⁶ to X⁹ in A and B.

R¹⁷ represents a hydrogen atom or a hydrocarbon group. Two R¹⁷s may be the same or different, and it is preferable that one be a hydrogen atom and the other be a hydrocarbon group. Examples of the hydrocarbon group represented by R¹⁷ include the groups described as the hydrocarbon group represented by X¹ mentioned above. Among these, a C₁-C₁₀ alkyl group, a C₃-C₁₀ cycloalkyl group, a C₃-C₁₂ saturated polycyclic hydrocarbon group, or a C₆-C₁₈ aromatic hydrocarbon group are preferable.

The group represented by formula (ia) and the group represented by formula (ib) are preferably the same. That is, it is preferable that X⁶ and X⁸ represent the same group, and X⁷ and X⁹ represent the same group. When these groups are the same, the color filter produced has an improved color density.

The group represented by formula (ia) and the group represented by formula (ib) are each independently more preferably any of groups represented by formulas (t1) to (t5), still more preferably any of groups represented by formulas (t1) to (t4), and particularly preferably any of groups represented by formulas (t1) to (t3).

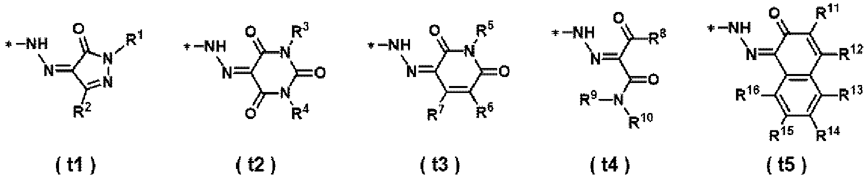

In formulas (t1) to (t5), R¹ to R¹⁶ each independently represent a hydrogen atom, a hydrocarbon group optionally having a substituent, a heterocyclic group, a cyano group, or a halogen atom; and * represents a point of attachment to L¹.

Examples of the hydrocarbon group represented by R¹ to R¹⁶ include the groups described as the hydrocarbon group represented by X¹ mentioned above. Among these, a C₁-C₁₀ alkyl group, a C₃-C₁₀ cycloalkyl group, and a C₆-C₁₂ aromatic hydrocarbon group are preferable, and a C₁-C₆ alkyl group, a C₃-C₈ cycloalkyl group, and a phenyl group are more preferable.

Examples of the substituent that the hydrocarbon group represented by R¹ to R¹⁶ optionally has include the groups described as the substituent C, and the preferred mode is also the same.

Examples of the heterocyclic group represented by R¹ to R¹⁶ include thienyl, benzo[b]thienyl, thianthrenyl, furyl, pyranyl, isobenzofuranyl, chromenyl, xanthenyl, pyrrolyl, imidazolyl, pyrazolyl, pyridyl, pyrazinyl, pyrimidinyl, pyridazinyl, indolizinyl, indolyl, 1H-indazolyl, isoquinolyl, quinolyl, phthalazinyl, carbazolyl, acridinyl, chromanyl, pyrrolidinyl, piperidyl, piperazinyl, indolinyl, isoindolinyl, and benzimidazolonyl. Among these, a heterocyclic group having a benzene ring such as benzo[b] thienyl, thianthrenyl, isobenzofuranyl, chromenyl, xanthenyl, indolyl, 1H-indazolyl, isoquinolyl, quinolyl, phthalazinyl, carbazolyl, acridinyl, chromanyl, indolinyl, isoindolinyl, and benzimidazolonyl are preferable; and indolyl, 1H-indazolyl, isoquinolyl, quinolyl, phthalazinyl, carbazolyl, acridinyl, indolinyl, isoindolinyl, and benzimidazolonyl are more preferable.

Examples of the halogen atom represented by R¹ to R¹⁶ include the atoms described as the halogen atom as the substituent A and the substituent B. Among these, a chlorine atom and a fluorine atom are preferable.

R¹ is preferably an aromatic hydrocarbon group optionally having a substituent, more preferably a phenyl group optionally having a substituent, still more preferably a phenyl group optionally having a substituent at the para position, still further preferably a phenyl group optionally having a halogen atom, -SO₃H, -SO₃T_{0.5}, -SO₃M, or -SO₂N(R¹⁷)₂ at the para position, and particularly preferably a phenyl group optionally having a halogen atom, -SO₃H, or -SO₂N(R¹⁷)₂ at the para position.

R² is preferably an alkyl group optionally having a substituent, more preferably an alkyl group optionally having a halogen atom, and still more preferably a C₁-C₄ alkyl group optionally having a halogen atom.

R³ and R⁴ are each independently preferably a hydrogen atom, an alkyl group, a cycloalkyl group, or an aromatic hydrocarbon group, and more preferably a hydrogen atom, a C₁-C₄ alkyl group, a C₃-C₈ cycloalkyl group, or a phenyl group. R³ and R⁴ are preferably the same.

R⁵ is preferably a hydrogen atom or an alkyl group optionally having a substituent, more preferably an alkyl group, and still more preferably a C₁-C₄ alkyl group.

R⁶ is preferably a cyano group or an alkyl group optionally having a substituent, more preferably a cyano group or an alkyl group optionally having a halogen atom, and still more preferably a cyano group or a C₁-C₄ alkyl group optionally having a halogen atom.

R⁷ is preferably an alkyl group optionally having a substituent, more preferably an alkyl group optionally having a halogen atom, and still more preferably a C₁-C₄ alkyl group optionally having a halogen atom.

R⁸ is preferably an alkyl group optionally having a substituent, and more preferably a C₁-C₄ alkyl group.

R⁹ is preferably a hydrogen atom or an alkyl group optionally having a substituent, and more preferably a hydrogen atom or a C₁-C₄ alkyl group.

R¹⁰ is preferably an aromatic hydrocarbon group optionally having a substituent or a heterocyclic group, more preferably a phenyl group optionally having a substituent or a heterocyclic group having a benzene ring, and still more preferably a phenyl group optionally having a halogen atom or a benzimidazolonyl group.

R¹¹ to R¹⁶ are each independently preferably a hydrogen atom or an alkyl group optionally having a substituent, more preferably a hydrogen atom or an alkyl group optionally having a halogen atom, and still more preferably a hydrogen atom or a C₁-C₄ alkyl group optionally having a halogen atom.

Examples of compound (I) include compounds (AI-1) to (AI-748) shown in Tables 1 to 7.

**[Table 1]**

| | **L¹** | **A** | **B** | | **L¹** | **A** | **B** | | **L¹** | **A** | **B** |
|---|---|---|---|---|---|---|---|---|---|---|---|
| **AI-1** | **ph3** | **t6** | **t6** | **AI-41** | **ph3** | **t9** | **t12** | **AI-81** | **ph4** | **t6** | **t10** |
| **AI-2** | **ph3** | **t7** | **t7** | **AI-42** | **ph3** | **t9** | **t13** | **AI-82** | **ph4** | **t6** | **t11** |
| **AI-3** | **ph3** | **t8** | **t8** | **AI-43** | **ph3** | **t9** | **t14** | **AI-83** | **ph4** | **t6** | **t12** |
| **AI-4** | **ph3** | **t9** | **t9** | **AI-44** | **ph3** | **t9** | **t15** | **AI-84** | **ph4** | **t6** | **t13** |
| **AI-5** | **ph3** | **t10** | **t10** | **AI-45** | **ph3** | **t9** | **t16** | **AI-85** | **ph4** | **t6** | **t14** |
| **AI-6** | **ph3** | **t11** | **t11** | **AI-46** | **ph3** | **t10** | **t11** | **AI-86** | **ph4** | **t6** | **t15** |
| **AI-7** | **ph3** | **t12** | **t12** | **AI-47** | **ph3** | **t10** | **t12** | **AI-87** | **ph4** | **t6** | **t16** |
| **AI-8** | **ph3** | **t13** | **t13** | **AI-48** | **ph3** | **t10** | **t13** | **AI-88** | **ph4** | **t7** | **t6** |
| **AI-9** | **ph3** | **t14** | **t14** | **AI-49** | **ph3** | **t10** | **t14** | **AI-89** | **ph4** | **t7** | **t8** |
| **AI-10** | **ph3** | **t15** | **t15** | **AI-50** | **ph3** | **t10** | **t15** | **AI-90** | **ph4** | **t7** | **t9** |
| **AI-11** | **ph3** | **t 16** | **t16** | **AI-51** | **ph3** | **t10** | **t16** | **AI-91** | **ph4** | **t7** | **t10** |
| **AI-12** | **ph3** | **t6** | **t7** | **AI-52** | **ph3** | **t11** | **t12** | **AI-92** | **ph4** | **t7** | **t11** |
| **AI-13** | **ph3** | **t6** | **t8** | **AI-53** | **ph3** | **t11** | **t13** | **AI-93** | **ph4** | **t7** | **t12** |
| **AI-14** | **ph3** | **t6** | **t9** | **AI-54** | **ph3** | **t11** | **t14** | **AI-94** | **ph4** | **t7** | **t13** |
| **AI-15** | **ph3** | **t6** | **t10** | **AI-55** | **ph3** | **t11** | **t15** | **AI-95** | **ph4** | **t7** | **t14** |
| **AI-16** | **ph3** | **t6** | **t11** | **AI-56** | **ph3** | **t11** | **t16** | **AI-96** | **ph4** | **t7** | **t15** |
| **AI-17** | **ph3** | **t6** | **t12** | **AI-57** | **ph3** | **t12** | **t13** | **AI-97** | **ph4** | **t7** | **t16** |
| **AI-18** | **ph3** | **t6** | **t13** | **AI-58** | **ph3** | **t12** | **t14** | **AI-98** | **ph4** | **t8** | **t6** |
| **AI-19** | **ph3** | **t6** | **t14** | **AI-59** | **ph3** | **t12** | **t15** | **AI-99** | **ph4** | **t8** | **t7** |
| **AI-20** | **ph3** | **t6** | **t15** | **AI-60** | **ph3** | **t12** | **t16** | **AI-100** | **ph4** | **t8** | **t9** |
| **AI-21** | **ph3** | **t6** | **t16** | **AI-61** | **ph3** | **t13** | **t14** | **AI-101** | **ph4** | **t8** | **t10** |
| **AI-22** | **ph3** | **t7** | **t8** | **AI-62** | **ph3** | **t13** | **t15** | **AI-102** | **ph4** | **t8** | **t11** |
| **AI-23** | **ph3** | **t7** | **t9** | **AI-63** | **ph3** | **t13** | **t16** | **AI-103** | **ph4** | **t8** | **t12** |
| **AI-24** | **ph3** | **t7** | **t10** | **AI-64** | **ph3** | **t14** | **t15** | **AI-104** | **ph4** | **t8** | **t13** |
| **AI-25** | **ph3** | **t7** | **t11** | **AI-65** | **ph3** | **t14** | **t16** | **AI-105** | **ph4** | **t8** | **t14** |
| **AI-26** | **ph3** | **t7** | **t12** | **AI-66** | **ph3** | **t15** | **t16** | **AI-106** | **ph4** | **t8** | **t15** |
| **AI-27** | **ph3** | **t7** | **t13** | **AI-67** | **ph4** | **t6** | **t6** | **AI-107** | **ph4** | **t8** | **t16** |
| **AI-28** | **ph3** | **t7** | **t14** | **AI-68** | **ph4** | **t7** | **t7** | **AI-108** | **ph4** | **t9** | **t6** |
| **AI-29** | **ph3** | **t7** | **t15** | **AI-69** | **ph4** | **t8** | **t8** | **AI-109** | **ph4** | **t9** | **t7** |
| **AI-30** | **ph3** | **t7** | **t16** | **AI-70** | **ph4** | **t9** | **t9** | **AI-110** | **ph4** | **t9** | **t8** |
| **AI-31** | **ph3** | **t8** | **t9** | **AI-71** | **ph4** | **t10** | **t10** | **AI-111** | **ph4** | **t9** | **t10** |
| **AI-32** | **ph3** | **t8** | **t10** | **AI-72** | **ph4** | **t11** | **t11** | **AI-112** | **ph4** | **t9** | **t11** |
| **AI-33** | **ph3** | **t8** | **t11** | **AI-73** | **ph4** | **t12** | **t12** | **AI-113** | **ph4** | **t9** | **t12** |
| **AI-34** | **ph3** | **t8** | **t12** | **AI-74** | **ph4** | **t13** | **t13** | **AI-114** | **ph4** | **t9** | **t13** |
| **AI-35** | **ph3** | **t8** | **t13** | **AI-75** | **ph4** | **t14** | **t14** | **AI-115** | **ph4** | **t9** | **t14** |
| **AI-36** | **ph3** | **t8** | **t14** | **AI-76** | **ph4** | **t15** | **t15** | **AI-116** | **ph4** | **t9** | **t15** |
| **AI-37** | **ph3** | **t8** | **t15** | **AI-77** | **ph4** | **t16** | **t16** | **AI-117** | **ph4** | **t9** | **t16** |
| **AI-38** | **ph3** | **t8** | **t16** | **AI-78** | **ph4** | **t6** | **t7** | **AI-118** | **ph4** | **t10** | **t6** |
| **AI-39** | **ph3** | **t9** | **t10** | **AI-79** | **ph4** | **t6** | **t8** | **AI-119** | **ph4** | **t10** | **t7** |
| **AI-40** | **ph3** | **t9** | **t11** | **AI-80** | **ph4** | **t6** | **t9** | **AI-120** | **ph4** | **t10** | **t8** |

**[Table 2]**

| | **L¹** | **A** | **B** | | **L¹** | **A** | **B** | | **L¹** | **A** | **B** |
|---|---|---|---|---|---|---|---|---|---|---|---|
| **AI-121** | **ph4** | **t10** | **t9** | **AI-161** | **ph4** | **t14** | **t9** | **AI-201** | **ph5** | **t6** | **t9** |
| **AI-122** | **ph4** | **t10** | **t11** | **AI-162** | **ph4** | **t14** | **t10** | **AI-202** | **ph5** | **t6** | **t10** |
| **AI-123** | **ph4** | **t10** | **t12** | **AI-163** | **ph4** | **t14** | **t11** | **AI-203** | **ph5** | **t6** | **t11** |
| **AI-124** | **ph4** | **t10** | **t13** | **AI-164** | **ph4** | **t14** | **t12** | **AI-204** | **ph5** | **t6** | **t12** |
| **AI-125** | **ph4** | **t10** | **t14** | **AI-165** | **ph4** | **t14** | **t13** | **AI-205** | **ph5** | **t6** | **t13** |
| **AI-126** | **ph4** | **t10** | **t15** | **AI-166** | **ph4** | **t14** | **t15** | **AI-206** | **ph5** | **t6** | **t14** |
| **AI-127** | **ph4** | **t10** | **t16** | **AI-167** | **ph4** | **t14** | **t16** | **AI-207** | **ph5** | **t6** | **t15** |
| **AI-128** | **ph4** | **t11** | **t6** | **AI-168** | **ph4** | **t15** | **t6** | **AI-208** | **ph5** | **t6** | **t16** |
| **AI-129** | **ph4** | **t11** | **t7** | **AI-169** | **ph4** | **t15** | **t7** | **AI-209** | **ph5** | **t7** | **t6** |
| **AI-130** | **ph4** | **t11** | **t8** | **AI-170** | **ph4** | **t15** | **t8** | **AI-210** | **ph5** | **t7** | **t8** |
| **AI-131** | **ph4** | **t11** | **t9** | **AI-171** | **ph4** | **t15** | **t9** | **AI-211** | **ph5** | **t7** | **t9** |
| **AI-132** | **ph4** | **t11** | **t10** | **AI-172** | **ph4** | **t15** | **t10** | **AI-212** | **ph5** | **t7** | **t10** |
| **AI-133** | **ph4** | **t11** | **t12** | **AI-173** | **ph4** | **t15** | **t11** | **AI-213** | **ph5** | **t7** | **t11** |
| **AI-134** | **ph4** | **t11** | **t13** | **AI-174** | **ph4** | **t15** | **t12** | **AI-214** | **ph5** | **t7** | **t12** |
| **AI-135** | **ph4** | **t11** | **t14** | **AI-175** | **ph4** | **t15** | **t13** | **AI-215** | **ph5** | **t7** | **t13** |
| **AI-136** | **ph4** | **t11** | **t15** | **AI-176** | **ph4** | **t15** | **t14** | **AI-216** | **ph5** | **t7** | **t14** |
| **AI-137** | **ph4** | **t11** | **t16** | **AI-177** | **ph4** | **t15** | **t16** | **AI-217** | **ph5** | **t7** | **t15** |
| **AI-138** | **ph4** | **t12** | **t6** | **AI-178** | **ph4** | **t16** | **t6** | **AI-218** | **ph5** | **t7** | **t16** |
| **AI-139** | **ph4** | **t12** | **t7** | **AI-179** | **ph4** | **t16** | **t7** | **AI-219** | **ph5** | **t8** | **t6** |
| **AI-140** | **ph4** | **t12** | **t8** | **AI-180** | **ph4** | **t16** | **t8** | **AI-220** | **ph5** | **t8** | **t7** |
| **AI-141** | **ph4** | **t12** | **t9** | **AI-181** | **ph4** | **t16** | **t9** | **AI-221** | **ph5** | **t8** | **t9** |
| **AI-142** | **ph4** | **t12** | **t10** | **AI-182** | **ph4** | **t16** | **t10** | **AI-222** | **ph5** | **t8** | **t10** |
| **AI-143** | **ph4** | **t12** | **t11** | **AI-183** | **ph4** | **t16** | **t11** | **AI-223** | **ph5** | **t8** | **t11** |
| **AI-144** | **ph4** | **t12** | **t13** | **AI-184** | **ph4** | **t16** | **t12** | **AI-224** | **ph5** | **t8** | **t12** |
| **AI-145** | **ph4** | **t12** | **t14** | **AI-185** | **ph4** | **t16** | **t13** | **AI-225** | **ph5** | **t8** | **t13** |
| **AI-146** | **ph4** | **t12** | **t15** | **AI-186** | **ph4** | **t16** | **t14** | **AI-226** | **ph5** | **t8** | **t14** |
| **AI-147** | **ph4** | **t12** | **t16** | **AI-187** | **ph4** | **t16** | **t15** | **AI-227** | **ph5** | **t8** | **t15** |
| **AI-148** | **ph4** | **t13** | **t6** | **AI-188** | **ph5** | **t6** | **t6** | **AI-228** | **ph5** | **t8** | **t16** |
| **AI-149** | **ph4** | **t13** | **t7** | **AI-189** | **ph5** | **t7** | **t7** | **AI-229** | **ph5** | **t9** | **t6** |
| **AI-150** | **ph4** | **t13** | **t8** | **AI-190** | **ph5** | **t8** | **t8** | **AI-230** | **ph5** | **t9** | **t7** |
| **AI-151** | **ph4** | **t13** | **t9** | **AI-191** | **ph5** | **t9** | **t9** | **AI-231** | **ph5** | **t9** | **t8** |
| **AI-152** | **ph4** | **t13** | **t10** | **AI-192** | **ph5** | **t10** | **t10** | **AI-232** | **ph5** | **t9** | **t10** |
| **AI-153** | **ph4** | **t13** | **t11** | **AI-193** | **ph5** | **t11** | **t11** | **AI-233** | **ph5** | **t9** | **t11** |
| **AI-154** | **ph4** | **t13** | **t12** | **AI-194** | **ph5** | **t12** | **t12** | **AI-234** | **ph5** | **t9** | **t12** |
| **AI-155** | **ph4** | **t13** | **t14** | **AI-195** | **ph5** | **t13** | **t13** | **AI-235** | **ph5** | **t9** | **t13** |
| **AI-156** | **ph4** | **t13** | **t15** | **AI-196** | **ph5** | **t14** | **t14** | **AI-236** | **ph5** | **t9** | **t14** |
| **AI-157** | **ph4** | **t13** | **t16** | **AI-197** | **ph5** | **t15** | **t15** | **AI-237** | **ph5** | **t9** | **t15** |
| **AI-158** | **ph4** | **t14** | **t6** | **AI-198** | **ph5** | **t16** | **t16** | **AI-238** | **ph5** | **t9** | **t16** |
| **AI-159** | **ph4** | **t14** | **t7** | **AI-199** | **ph5** | **t6** | **t7** | **AI-239** | **ph5** | **t10** | **t6** |
| **AI-160** | **ph4** | **t14** | **t8** | **AI-200** | **ph5** | **t6** | **t8** | **AI-240** | **ph5** | **t10** | **t7** |

**[Table 3]**

| | **L¹** | **A** | **B** | | **L¹** | **A** | **B** | | **L¹** | **A** | **B** |
|---|---|---|---|---|---|---|---|---|---|---|---|
| **AI-241** | **ph5** | **t10** | **t8** | **AI-281** | **ph5** | **t14** | **t8** | **AI-321** | **ph6** | **t6** | **t8** |
| **AI-242** | **ph5** | **t10** | **t9** | **AI-282** | **ph5** | **t14** | **t9** | **AI-322** | **ph6** | **t6** | **t9** |
| **AI-243** | **ph5** | **t10** | **t11** | **AI-283** | **ph5** | **t14** | **t10** | **AI-323** | **ph6** | **t6** | **t10** |
| **AI-244** | **ph5** | **t10** | **t12** | **AI-284** | **ph5** | **t14** | **t11** | **AI-324** | **ph6** | **t6** | **t11** |
| **AI-245** | **ph5** | **t10** | **t13** | **AI-285** | **ph5** | **t14** | **t12** | **AI-325** | **ph6** | **t6** | **t12** |
| **AI-246** | **ph5** | **t10** | **t14** | **AI-286** | **ph5** | **t14** | **t13** | **AI-326** | **ph6** | **t6** | **t13** |
| **AI-247** | **ph5** | **t10** | **t15** | **AI-287** | **ph5** | **t14** | **t15** | **AI-327** | **ph6** | **t6** | **t14** |
| **AI-248** | **ph5** | **t10** | **t16** | **AI-288** | **ph5** | **t14** | **t16** | **AI-328** | **ph6** | **t6** | **t15** |
| **AI-249** | **ph5** | **t11** | **t6** | **AI-289** | **ph5** | **t15** | **t6** | **AI-329** | **ph6** | **t6** | **t16** |
| **AI-250** | **ph5** | **t11** | **t7** | **AI-290** | **ph5** | **t15** | **t7** | **AI-330** | **ph6** | **t7** | **t6** |
| **AI-251** | **ph5** | **t11** | **t8** | **AI-291** | **ph5** | **t15** | **t8** | **AI-331** | **ph6** | **t7** | **t8** |
| **AI-252** | **ph5** | **t11** | **t9** | **AI-292** | **ph5** | **t15** | **t9** | **AI-332** | **ph6** | **t7** | **t9** |
| **AI-253** | **ph5** | **t11** | **t10** | **AI-293** | **ph5** | **t15** | **t10** | **AI-333** | **ph6** | **t7** | **t10** |
| **AI-254** | **ph5** | **t11** | **t12** | **AI-294** | **ph5** | **t15** | **t11** | **AI-334** | **ph6** | **t7** | **t11** |
| **AI-255** | **ph5** | **t11** | **t13** | **AI-295** | **ph5** | **t15** | **t12** | **AI-335** | **ph6** | **t7** | **t12** |
| **AI-256** | **ph5** | **t11** | **t14** | **AI-296** | **ph5** | **t15** | **t13** | **AI-336** | **ph6** | **t7** | **t13** |
| **AI-257** | **ph5** | **t11** | **t15** | **AI-297** | **ph5** | **t15** | **t14** | **AI-337** | **ph6** | **t7** | **t14** |
| **AI-258** | **ph5** | **t11** | **t16** | **AI-298** | **ph5** | **t15** | **t16** | **AI-338** | **ph6** | **t7** | **t15** |
| **AI-259** | **ph5** | **t12** | **t6** | **AI-299** | **ph5** | **t16** | **t6** | **AI-339** | **ph6** | **t7** | **t16** |
| **AI-260** | **ph5** | **t12** | **t7** | **AI-300** | **ph5** | **t16** | **t7** | **AI-340** | **ph6** | **t8** | **t6** |
| **AI-261** | **ph5** | **t12** | **t8** | **AI-301** | **ph5** | **t16** | **t8** | **AI-341** | **ph6** | **t8** | **t7** |
| **AI-262** | **ph5** | **t12** | **t9** | **AI-302** | **ph5** | **t16** | **t9** | **AI-342** | **ph6** | **t8** | **t9** |
| **AI-263** | **ph5** | **t12** | **t10** | **AI-303** | **ph5** | **t16** | **t10** | **AI-343** | **ph6** | **t8** | **t10** |
| **AI-264** | **ph5** | **t12** | **t11** | **AI-304** | **ph5** | **t16** | **t11** | **AI-344** | **ph6** | **t8** | **t11** |
| **AI-265** | **ph5** | **t12** | **t13** | **AI-305** | **ph5** | **t16** | **t12** | **AI-345** | **ph6** | **t8** | **t12** |
| **AI-266** | **ph5** | **t12** | **t14** | **AI-306** | **ph5** | **t16** | **t13** | **AI-346** | **ph6** | **t8** | **t13** |
| **AI-267** | **ph5** | **t12** | **t15** | **AI-307** | **ph5** | **t16** | **t14** | **AI-347** | **ph6** | **t8** | **t14** |
| **AI-268** | **ph5** | **t12** | **t16** | **AI-308** | **ph5** | **t16** | **t15** | **AI-348** | **ph6** | **t8** | **t15** |
| **AI-269** | **ph5** | **t13** | **t6** | **AI-309** | **ph6** | **t6** | **t6** | **AI-349** | **ph6** | **t8** | **t16** |
| **AI-270** | **ph5** | **t13** | **t7** | **AI-310** | **ph6** | **t7** | **t7** | **AI-350** | **ph6** | **t9** | **t6** |
| **AI-271** | **ph5** | **t13** | **t8** | **AI-311** | **ph6** | **t8** | **t8** | **AI-351** | **ph6** | **t9** | **t7** |
| **AI-272** | **ph5** | **t13** | **t9** | **AI-312** | **ph6** | **t9** | **t9** | **AI-352** | **ph6** | **t9** | **t8** |
| **AI-273** | **ph5** | **t13** | **t10** | **AI-313** | **ph6** | **t10** | **t10** | **AI-353** | **ph6** | **t9** | **t10** |
| **AI-274** | **ph5** | **t13** | **t11** | **AI-314** | **ph6** | **t11** | **t11** | **AI-354** | **ph6** | **t9** | **t11** |
| **AI-275** | **ph5** | **t13** | **t12** | **AI-315** | **ph6** | **t12** | **t12** | **AI-355** | **ph6** | **t9** | **t12** |
| **AI-276** | **ph5** | **t13** | **t14** | **AI-316** | **ph6** | **t13** | **t13** | **AI-356** | **ph6** | **t9** | **t13** |
| **AI-277** | **ph5** | **t13** | **t15** | **AI-317** | **ph6** | **t14** | **t14** | **AI-357** | **ph6** | **t9** | **t14** |
| **AI-278** | **ph5** | **t13** | **t16** | **AI-318** | **ph6** | **t15** | **t15** | **AI-358** | **ph6** | **t9** | **t15** |
| **AI-279** | **ph5** | **t14** | **t6** | **AI-319** | **ph6** | **t16** | **t16** | **AI-359** | **ph6** | **t9** | **t16** |
| **AI-280** | **ph5** | **t14** | **t7** | **AI-320** | **ph6** | **t6** | **t7** | **AI-360** | **ph6** | **t10** | **t6** |

**[Table 4]**

| | **L¹** | **A** | **B** | | **L¹** | **A** | **B** | | **L¹** | **A** | **B** |
|---|---|---|---|---|---|---|---|---|---|---|---|
| **AI-361** | **ph6** | **t10** | **t7** | **AI-401** | **ph6** | **t14** | **t7** | **AI-441** | **ph7** | **t6** | **t7** |
| **AI-362** | **ph6** | **t10** | **t8** | **AI-402** | **ph6** | **t14** | **t8** | **AI-442** | **ph7** | **t6** | **t8** |
| **AI-363** | **ph6** | **t10** | **t9** | **AI-403** | **ph6** | **t14** | **t9** | **AI-443** | **ph7** | **t6** | **t9** |
| **AI-364** | **ph6** | **t10** | **t11** | **AI-404** | **ph6** | **t14** | **t10** | **AI-444** | **ph7** | **t6** | **t10** |
| **AI-365** | **ph6** | **t10** | **t12** | **AI-405** | **ph6** | **t14** | **t11** | **AI-445** | **ph7** | **t6** | **t11** |
| **AI-366** | **ph6** | **t10** | **t13** | **AI-406** | **ph6** | **t14** | **t12** | **AI-446** | **ph7** | **t6** | **t12** |
| **AI-367** | **ph6** | **t10** | **t14** | **AI-407** | **ph6** | **t14** | **t13** | **AI-447** | **ph7** | **t6** | **t13** |
| **AI-368** | **ph6** | **t10** | **t15** | **AI-408** | **ph6** | **t14** | **t15** | **AI-448** | **ph7** | **t6** | **t14** |
| **AI-369** | **ph6** | **t10** | **t16** | **AI-409** | **ph6** | **t14** | **t16** | **AI-449** | **ph7** | **t6** | **t15** |
| **AI-370** | **ph6** | **t11** | **t6** | **AI-410** | **ph6** | **t15** | **t6** | **AI-450** | **ph7** | **t6** | **t16** |
| **AI-371** | **ph6** | **t11** | **t7** | **AI-411** | **ph6** | **t15** | **t7** | **AI-451** | **ph7** | **t7** | **t6** |
| **AI-372** | **ph6** | **t11** | **t8** | **AI-412** | **ph6** | **t15** | **t8** | **AI-452** | **ph7** | **t7** | **t8** |
| **AI-373** | **ph6** | **t11** | **t9** | **AI-413** | **ph6** | **t15** | **t9** | **AI-453** | **ph7** | **t7** | **t9** |
| **AI-374** | **ph6** | **t11** | **t10** | **AI-414** | **ph6** | **t15** | **t10** | **AI-454** | **ph7** | **t7** | **t10** |
| **AI-375** | **ph6** | **t11** | **t12** | **AI-415** | **ph6** | **t15** | **t11** | **AI-455** | **ph7** | **t7** | **t11** |
| **AI-376** | **ph6** | **t11** | **t13** | **AI-416** | **ph6** | **t15** | **t12** | **AI-456** | **ph7** | **t7** | **t12** |
| **AI-377** | **ph6** | **t11** | **t14** | **AI-417** | **ph6** | **t15** | **t13** | **AI-457** | **ph7** | **t7** | **t13** |
| **AI-378** | **ph6** | **t11** | **t15** | **AI-418** | **ph6** | **t15** | **t14** | **AI-458** | **ph7** | **t7** | **t14** |
| **AI-379** | **ph6** | **t11** | **t16** | **AI-419** | **ph6** | **t15** | **t16** | **AI-459** | **ph7** | **t7** | **t15** |
| **AI-380** | **ph6** | **t12** | **t6** | **AI-420** | **ph6** | **t16** | **t6** | **AI-460** | **ph7** | **t7** | **t16** |
| **AI-381** | **ph6** | **t12** | **t7** | **AI-421** | **ph6** | **t16** | **t7** | **AI-461** | **ph7** | **t8** | **t6** |
| **AI-382** | **ph6** | **t12** | **t8** | **AI-422** | **ph6** | **t16** | **t8** | **AI-462** | **ph7** | **t8** | **t7** |
| **AI-383** | **ph6** | **t12** | **t9** | **AI-423** | **ph6** | **t16** | **t9** | **AI-463** | **ph7** | **t8** | **t9** |
| **AI-384** | **ph6** | **t12** | **t10** | **AI-424** | **ph6** | **t16** | **t10** | **AI-464** | **ph7** | **t8** | **t10** |
| **AI-385** | **ph6** | **t12** | **t11** | **AI-425** | **ph6** | **t16** | **t11** | **AI-465** | **ph7** | **t8** | **t11** |
| **AI-386** | **ph6** | **t12** | **t13** | **AI-426** | **ph6** | **t16** | **t12** | **AI-466** | **ph7** | **t8** | **t12** |
| **AI-387** | **ph6** | **t12** | **t14** | **AI-427** | **ph6** | **t16** | **t13** | **AI-467** | **ph7** | **t8** | **t13** |
| **AI-388** | **ph6** | **t12** | **t15** | **AI-428** | **ph6** | **t16** | **t14** | **AI-468** | **ph7** | **t8** | **t14** |
| **AI-389** | **ph6** | **t12** | **t16** | **AI-429** | **ph6** | **t16** | **t15** | **AI-469** | **ph7** | **t8** | **t15** |
| **AI-390** | **ph6** | **t13** | **t6** | **AI-430** | **ph7** | **t6** | **t6** | **AI-470** | **ph7** | **t8** | **t16** |
| **AI-391** | **ph6** | **t13** | **t7** | **AI-431** | **ph7** | **t7** | **t7** | **AI-471** | **ph7** | **t9** | **t6** |
| **AI-392** | **ph6** | **t13** | **t8** | **AI-432** | **ph7** | **t8** | **t8** | **AI-472** | **ph7** | **t9** | **t7** |
| **AI-393** | **ph6** | **t13** | **t9** | **AI-433** | **ph7** | **t9** | **t9** | **AI-473** | **ph7** | **t9** | **t8** |
| **AI-394** | **ph6** | **t13** | **t10** | **AI-434** | **ph7** | **t10** | **t10** | **AI-474** | **ph7** | **t9** | **t10** |
| **AI-395** | **ph6** | **t13** | **t11** | **AI-435** | **ph7** | **t11** | **t11** | **AI-475** | **ph7** | **t9** | **t11** |
| **AI-396** | **ph6** | **t13** | **t12** | **AI-436** | **ph7** | **t12** | **t12** | **AI-476** | **ph7** | **t9** | **t12** |
| **AI-397** | **ph6** | **t13** | **t14** | **AI-437** | **ph7** | **t13** | **t13** | **AI-477** | **ph7** | **t9** | **t13** |
| **AI-398** | **ph6** | **t13** | **t15** | **AI-438** | **ph7** | **t14** | **t14** | **AI-478** | **ph7** | **t9** | **t14** |
| **AI-399** | **ph6** | **t13** | **t16** | **AI-439** | **ph7** | **t15** | **t15** | **AI-479** | **ph7** | **t9** | **t15** |
| **AI-400** | **ph6** | **t14** | **t6** | **AI-440** | **ph7** | **t16** | **t16** | **AI-480** | **ph7** | **t9** | **t16** |

**[Table 5]**

| | **L¹** | **A** | **B** | | **L¹** | **A** | **B** | | **L¹** | **A** | **B** |
|---|---|---|---|---|---|---|---|---|---|---|---|
| **AI-481** | **ph7** | **t10** | **t6** | **AI-521** | **ph7** | **t14** | **t6** | **AI-561** | **ph8** | **t16** | **t16** |
| **AI-482** | **ph7** | **t10** | **t7** | **AI-522** | **ph7** | **t14** | **t7** | **AI-562** | **ph8** | **t6** | **t7** |
| **AI-483** | **ph7** | **t10** | **t8** | **AI-523** | **ph7** | **t14** | **t8** | **AI-563** | **ph8** | **t6** | **t8** |
| **AI-484** | **ph7** | **t10** | **t9** | **AI-524** | **ph7** | **t14** | **t9** | **AI-564** | **ph8** | **t6** | **t9** |
| **AI-485** | **ph7** | **t10** | **t11** | **AI-525** | **ph7** | **t14** | **t10** | **AI-565** | **ph8** | **t6** | **t10** |
| **AI-486** | **ph7** | **t10** | **t12** | **AI-526** | **ph7** | **t14** | **t11** | **AI-566** | **ph8** | **t6** | **t11** |
| **AI-487** | **ph7** | **t10** | **t13** | **AI-527** | **ph7** | **t14** | **t12** | **AI-567** | **ph8** | **t6** | **t12** |
| **AI-488** | **ph7** | **t10** | **t14** | **AI-528** | **ph7** | **t14** | **t13** | **AI-568** | **ph8** | **t6** | **t13** |
| **AI-489** | **ph7** | **t10** | **t15** | **AI-529** | **ph7** | **t14** | **t15** | **AI-569** | **ph8** | **t6** | **t14** |
| **AI-490** | **ph7** | **t10** | **t16** | **AI-530** | **ph7** | **t14** | **tie** | **AI-570** | **ph8** | **t6** | **t15** |
| **AI-491** | **ph7** | **t11** | **t6** | **AI-531** | **ph7** | **t15** | **t6** | **AI-571** | **ph8** | **t6** | **t16** |
| **AI-492** | **ph7** | **t11** | **t7** | **AI-532** | **ph7** | **t15** | **t7** | **AI-572** | **ph8** | **t7** | **t8** |
| **AI-493** | **ph7** | **t11** | **t8** | **AI-533** | **ph7** | **t15** | **t8** | **AI-573** | **ph8** | **t7** | **t9** |
| **AI-494** | **ph7** | **t11** | **t9** | **AI-534** | **ph7** | **t15** | **t9** | **AI-574** | **ph8** | **t7** | **t10** |
| **AI-495** | **ph7** | **t11** | **t10** | **AI-535** | **ph7** | **t15** | **t10** | **AI-575** | **ph8** | **t7** | **t11** |
| **AI-496** | **ph7** | **t11** | **t12** | **AI-536** | **ph7** | **t15** | **t11** | **AI-576** | **ph8** | **t7** | **t12** |
| **AI-497** | **ph7** | **t11** | **t13** | **AI-537** | **ph7** | **t15** | **t12** | **AI-577** | **ph8** | **t7** | **t13** |
| **AI-498** | **ph7** | **t11** | **t14** | **AI-538** | **ph7** | **t15** | **t13** | **AI-578** | **ph8** | **t7** | **t14** |
| **AI-499** | **ph7** | **t11** | **t15** | **AI-539** | **ph7** | **t15** | **t14** | **AI-579** | **ph8** | **t7** | **t15** |
| **AI-500** | **ph7** | **t11** | **t16** | **AI-540** | **ph7** | **t15** | **t16** | **AI-580** | **ph8** | **t7** | **t16** |
| **AI-501** | **ph7** | **t12** | **t6** | **AI-541** | **ph7** | **t16** | **t6** | **AI-581** | **ph8** | **t8** | **t9** |
| **AI-502** | **ph7** | **t12** | **t7** | **AI-542** | **ph7** | **t16** | **t7** | **AI-582** | **ph8** | **t8** | **t10** |
| **AI-503** | **ph7** | **t12** | **t8** | **AI-543** | **ph7** | **t16** | **t8** | **AI-583** | **ph8** | **t8** | **t11** |
| **AI-504** | **ph7** | **t12** | **t9** | **AI-544** | **ph7** | **t16** | **t9** | **AI-584** | **ph8** | **t8** | **t12** |
| **AI-505** | **ph7** | **t12** | **t10** | **AI-545** | **ph7** | **t16** | **t10** | **AI-585** | **ph8** | **t8** | **t13** |
| **AI-506** | **ph7** | **t12** | **t11** | **AI-546** | **ph7** | **t16** | **t11** | **AI-586** | **ph8** | **t8** | **t14** |
| **AI-507** | **ph7** | **t12** | **t13** | **AI-547** | **ph7** | **t16** | **t12** | **AI-587** | **ph8** | **t8** | **t15** |
| **AI-508** | **ph7** | **t12** | **t14** | **AI-548** | **ph7** | **t16** | **t13** | **AI-588** | **ph8** | **t8** | **t16** |
| **AI-509** | **ph7** | **t12** | **t15** | **AI-549** | **ph7** | **t16** | **t14** | **AI-589** | **ph8** | **t9** | **t10** |
| **AI-510** | **ph7** | **t12** | **t16** | **AI-550** | **ph7** | **t16** | **t15** | **AI-590** | **ph8** | **t9** | **t11** |
| **AI-511** | **ph7** | **t13** | **t6** | **AI-551** | **ph8** | **t6** | **t6** | **AI-591** | **ph8** | **t9** | **t12** |
| **AI-512** | **ph7** | **t13** | **t7** | **AI-552** | **ph8** | **t7** | **t7** | **AI-592** | **ph8** | **t9** | **t13** |
| **AI-513** | **ph7** | **t13** | **t8** | **AI-553** | **ph8** | **t8** | **t8** | **AI-593** | **ph8** | **t9** | **t14** |
| **AI-514** | **ph7** | **t13** | **t9** | **AI-554** | **ph8** | **t9** | **t9** | **AI-594** | **ph8** | **t9** | **t15** |
| **AI-515** | **ph7** | **t13** | **t10** | **AI-555** | **ph8** | **t10** | **t10** | **AI-595** | **ph8** | **t9** | **t16** |
| **AI-516** | **ph7** | **t13** | **t11** | **AI-556** | **ph8** | **t11** | **t11** | **AI-596** | **ph8** | **t10** | **t11** |
| **AI-517** | **ph7** | **t13** | **t12** | **AI-557** | **ph8** | **t12** | **t12** | **AI-597** | **ph8** | **t10** | **t12** |
| **AI-518** | **ph7** | **t13** | **t14** | **AI-558** | **ph8** | **t13** | **t13** | **AI-598** | **ph8** | **t10** | **t13** |
| **AI-519** | **ph7** | **t13** | **t15** | **AI-559** | **ph8** | **t14** | **t14** | **AI-599** | **ph8** | **t10** | **t14** |
| **AI-520** | **ph7** | **t13** | **t16** | **AI-560** | **ph8** | **t15** | **t15** | **AI-600** | **ph8** | **t10** | **t15** |

**[Table 6]**

| | **L¹** | **A** | **B** | | **L¹** | **A** | **B** | | **L¹** | **A** | **B** |
|---|---|---|---|---|---|---|---|---|---|---|---|
| **AI-601** | **ph8** | **t10** | **t16** | **AI-641** | **ph9** | **t7** | **t11** | **AI-681** | **ph9** | **t14** | **t16** |
| **AI-602** | **ph8** | **t11** | **t12** | **AI-642** | **ph9** | **t7** | **t12** | **AI-682** | **ph9** | **t15** | **t16** |
| **AI-603** | **ph8** | **t11** | **t13** | **AI-643** | **ph9** | **t7** | **t13** | **AI-683** | **ph10** | **t6** | **t6** |
| **AI-604** | **ph8** | **t11** | **t14** | **AI-644** | **ph9** | **t7** | **t14** | **AI-684** | **ph10** | **t7** | **t7** |
| **AI-605** | **ph8** | **t11** | **t15** | **AI-645** | **ph9** | **t7** | **t15** | **AI-685** | **ph10** | **t8** | **t8** |
| **AI-606** | **ph8** | **t11** | **t16** | **AI-646** | **ph9** | **t7** | **t16** | **AI-686** | **ph10** | **t9** | **t9** |
| **AI-607** | **ph8** | **t12** | **t13** | **AI-647** | **ph9** | **t8** | **t9** | **AI-687** | **ph10** | **t10** | **t10** |
| **AI-608** | **ph8** | **t12** | **t14** | **AI-648** | **ph9** | **t8** | **t10** | **AI-688** | **ph10** | **t11** | **t11** |
| **AI-609** | **ph8** | **t12** | **t15** | **AI-649** | **ph9** | **t8** | **t11** | **AI-689** | **ph10** | **t12** | **t12** |
| **AI-610** | **ph8** | **t12** | **t16** | **AI-650** | **ph9** | **t8** | **t12** | **AI-690** | **ph10** | **t13** | **t13** |
| **AI-611** | **ph8** | **t13** | **t14** | **AI-651** | **ph9** | **t8** | **t13** | **AI-691** | **ph10** | **t14** | **t14** |
| **AI-612** | **ph8** | **t13** | **t15** | **AI-652** | **ph9** | **t8** | **t14** | **AI-692** | **ph10** | **t15** | **t15** |
| **AI-613** | **ph8** | **t13** | **t16** | **AI-653** | **ph9** | **t8** | **t15** | **AI-693** | **ph10** | **t16** | **t16** |
| **AI-614** | **ph8** | **t14** | **t15** | **AI-654** | **ph9** | **t8** | **t16** | **AI-694** | **ph10** | **t6** | **t7** |
| **AI-615** | **ph8** | **t14** | **t16** | **AI-655** | **ph9** | **t9** | **t10** | **AI-695** | **ph10** | **t6** | **t8** |
| **AI-616** | **ph8** | **t15** | **t16** | **AI-656** | **ph9** | **t9** | **t11** | **AI-696** | **ph10** | **t6** | **t9** |
| **AI-617** | **ph9** | **t6** | **t6** | **AI-657** | **ph9** | **t9** | **t12** | **AI-697** | **ph10** | **t6** | **tio** |
| **AI-618** | **ph9** | **t7** | **t7** | **AI-658** | **ph9** | **t9** | **t13** | **AI-698** | **ph10** | **t6** | **t11** |
| **AI-619** | **ph9** | **t8** | **t8** | **AI-659** | **ph9** | **t9** | **t14** | **AI-699** | **ph10** | **t6** | **t12** |
| **AI-620** | **ph9** | **t9** | **t9** | **AI-660** | **ph9** | **t9** | **t15** | **AI-700** | **ph10** | **t6** | **t13** |
| **AI-621** | **ph9** | **t10** | **t10** | **AI-661** | **ph9** | **t9** | **t16** | **AI-701** | **ph10** | **t6** | **t14** |
| **AI-622** | **ph9** | **t11** | **t11** | **AI-662** | **ph9** | **t10** | **t11** | **AI-702** | **ph10** | **t6** | **t15** |
| **AI-623** | **ph9** | **t12** | **t12** | **AI-663** | **ph9** | **t10** | **t12** | **AI-703** | **ph10** | **t6** | **t16** |
| **AI-624** | **ph9** | **t13** | **t13** | **AI-664** | **ph9** | **t10** | **t13** | **AI-704** | **ph10** | **t7** | **t8** |
| **AI-625** | **ph9** | **t14** | **t14** | **AI-665** | **ph9** | **t10** | **t14** | **AI-705** | **ph10** | **t7** | **t9** |
| **AI-626** | **ph9** | **t15** | **t15** | **AI-666** | **ph9** | **t10** | **t15** | **AI-706** | **ph10** | **t7** | **t10** |
| **AI-627** | **ph9** | **t16** | **t16** | **AI-667** | **ph9** | **t10** | **t16** | **AI-707** | **ph10** | **t7** | **t11** |
| **AI-628** | **ph9** | **t6** | **t7** | **AI-668** | **ph9** | **t11** | **t12** | **AI-708** | **ph10** | **t7** | **t12** |
| **AI-629** | **ph9** | **t6** | **t8** | **AI-669** | **ph9** | **t11** | **t13** | **AI-709** | **ph10** | **t7** | **t13** |
| **AI-630** | **ph9** | **t6** | **t9** | **AI-670** | **ph9** | **t11** | **t14** | **AI-710** | **ph10** | **t7** | **t14** |
| **AI-631** | **ph9** | **t6** | **t10** | **AI-671** | **ph9** | **t11** | **t15** | **AI-711** | **ph10** | **t7** | **t15** |
| **AI-632** | **ph9** | **t6** | **t11** | **AI-672** | **ph9** | **t11** | **t16** | **AI-712** | **ph10** | **t7** | **t16** |
| **AI-633** | **ph9** | **t6** | **t12** | **AI-673** | **ph9** | **t12** | **t13** | **AI-713** | **ph10** | **t8** | **t9** |
| **AI-634** | **ph9** | **t6** | **t13** | **AI-674** | **ph9** | **t12** | **t14** | **AI-714** | **ph10** | **t8** | **t10** |
| **AI-635** | **ph9** | **t6** | **t14** | **AI-675** | **ph9** | **t12** | **t15** | **AI-715** | **ph10** | **t8** | **t11** |
| **AI-636** | **ph9** | **t6** | **t15** | **AI-676** | **ph9** | **t12** | **t16** | **AI-716** | **ph10** | **t8** | **t12** |
| **AI-637** | **ph9** | **t6** | **t16** | **AI-677** | **ph9** | **t13** | **t14** | **AI-717** | **ph10** | **t8** | **t13** |
| **AI-638** | **ph9** | **t7** | **t8** | **AI-678** | **ph9** | **t13** | **t15** | **AI-718** | **ph10** | **t8** | **t14** |
| **AI-639** | **ph9** | **t7** | **t9** | **AI-679** | **ph9** | **t13** | **t16** | **AI-719** | **ph10** | **t8** | **t15** |
| **AI-640** | **ph9** | **t7** | **t10** | **AI-680** | **ph9** | **t14** | **t15** | **AI-720** | **ph10** | **t8** | **t16** |

**[Table 7]**

| | **L¹** | **A** | **B** | | **L¹** | **A** | **B** | | **L¹** | **A** | **B** |
|---|---|---|---|---|---|---|---|---|---|---|---|
| **AI-721** | **ph10** | **t9** | **t10** | **AI-731** | **ph10** | **t10** | **t14** | **AI-741** | **ph10** | **t12** | **t15** |
| **AI-722** | **ph10** | **t9** | **t11** | **AI-732** | **ph10** | **t10** | **t15** | **AI-742** | **ph10** | **t12** | **t16** |
| **AI-723** | **ph10** | **t9** | **t12** | **AI-733** | **ph10** | **t10** | **t16** | **AI-743** | **ph10** | **t13** | **t14** |
| **AI-724** | **ph10** | **t9** | **t13** | **AI-734** | **ph10** | **t11** | **t12** | **AI-744** | **ph10** | **t13** | **t15** |
| **AI-725** | **ph10** | **t9** | **t14** | **AI-735** | **ph10** | **t11** | **t13** | **AI-745** | **ph10** | **t13** | **t16** |
| **AI-726** | **ph10** | **t9** | **t15** | **AI-736** | **ph10** | **t11** | **t14** | **AI-746** | **ph10** | **t14** | **t15** |
| **AI-727** | **ph10** | **t9** | **t16** | **AI-737** | **ph10** | **t11** | **t15** | **AI-747** | **ph10** | **t14** | **t16** |
| **AI-728** | **ph10** | **t10** | **t11** | **AI-738** | **ph10** | **t11** | **t16** | **AI-748** | **ph10** | **t15** | **t16** |
| **AI-729** | **ph10** | **t10** | **t12** | **AI-739** | **ph10** | **t12** | **t13** | | | | |
| **AI-730** | **ph10** | **t10** | **t13** | **AI-740** | **ph10** | **t12** | **t14** | | | | |

In Tables 1 to 7, ph3 to ph10 represent groups represented by formulas (ph3) to (ph10), respectively. In the formulas, * represents a point of attachment to A, and ** represents a point of attachment to B.

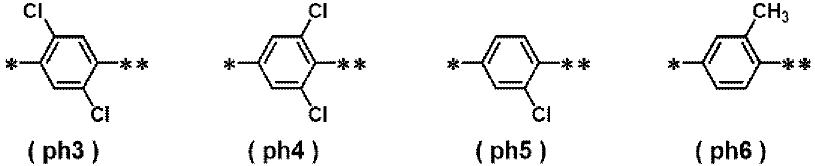

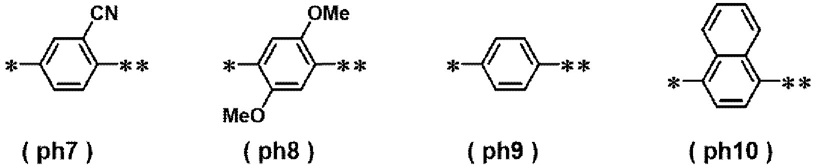

In Tables 1 to 7, t6 to t16 represent groups represented by formulas (t6) to (t16), respectively. In the formulas, R¹⁸ represents 2-methylcyclohexyl, phenyl, 3,5-di-tert-butylphenyl, adamantyl, or 1,3-dimethylbutyl. * represents a point of attachment to L¹.

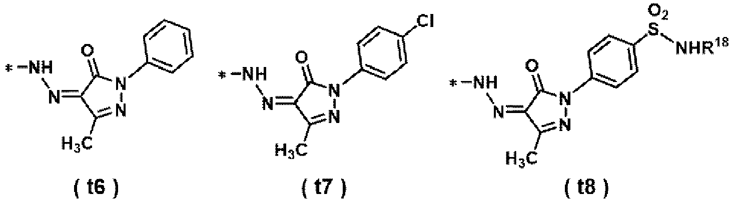

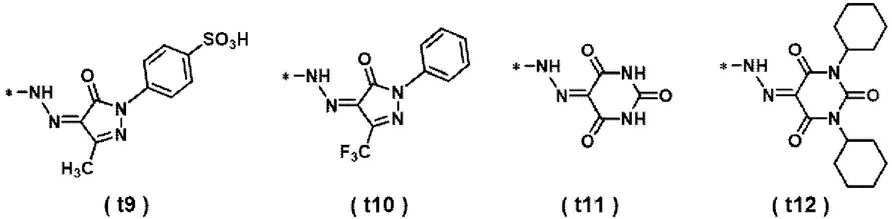

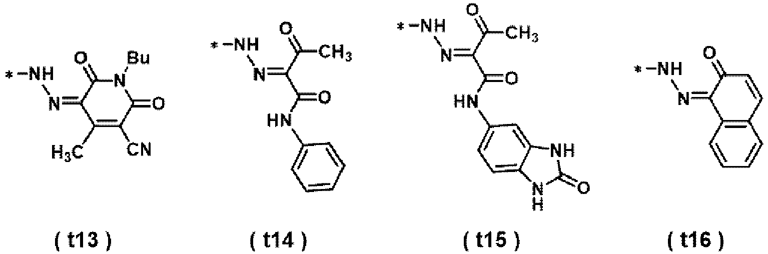

Examples of compound (I) also include following compounds (AI-749) to (AI-753).

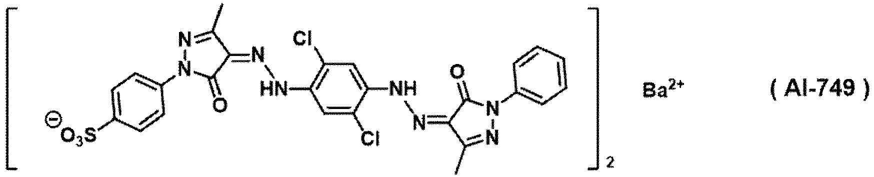

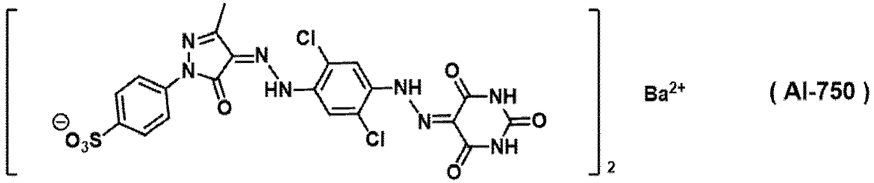

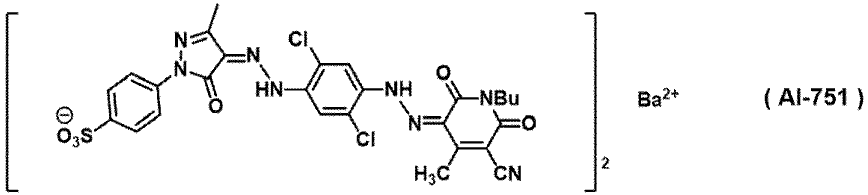

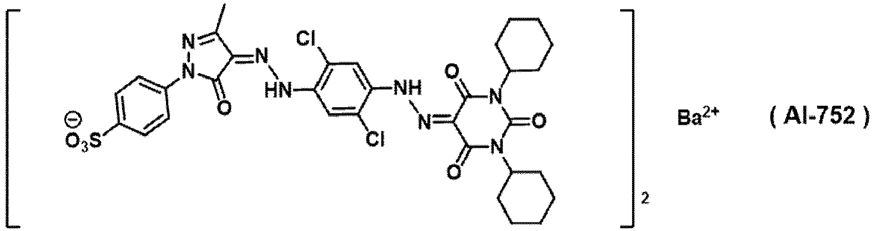

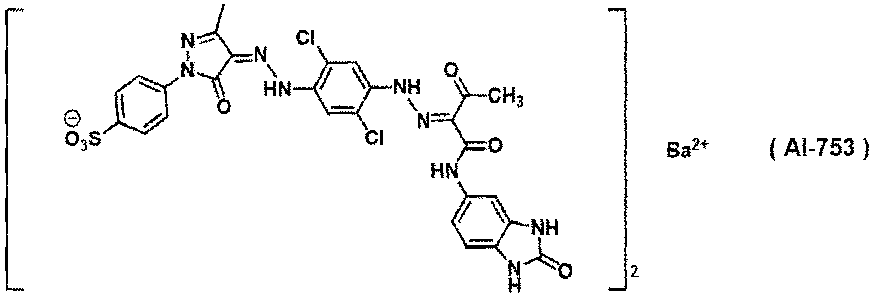

As the compound (I), compounds (AI-1) to (AI-682) and (AI-749) to (AI-753) are preferable,
compounds (AI-1) to (AI-682) in which A and B are each independently any of groups represented by formulas (t6) to (t15) are more preferable, and
compounds (AI-1) to (AI-10), (AI-67) to (AP76), (AI-188) to (AP197), (AI-309) to (AP318), (AI-430) to (AI-439), (AP511) to (AI-560), and (AI-617) to (AI-626) are still more preferable.

The compound (I) can be produced, for example, by the following method.

When the compound (I) is a compound represented by formula (I') (hereinafter sometimes referred to as compound (I')), first, an amine represented by formula (pt1) is diazotized to produce a diazonium salt represented by formula (q1). The produced diazonium salt is reacted with a compound represented by formula (pt2) to produce a compound represented by formula (q2). Subsequently, the compound represented by formula (q2) is reduced to produce an amine represented by formula (q3). Furthermore, the produced amine is diazotized to produce a diazonium salt represented by formula (q4), and the produced diazonium salt is then reacted with a compound represented by formula (pt3), whereby a compound represented by formula (I') can be produced.

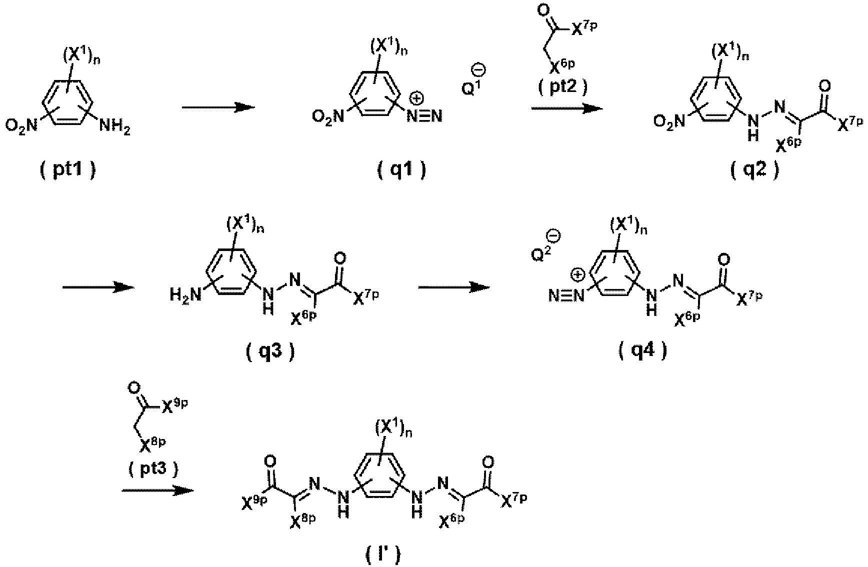

In formulas (pt1) to (pt3), formulas (q1) to (q4), and formula (I'),
X¹ and n have the same meanings as above;
X^{6p} to X^{9p} each independently represent a hydrocarbon group optionally having, as a substituent, a hydroxy group, a C₁-C₄ alkoxy group, a C₁-C₄ alkylthio group, a carboxyl group, an amino group, an amide group, a cyano group, a halogen atom, or -SO₃H, -CH₂- contained in the hydrocarbon group may be replaced with -O-, -CO-, or -NH-, -CH= contained in the hydrocarbon group may be replaced with -N=, and -C< contained in the hydrocarbon group may be replaced with -N<;
X^{6p} and X^{7p} may be combined with each other to form a ring, and X^{8p} and X^{9p} may be combined with each other to form a ring; and
Q¹ and Q² each independently represent an inorganic anion or an organic anion.

The diazonium salt represented by formula (q!) can be obtained, for example, by diazotization of the amine represented by formula (pt1) with a nitrous acid, a nitrous acid salt, or a nitrous acid ester. Such diazotization can be carried out by any known method.

Examples of the inorganic anion include a fluoride ion, a chloride ion, a bromide ion, an iodide ion, a perchlorate ion, and a hypochlorite ion. Examples of the organic anion include CH₃COO⁻ and C₆H₅COO⁻. Preferred examples of Q¹ and Q² include a chloride ion, a bromide ion, and CH₃COO⁻.

An acidic catalyst may be used in the foregoing diazotization reaction to allow the reaction to proceed smoothly. Examples of the acidic catalyst include mineral acids such as sulfuric acid and hydrochloric acid.

The compound represented by formula (q2) can be produced by diazo-coupling the diazonium salt represented by formula (q!) with the compound represented by formula (pt2). Such diazo-coupling can be carried out by any known method. This reaction is preferably performed in the presence of an aqueous solvent. Examples of the aqueous solvent include water, a water-soluble organic solvent such as methanol, ethanol, propanol, and 2-propanol, and a mixed solvent of water and the water-soluble organic solvent. Among these, a mixed solvent of water and the water-soluble organic solvent is preferable.

The compound represented by formula (q3) can be produced by reduction of the compound represented by the formula (q2). The method of reduction is not particularly limited, and the reduction can be carried out by any known method. For example, reduction with a reducing agent such as a sulfide can be employed. The sulfide is not particularly limited, and examples thereof include hydrosulfides such as sodium hydrosulfide, potassium hydrosulfide, and ammonium hydrosulfide, and sulfides such as sodium sulfide, potassium sulfide and ammonium sulfide. These hydrosulfides and sulfides may be anhydrous or contain water of crystallization. The reduction reaction is preferably performed in the presence of an aqueous solvent. Examples of the aqueous solvent include the same solvents as the above-mentioned aqueous solvents, and preferred is water.

The diazonium salt represented by formula (q4) can be obtained by diazotization of the amine represented by formula (q3). As the method of diazotization, the same method as the above-mentioned method of diazotization of the compound represented by formula (pt1) can be employed.

The compound (I') can be produced by diazo-coupling the diazonium salt represented by formula (q4) with the compound represented by formula (pt3). As the method of diazo-coupling, the same method as the above-mentioned method of diazo-coupling of the diazonium salt represented by formula (q1) with the compound represented by formula (pt2) can be employed.

When producing a compound represented by the compound (I) in which at least one of X⁶ to X⁹ is a hydrocarbon group having -SO₃M or -SO₃T_{0.5} as a substituent (hereinafter sometimes referred to as compound (I")), the compound (I') in which at least one of X^{6p} to X^{9p} is a hydrocarbon group having a sulfonic acid group as a substituent is produced by the method described above, and then the produced compound (I') having a sulfonic acid group as a substituent is reacted with an alkali metal salt or an alkaline-earth metal salt. Through this reaction, the sulfonic acid group in the compound (I') is converted to -SO₃M or -SO₃T_{0.5}, whereby a compound (I") can be produced.

Examples of the alkali metal compound and the alkaline-earth metal compound include a salt with a chloride ion, a salt with an iodide ion, a salt with a bromide ion, a salt with an acetate ion, a salt with a formate ion, and a salt with a benzoate ion. Among these, a salt with an acetate ion is preferable.

This reaction is preferably performed in the presence of a mixed solvent of an organic solvent and an aqueous solvent. Examples of the aqueous solvent include the same solvents as the above-mentioned aqueous solvents, and preferred is water. Examples of the organic solvent include ester solvents such as ethyl lactate, butyl lactate, n-butyl acetate, ethyl butyrate, and methyl acetoacetate; ether solvents such as ethylene glycol monobutyl ether, diethylene glycol monomethyl ether, and propylene glycol monomethyl ether; ketone solvents such as diacetone alcohol; amide solvents such as N,N-dimethylformamide, N,N-dimethylacetamide, and N-methylpyrrolidone; and halogen solvents such as chloroform and methylene chloride. Among these, amide solvents are preferable.

When producing a compound represented by the compound (I) in which at least one of X⁶ to X⁹ is a hydrocarbon group having -SO₂N(R¹⁷)₂ as a substituent (hereinafter sometimes referred to as compound (I‴)), first, the compound (I') in which at least one of X^{6p} to X^{9p} is a hydrocarbon group having a sulfonic acid group as a substituent is produced by the method described above, and then the produced compound (I') having a sulfonic acid group is reacted with a halogenating agent. To the resulting reaction solution are added a base and NH(R¹⁷)₂ to allow them to react. Through this reaction, the sulfonic acid group in the compound (I') is converted to -SO₂N(R¹⁷)₂, whereby a compound (I‴) can be produced.

Examples of the halogenating agent include thionyl chloride, oxalyl chloride, phosphorus trichloride, and phosphorus pentachloride.

The reaction is preferably performed in the presence of an organic solvent. Examples of the organic solvent include the same solvents as the above-mentioned organic solvents, and preferred are amide solvents and halogen solvents.

Examples of the base include organic bases such as triethylamine, 4-(N,N-dimethylamino)pyridine, pyridine, and piperidine; metal alkoxides such as sodium methoxide, sodium ethoxide, sodium tert-butoxide, and potassium tert-butoxide; organometallic compounds such as butyllithium, tert-butyllithium and phenyllithium; and inorganic bases such as lithium hydroxide, sodium hydroxide and potassium hydroxide. Among these, organic bases are preferable.

There is no specific limitation on the method of obtaining the compound (I) (for example, compounds (I') to (I‴)) from the reaction mixture, and various known methods can be employed. For example, an acid (acetic acid or the like) is added to the reaction mixture as necessary, and precipitated crystal can be collected by filtration. Alternatively, the solvent is distilled off from the reaction mixture after completion of the reaction, a small amount of methanol is added, followed by stirring, and an acid (acetic acid or the like) and water is added to the resulting solution, whereby precipitated crystal can be collected by filtration. The crystal obtained by filtration is preferably washed with water or methanol and then dried. If necessary, the crystal may be further purified by a known method such as recrystallization.

The content of the compound (I) in the whole amount of the colorant (A) is preferably 5% by mass or more, more preferably 10% by mass or more, and still more preferably 20% by mass or more. This content may 100% by mass and may 98% by mass or less or 93% by mass or less.

The colorant (A) may further contain a colorant different from the compound (I). The colorant different from the compound (I) may be one or both of a dye (hereinafter, sometimes referred to as a dye (A1)) and a pigment (hereinafter, sometimes referred to as a pigment (A2)).

The dye (A1) is not particularly limited, and any known dye other than the compound (I) can be used. Examples of the dye (A1) include a solvent dye, an acid dye, a direct dye, and a mordant dye. Examples of the dye (A1) include a compound that is not a pigment but classified into a compound having a hue in the Color Index (published by The Society of Dyers and Colourists), and a known dye as described in Dying note (Shikisensha Co., Ltd.). According to chemical structures, examples thereof include an azo dye other than the compound (I), a cyanine dye, a triphenylmethane dye, a xanthene dye, a phthalocyanine dye, an anthraquinone dye, a naphthoquinone dye, a quinonimine dye, a methine dye, an azomethine dye, a squarylium dye, an acridine dye, a styryl dye, a coumarin dye, a quinoline dye, and a nitro dye. Among these, a dye which is soluble in an organic solvent is preferable.

### Specific examples of the dye (A1) include

C. I. Solvent dyes such as:
   C. I. Solvent Yellow 4 (hereinafter, the term "C. I. Solvent Yellow" is omitted and only the number is shown), 14, 15, 23, 24, 38, 62, 63, 68, 82, 94, 98, 99, 117, 162, 163, 167, and 189;
   C. I. Solvent Red 45, 49, 111, 125, 130, 143, 145, 146, 150, 151, 155, 168, 169, 172, 175, 181, 207, 218, 222, 227, 230, 245, and 247;
   C. I. Solvent Orange 2, 7, 11, 15, 26, 56, 77, and 86;
   C. I. Solvent Violet 11, 13, 14, 26, 31, 36, 37, 38, 45, 47, 48, 51, 59, and 60;
   C. I. Solvent Blue 4, 5, 14, 18, 35, 36, 37, 45, 58, 59, 59:1, 63, 67, 68, 69, 70, 78, 79, 83, 90, 94, 97, 98, 100, 101, 102, 104, 105, 111, 112, 122, 128, 132, 136, and 139; and
   C. I. Solvent Green 1, 3, 4, 5, 7, 28, 29, 32, 33, 34, and 35,
C. I. Acid dyes such as:
   C. I. Acid Yellow 1, 3, 7, 9, 11, 17, 23, 25, 29, 34, 36, 38, 40, 42, 54, 65, 72, 73, 76, 79, 98, 99, 111, 112, 113, 114, 116, 119, 123, 128, 134, 135, 138, 139, 140, 144, 150, 155, 157, 160, 161, 163, 168, 169, 172, 177, 178, 179, 184, 190, 193, 196, 197, 199, 202, 203, 204, 205, 207, 212, 214, 220, 221, 228, 230, 232, 235, 238, 240, 242, 243, and 251;
   C. I. Acid Red 1, 4, 8, 14, 17, 18, 26, 27, 29, 31, 33, 34, 35, 37, 40, 42, 44, 50, 51, 52, 57, 66, 73, 76, 80, 87, 88, 91, 92, 94, 95, 97, 98, 103, 106, 111, 114, 129, 133, 134, 138, 143, 145, 150, 151, 155, 158, 160, 172, 176, 182, 183, 195, 198, 206, 211, 215, 216, 217, 227, 228, 249, 252, 257, 258, 260, 261, 266, 268, 270, 274, 277, 280, 281, 289, 308, 312, 315, 316, 339, 341, 345, 346, 349, 382, 383, 388, 394, 401, 412, 417, 418, 422, and 426;
   C. I. Acid Orange 6, 7, 8, 10, 12, 26, 50, 51, 52, 56, 62, 63, 64, 74, 75, 94, 95, 107, 108, 169, and 173;
   C. I. Acid Violet 6B, 7, 9, 15, 16, 17, 19, 21, 23, 24, 25, 30, 34, 38, 49, 72, and 102;
   C.I. Acid Blue 1, 3, 5, 7, 9, 11, 13, 15, 17, 18, 22, 23, 24, 25, 26, 27, 29, 34, 38, 40, 41, 42, 43, 45, 48, 51, 54, 59, 60, 62, 70, 72, 74, 75, 78, 80, 82, 83, 86, 87, 88, 90, 90:1, 91, 92, 93, 93:1, 96, 99, 100, 102, 103, 104, 108, 109, 110, 112, 113, 117, 119, 120, 123, 126, 127, 129, 130, 131, 138, 140, 142, 143, 147, 150, 151, 154, 158, 161, 166, 167, 168, 170, 171, 175, 182, 183, 184, 187, 192, 199, 203, 204, 205, 210, 213, 229, 234, 236, 242, 243, 256, 259, 267, 269, 278, 280, 285, 290, 296, 315, 324:1, 335, and 340; and
   C. I. Acid Green 1, 3, 5, 6, 7, 8, 9, 11, 13, 14, 15, 16, 22, 25, 27, 28, 41, 50, 50:1, 58, 63, 65, 80, 104, 105, 106, and 109,
C. I. Direct dyes such as:
   C. I. Direct Yellow 2, 33, 34, 35, 38, 39, 43, 47, 50, 54, 58, 68, 69, 70, 71, 86, 93, 94, 95, 98, 102, 108, 109, 129, 136, 138, and 141;
   C. I. Direct Red 79, 82, 83, 84, 91, 92, 96, 97, 98, 99, 105, 106, 107, 172, 173, 176, 177, 179, 181, 182, 184, 204, 207, 211, 213, 218, 220, 221, 222, 232, 233, 234, 241, 243, 246, and 250;
   C. I. Direct Orange 26, 34, 39, 41, 46, 50, 52, 56, 57, 61, 64, 65, 68, 70, 96, 97, 106, and 107;
   C. I. Direct Violet 47, 52, 54, 59, 60, 65, 66, 79, 80, 81, 82, 84, 89, 90, 93, 95, 96, 103, and 104;
   C. I. Direct Blue 1, 2, 3, 6, 8, 15, 22, 25, 28, 29, 40, 41, 42, 47, 52, 55, 57, 71, 76, 77, 78, 80, 81, 84, 85, 86, 90, 93, 94, 95, 97, 98, 99, 100, 101, 106, 107, 108, 109, 113, 114, 115, 117, 119, 120, 137, 149, 150, 153, 155, 156, 158, 159, 160, 161, 162, 163, 164, 165, 166, 167, 168, 170, 171, 172, 173, 188, 189, 190, 192, 193, 194, 195, 196, 198, 199, 200, 201, 202, 203, 207, 209, 210, 212, 213, 214, 222, 225, 226, 228, 229, 236, 237, 238, 242, 243, 244, 245, 246, 247, 248, 249, 250, 251, 252, 256, 257, 259, 260, 268, 274, 275, and 293; and
   C. I. Direct Green 25, 27, 31, 32, 34, 37, 63, 65, 66, 67, 68, 69, 72, 77, 79, and 82,
C. I. Disperse dyes such as:
   C. I. Disperse Yellow 51, 54, and 76;
   C. I. Disperse Violet 26 and 27; and
   C. I. Disperse Blue 1, 14, 56, and 60,
C. I. Basic dyes such as:
   C. I. Basic Red 1 and 10;
   C. I. Basic Blue 1, 3, 5, 7, 9, 19, 21, 22, 24, 25, 26, 28, 29, 40, 41, 45, 47, 54, 58, 59, 60, 64, 65, 66, 67, 68, 81, 83, 88, and 89;
   C. I. Basic Violet 2;
   C. I. Basic Red 9;and
   C. I. Basic Green 1,
C. I. Reactive dyes such as:
   C. I. Reactive Yellow 2, 76, and 116;
   C. I. Reactive Orange 16; and
   C. I. Reactive Red 36,
C. I. Mordant dyes such as:
   C. I. Mordant Yellow 5, 8, 10, 16, 20, 26, 30, 31, 33, 42, 43, 45, 56, 61, 62, and 65;
   C. I. Mordant Red 1, 2, 3, 4, 9, 11, 12, 14, 17, 18, 19, 22, 23, 24, 25, 26, 27, 29, 30, 32, 33, 36, 37, 38, 39, 41, 42, 43, 45, 46, 48, 52, 53, 56, 62, 63, 71, 74, 76, 78, 85, 86, 88, 90, 94, and 95;
   C. I. Mordant Orange 3, 4, 5, 8, 12, 13, 14, 20, 21, 23, 24, 28, 29, 32, 34, 35, 36, 37, 42, 43, 47, and 48;
   C. I. Mordant Violet 1, 1:1, 2, 3, 4, 5, 6, 7, 8, 10, 11, 14, 15, 16, 17, 18, 19, 21, 22, 23, 24, 27, 28, 30, 31, 32, 33, 36, 37, 39, 40, 41, 44, 45, 47, 48, 49, 53, and 58;
   C. I. Mordant Blue 1, 2, 3, 7, 8, 9, 12, 13, 15, 16, 19, 20, 21, 22, 23, 24, 26, 30, 31, 32, 39, 40, 41, 43, 44, 48, 49, 53, 61, 74, 77, 83, and 84; and
   C. I. Mordant Green 1, 3, 4, 5, 10, 13, 15, 19, 21, 23, 26, 29, 31, 33, 34, 35, 41, 43, and 53; and
C. I. Vat dyes such as:
   C. I. Vat Green 1.

Specific examples of the dye (A1) also include compounds represented formulas (z) and (z1).

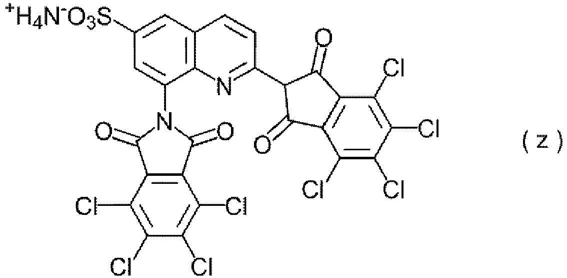

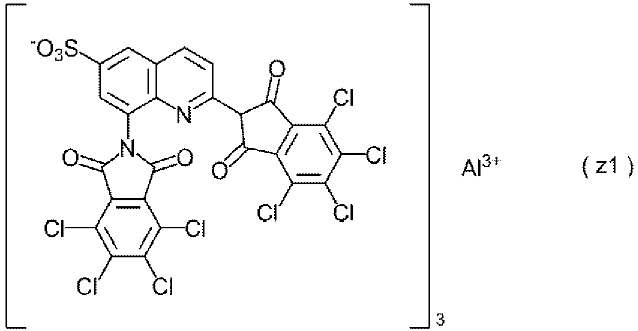

These dyes may be appropriately selected depending on the optical spectrum of a desired color filter.

When the colorant (A) contains the dye (A1), the content of the dye (A1) is preferably 1% by mass or more, more preferably 3% by mass or more, and still more preferably 5% by mass or more, and is preferably 20% by mass or less and more preferably 15% by mass or less, in the whole amount of the colorant (A).

The pigment (A2) is not particularly limited, and any known pigment can be used. Examples of the pigment (A2) include a pigment that is classified into a pigment in the Color Index (published by The Society of Dyers and Colourists).

Specific examples of the pigment include
yellow pigments such as C.I. Pigment Yellow 1, 3, 10, 12, 13, 14, 15, 16, 17, 20, 24, 31, 53, 81, 83, 86, 93, 94, 109, 110, 117, 125, 128, 129, 137, 138, 139, 147, 148, 150, 153, 154, 166, 173, 185, 194, 214, and 231;
orange pigments such as C.I. Pigment Orange 13, 31, 36, 38, 40, 42, 43, 51, 55, 59, 61, 62, 64, 65, 71, 72, and 73;
red pigments such as C.I. Pigment Red 9, 97, 105, 122, 123, 144, 149, 166, 168, 176, 177, 179, 180, 190, 192, 202, 209, 215, 216, 224, 242, 254, 255, 264, 265, 266, 268, 269, 273, 291, 295, and 296;
blue pigments such as C.I. Pigment Blue 15, 15:3, 15:4, 15:6, and 60;
violet pigments such as C.I. Pigment Violet 1, 19, 23, 29, 32, 36, and 38;
green pigments such as C.I. Pigment Green 7, 36, 58, 59, 62, and 63;
brown pigments such as C.I. Pigment Brown 23 and 25; and
black pigments such as C.I. Pigment Black 1 and 7.

If necessary, the pigment may be subjected to a treatment such as a rosin treatment; a surface treatment using a pigment derivative or the like having an introduced acidic group or basic group; a pigment surface graft treatment with a polymeric compound or the like; a particle micronization treatment by a sulfuric acid micronization method or the like; a washing treatment with an organic solvent, water or the like for removing impurities; or a removing treatment of ionic impurities by an ionic exchange method or the like.

The pigment preferably has a uniform particle diameter. To the pigment, a pigment dispersant is added, followed by performing a dispersion treatment, whereby a pigment dispersion in which the pigment is uniformly dispersed in a solvent can be produced.

Examples of the pigment dispersant include surfactants such as a cationic surfactant, an anionic surfactant, a non-ionic surfactant, an amphoteric surfactant, a polyester-based surfactant, a polyamine-based surfactant, and an acrylic surfactant. These pigment dispersants may be used singly or in combination of two or more thereof. Examples in trade names of the pigment dispersant include KP (manufactured by Shin-Etsu Chemical Co., Ltd.), Flowlen (manufactured by Kyoeisha Chemical Co., Ltd.), Solsperse (manufactured by Zeneca Ltd.), EFKA (manufactured by Ciba), AJISPER (manufactured by Ajinomoto Fine-Techno Co., Inc.), and Disperbyk (manufactured by BYK-Chemie Corporation).

When the pigment dispersant is used, the amount thereof used is preferably 1% by mass or more and 100% by mass or less, and more preferably 5% by mass or more and 50% by mass or less, relative to the whole amount of the pigment (A2). When the amount of the pigment dispersant used falls within the above-mentioned range, a pigment dispersion in which two or more pigments are more uniformly dispersed tends to be obtained.

The content of the colorant (A) is preferably 0.1% by mass or more and 70% by mass or less, more preferably 0.5% by mass or more and 60% by mass or less, and still more preferably 1% by mass or more and 50% by mass or less, in the whole amount of the solid content. When the content of the colorant (A) falls within the above-mentioned range, the color density of the resulting color filter is sufficient, and the composition can be made to contain a required amount of the resin (B) and polymerizable compound (C), so that it is possible to form a pattern having sufficient mechanical strength.

Herein, the term "whole amount of the solid content" means the total amount of components obtained by excluding the solvent from the colored composition of the present invention. The whole amount of the solid content and the content of each of the components with respect thereto can be measured by known analysis means such as liquid chromatography or gas chromatography.

### <Resin (B)>

The resin (B) is an alkali soluble resin. Examples of the resin (B) include the following resins [K1] to [K6].
Resin [K1]; a copolymer having a structural unit derived from at least one monomer (a) selected from the group consisting of an unsaturated carboxylic acid and an unsaturated carboxylic anhydride (hereinafter, the monomer (a) is sometimes referred to as "(a)") and a structural unit derived from a monomer (b) having a cyclic ether structure having 2 to 4 carbon atoms and an ethylenically unsaturated bond (hereinafter, monomer (b) is sometimes referred to as "(b)");
Resin [K2]; a copolymer having a structural unit derived from (a), a structural unit derived from (b), and a structural unit derived from a monomer (c) copolymerizable with (a) (hereinafter, the monomer (c) is sometimes referred to as "(c)");
Resin [K3]; a copolymer having a structural unit derived from (a) and a structural unit derived from (c);
Resin [K4]; a copolymer having (i) a structural unit produced by adding (b) to a structural unit derived from (a) and (ii) a structural unit derived from (c);
Resin [K5]; a copolymer having (i) a structural unit produced by adding (a) to a structural unit derived from (b) and (ii) a structural unit derived from (c); and
Resin [K6]; a copolymer having (i) a structural unit produced by adding (a) to a structural unit derived from (b) and further adding a carboxylic anhydride thereto, and (ii) a structural unit derived from (c).

It is noted that (c) is different from (a) and (b).

Specific examples of (a) include unsaturated monocarboxylic acids such as acrylic acid, methacrylic acid, crotonic acid, and o-, m- or p-vinylbenzoic acid;
unsaturated dicarboxylic acids such as maleic acid, fumaric acid, citraconic acid, mesaconic acid, itaconic acid, 3-vinylphthalic acid, 4-vinylphthalic acid, 3,4,5,6-tetrahydrophthalic acid, 1,2,3,6-tetrahydrophthalic acid, dimethyltetrahydrophthalic acid, and 1,4-cyclohexenedicarboxylic acid;
carboxy group-containing bicyclo unsaturated compounds such as methyl-5-norbornene-2,3-dicarboxylic acid, 5-carboxybicyclo[2.2.1]hept-2-ene, 5,6-dicarboxybicyclo[2.2.1]hept-2-ene, 5-carboxy-5-methylbicyclo[2.2.1]hept-2-ene, 5-carboxy-5-ethylbicyclo[2.2.1]hept-2-ene, 5-carboxy-6-methylbicyclo[2.2.1]hept-2-ene, and 5-carboxy-6-ethylbicyclo[2.2.1]hept-2-ene;
unsaturated dicarboxylic anhydrides such as maleic anhydride, citraconic anhydride, itaconic anhydride, 3-vinylphthalic anhydride, 4-vinylphthalic anhydride, 3,4,5,6-tetrahydrophthalic anhydride, 1,2,3,6-tetrahydrophthalic anhydride, dimethyltetrahydrophthalic anhydride, and 5,6-dicarboxybicyclo[2.2.1]hept-2-ene anhydride;
unsaturated monoL(meth)acryloyloxyalkyl]esters of a polyvalent carboxylic acid having a valence of 2 or more such as succinic acid mono[2-(meth)acryloyloxyethyl], and phthalic acid mono [2-(meth) acryloyloxy ethyl]; and
unsaturated acrylates containing a hydroxy group and a carboxy group in its molecule such as α-(hydroxymethyl)acrylic acid.

Among these, from the viewpoint of copolymerization reactivity and solubility of obtained resin to an alkaline aqueous solution, acrylic acid, methacrylic acid, maleic anhydride and the like are preferable.

Herein, "(meth)acrylic acid" represents at least one selected from the group consisting of acrylic acid and methacrylic acid. The terms "(meth)acryloyl", "(meth)acrylate" and the like also have similar meanings.

(b) means a polymerizable compound having a C₂-C₄ cyclic ether structure (for example, at least one selected from the group consisting of an oxirane ring, an oxetane ring, and a tetrahydrofuran ring) and an ethylenically unsaturated bond. (b) is preferably a monomer having a C₂-C₄ cyclic ether and a (meth)acryloyloxy group.

Examples of (b) include a monomer (b1) having an oxiranyl group and an ethylenically unsaturated bond (hereinafter, the monomer (b1) is sometimes referred to as "(b1)"), a monomer (b2) having an oxetanyl group and an ethylenically unsaturated bond (hereinafter, the monomer (b2) is sometimes referred to as "(b2)"), and a monomer (b3) having a tetrahydrofuryl group and an ethylenically unsaturated bond (hereinafter, the monomer (b3) is sometimes referred to as "(b3)").

Examples of (b1) include a monomer (b1-1) having a structure where a straight- or branched-chain aliphatic unsaturated hydrocarbon is epoxidized (hereinafter, the monomer (b1-1) is sometimes referred to as "(b1-1)") and a monomer (b1-2) having a structure where an alicyclic unsaturated hydrocarbon is epoxidized (hereinafter, sometimes referred to as "(b1-2)").

Specific examples of (b1-1) include glycidyl(meth)acrylate, β-methylglycidyl(meth)acrylate, β-ethylglycidyl(meth)acrylate, glycidyl vinyl ether, o-vinylbenzyl glycidyl ether, m-vinylbenzyl glycidyl ether, p-vinylbenzyl glycidyl ether, α-methyl-o-vinylbenzyl glycidyl ether, α-methyl-m-vinylbenzyl glycidyl ether, α-methyl-p-vinylbenzyl glycidyl ether, 2,3-bis(glycidyloxymethyl)styrene, 2,4-bis(glycidyloxymethyl)styrene, 2,5-bis(glycidyloxymethyl)styrene, 2,6-bis(glycidyloxymethyl)styrene, 2,3,4-tris(glycidyloxymethyl)styrene, 2,3,5-tris(glycidyloxymethyl)styrene, 2,3,6-tris(glycidyloxymethyl)styrene, 3,4,5-tris(glycidyloxymethyl)styrene, and 2,4,6-tris(glycidyloxymethyl) styrene.

Specific examples of (b1-2) include vinylcyclohexene monoxide, 1,2-epoxy-4-vinylcyclohexane (for example, Celloxide 2000 manufactured by Daicel Corporation), 3,4-epoxycyclohexylmethyl(meth)acrylate (for example, Cyclomer A400 manufactured by Daicel Corporation), 3,4-epoxycyclohexylmethyl(meth)acrylate (for example, Cyclomer M100 manufactured by Daicel Corporation), a compound represented by formula (R1), and a compound represented by formula (R2).

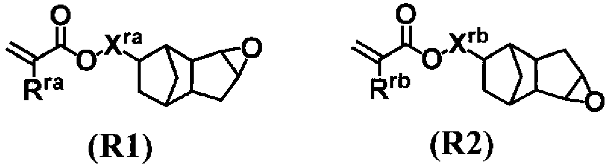

In formulas (R1) and (R2),
R^{ra} and R^{rb} represent a hydrogen atom or a C₁-C₄ alkyl group; a hydrogen atom contained in the alkyl group is optionally replaced with a hydroxy group;
X^{ra} and X^{rb} represent a single bond, *-R^{rc}-, *-R^{rc}-O-, *-R^{rc}-S-, or *-R^{rc}-NH-;
R^{rc} represents a C₁-C₆ alkanediyl group; and
* represents a point of attachment to O.

Examples of the C₁-C₄ alkyl group include methyl, ethyl, n-propyl, isopropyl, n-butyl, sec-butyl, and tert-butyl.

Examples of the alkyl group in which the hydrogen atom is replaced with the hydroxy group include hydroxymethyl, 1-hydroxyethyl, 2-hydroxyethyl, 1-hydroxypropyl, 2-hydroxypropyl, 3-hydroxypropyl, 1-hydroxy-1-methylethyl, 2-hydroxy-1-methylethyl, 1-hydroxybutyl, 2-hydroxybutyl, 3-hydroxybutyl, and 4-hydroxybutyl.

R^{ra} and R^{rb} are preferably a hydrogen atom, methyl, hydroxymethyl, 1-hydroxyethyl, or 2-hydroxyethyl, and more preferably a hydrogen atom or methyl.

Examples of the alkanediyl group include methylene, ethylene, propane-1,2-diyl, propane-1,3-diyl, butane-1,4-diyl, pentane-1,5-diyl, and hexane-1,6-diyl.

X^{ra} and X^{rb} are preferably a single bond, methylene, ethylene, *-CH₂-O-, or *-CH₂CH₂-O-, and more preferably a single bond or *-CH₂CH₂-O- (* represents a point of attachment to O).

Examples of the compound represented by formula (R1) include a compound represented by any of formulas (R1-1) to (R1-15). Among these, the compound represented by any of formulas (R1-1), (R1-3), (R1-5), (R1-7), (R1-9), and (R1-11) to (R1-15) is preferable, and the compound represented by any of formulas (R1-1), (R1-7), (R1-9), and (R1-15) is more preferable.

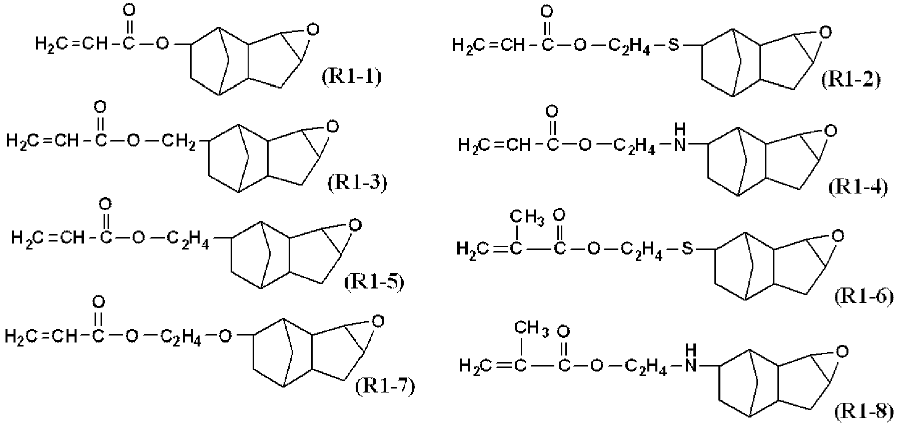

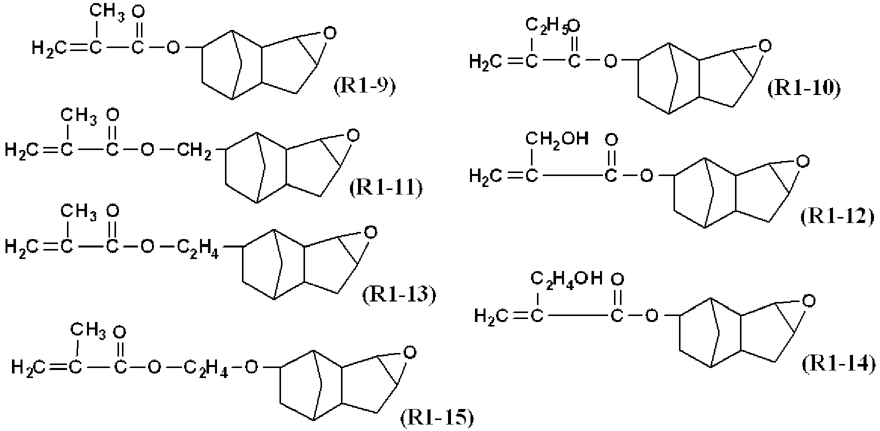

Examples of the compound represented by formula (R2) include a compound represented by any of formulas (R2-1) to (R2-15). Among these, the compound represented by any of formulas (R2-1), (R2-3), (R2-5), (R2-7), (R2-9), and (R2-11) to (R2-15) is preferable, and the compound represented by any of formulas (R2-1), (R2-7), (R2-9), and (R2-15) is more preferable.

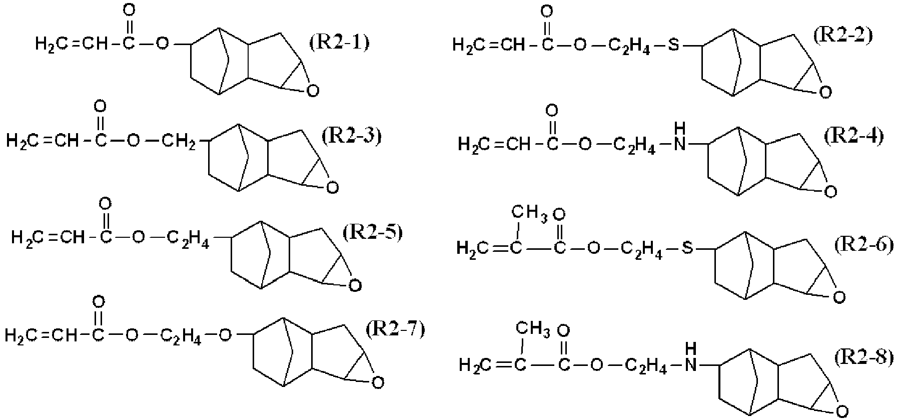

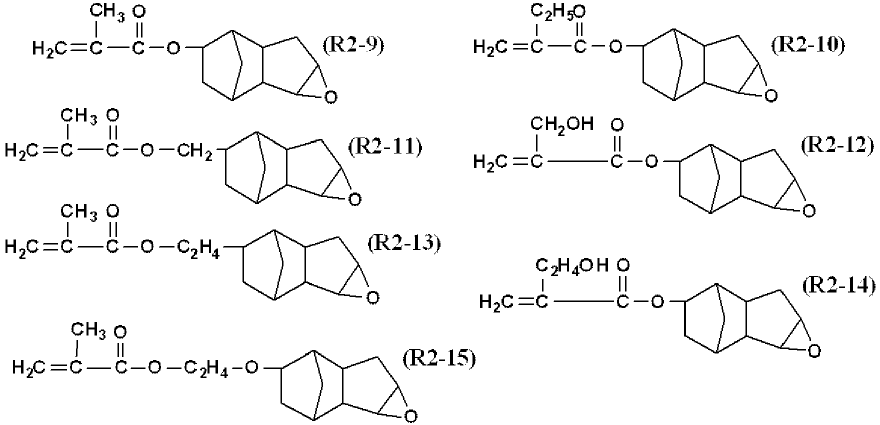

The compound represented by formula (R1) and the compound represented by formula (R2) may be used singly or in combinations of two or more thereof. When the compounds represented by formulas (R1) and (R2) are used in combination, the content ratio thereof [compound represented by formula (R1): compound represented by formula (R2)] is preferably 5:95 to 95:5, and more preferably 20:80 to 80:20, on a molar basis.

(b2) is more preferably a monomer having an oxetanyl group and a (meth)acryloyloxy group. Examples of (b2) include 3-methyl-3-methacryloyloxy methyl oxetane, 3-methyl-3-acryloyloxy methyl oxetane, 3-ethyl-3-methacryloyloxy methyl oxetane, 3-ethyl-3-acryloyloxy methyl oxetane, 3-methyl-3-methacryloyloxy ethyl oxetane, 3-methyl-3-acryloyloxy ethyl oxetane, 3-ethyl-3-methacryloyloxy ethyl oxetane, and 3-ethyl-3-acryloyloxy ethyl oxetane.

(b3) is more preferably a monomer having a tetrahydrofuryl group and a (meth)acryloyloxy group. Specific examples of (b3) include tetrahydrofurfuryl acrylate (for example, Viscoat V#150 manufactured by Osaka Organic Chemical Industry Ltd.) and tetrahydrofurfuryl methacrylate.

(b) is preferably (b1) since reliabilities such as heat resistance and chemical resistance of a color filter to be produced can be further improved, and more preferably (b1-2) since the storage stability of the colored composition is excellent.

Examples of (c) include
(meth)acrylic esters such as methyl(meth)acrylate, ethyl(meth)acrylate, n-butyl(meth)acrylate, sec-butyl(meth)acrylate, tert-butyl(meth)acrylate, 2-ethylhexyl(meth)acrylate, dodecyl(meth)acrylate, lauryl(meth)acrylate, stearyl(meth)acrylate, cyclopentyl(meth)acrylate, cyclohexyl(meth)acrylate, 2-methylcyclohexyl(meth)acrylate, tricyclo[5.2.1.0^{2,6}]decan-8-yl(meth)acrylate (which is referred to as "dicyclopentanyl(meth)acrylate" (common name) in the art or sometimes referred to as "tricyclodecyl(meth)acrylate"), tricyclo [5.2.1.0^{2,6}]decene-8-yl (meth)acrylate (which is referred to as "dicyclopentenyl(meth)acrylate" (common name) in the art), dicyclopentanyloxyethyl(meth)acrylate, isobornyl(meth)acrylate, adamantyl(meth)acrylate, allyl(meth)acrylate, propargyl(meth)acrylate, phenyl(meth)acrylate, naphthyl(meth)acrylate, and benzyl(meth)acrylate;
hydroxy group-containing (meth)acrylic esters such as 2-hydroxyethyl(meth)acrylate and 2-hydroxypropyl(meth)acrylate;
dicarboxylic diesters such as diethyl maleate, diethyl fumarate, and diethyl itaconate;
bicyclo unsaturated compounds such as bicyclo[2.2.1]hept-2-ene, 5-methylbicyclo[2.2.1]hept-2-ene, 5-ethylbicyclo[2.2.1]hept-2-ene, 5-hydroxybicyclo[2.2.1]hept-2-ene, 5-hydroxymethylbicyclo[2.2.1]hept-2-ene, 5-(2'-hydroxyethyl)bicyclo[2.2.1]hept-2-ene, 5-methoxybicyclo[2.2.1]hept-2-ene, 5-ethoxybicyclo[2.2.1]hept-2-ene, 5,6-dihydroxybicyclo[2.2.1]hept-2-ene, 5,6-di(hydroxymethyl)bicyclo[2.2.1]hept-2-ene, 5,6-di(2'-hydroxyethyl)bicyclo[2.2.1]hept-2-ene, 5,6-dimethoxybicyclo[2.2.1]hept-2-ene, 5,6-diethoxybicyclo[2.2.1]hept-2-ene, 5-hydroxy-5-methylbicyclo[2.2.1]hept-2-ene, 5-hydroxy-5-ethylbicyclo[2.2.1]hept-2-ene, 5-hydroxymethyl-5-methylbicyclo[2.2.1]hept-2-ene, 5-tert-butoxycarbonylbicyclo[2.2.1]hept-2-ene, 5-cyclohexyloxycarbonylbicyclo[2.2.1]hept-2-ene, 5-phenoxycarbonylbicyclo[2.2.1]hept-2-ene, 5,6-bis(tert-butoxycarbonyl)bicyclo[2.2.1]hept-2-ene, and 5,6-bis(cyclohexyloxycarbonyl)bicyclo[2.2.1]hept-2-ene;
dicarbonylimide derivatives such as N-phenylmaleimide, N-cyclohexylmaleimide, N-benzylmaleimide, N-succinimidyl-3-maleimidobenzoate, N-succinimidyl-4-maleimidobutyrate, N-succinimidyl-6-maleimide caproate, N-succinimidyl-3-maleimide propionate, and N-(9-acridinyl)maleimide;
styrene, α-methylstyrene, m-methylstyrene, p-methylstyrene, vinyltoluene, p-methoxystyrene, acrylonitrile, methacrylonitrile, vinyl chloride, vinylidene chloride, acrylamide, methacrylamide, vinyl acetate, 1,3-butadiene, isoprene, and 2,3-dimethyl-1,3-butadiene.

Among these, from the viewpoint of copolymerization reactivity and heat resistance, styrene, vinyltoluene, N-phenylmaleimide, N-cyclohexylmaleimide, N-benzylmaleimide, bicyclo[2.2.1]hept-2-ene, 2-hydroxyethyl(meth)acrylate, and the like are preferable.

The ratio of the structural unit derived from each of (a) and (b) in the total structural units constituting the resin [K1] is preferably the following:
the structural unit derived from (a): 2 to 60 mol%; and
the structural unit derived from (b): 40 to 98 mol%,
and more preferably the following:
the structural unit derived from (a): 10 to 50 mol%; and
the structural unit derived from (b): 50 to 90 mol%.

When the ratio of the structural unit of the resin [K1] falls within the above-mentioned range, there is a tendency that the storage stability of the colored composition, the developability thereof during the formation of a colored pattern, and the solvent resistance of a color filter to be produced are excellent.

The resin [K1] can be produced with reference to the method described in, for example, a document "Experimental Method for Polymer Synthesis" (edited by Takayuki Otsu, published by Kagaku-Dojin Publishing Co., Ltd., First Edition, First Printed on Mar. 1, 1972) and cited documents described in the document.

Specific examples the producing method of the resin [K1] include the following method: predetermined amounts of (a) and (b), a polymerization initiator, a solvent, and the like are placed in a reaction vessel, a deoxidization atmosphere is formed by, for example, substituting oxygen with nitrogen, and these are heated and kept warm during stirring. The polymerization initiator, the solvent, and the like used here are not particularly limited, and those commonly used in the art can be used. Examples of the polymerization initiator include azo compounds such as 2,2'-azobisisobutyronitrile and 2,2'-azobis(2,4-dimethylvaleronitrile, and organic peroxides such as benzoyl peroxide. The solvent is required to dissolve each monomer, and examples thereof include solvents described later as the solvent (E).

The obtained copolymer may be used directly in the form of a solution after reaction. Alternatively, a solution obtained by concentrating or diluting the solution after reaction may be used, or a solid (powder) taken out from the solution after reaction by a method such as reprecipitation may be used. In particular, the solution after reaction can be used directly in the preparation of the colored composition by using a solvent contained in the colored composition as the solvent for the polymerization, whereby the producing process of the colored composition can be simplified.

The ratio of the structural unit derived from each of (a) to (c) in the total structural units constituting the resin [K2] is preferably the following:
the structural unit derived from (a): 2 to 45 mol%;
the structural unit derived from (b): 2 to 95 mol%; and
the structural unit derived from (c): 1 to 75 mol%,
and more preferably the following:
the structural unit derived from (a): 5 to 40 mol%;
the structural unit derived from (b): 5 to 80 mol%; and
the structural unit derived from (c): 5 to 70 mol%.

When the ratio of the structural unit of the resin [K2] falls within the above-mentioned range, there is a tendency that the storage stability of the colored composition, the developability thereof during the formation of a colored pattern, and the solvent resistance, heat resistance, and mechanical strength of a color filter to be produced are excellent.

The resin [K2] can be produced in a similar manner to the producing method of the resin [K1], for example.

The ratio of the structural unit derived from each of (a) and (c) in the total structural units constituting the resin [K3] is preferably the following:
the structural unit derived from (a): 2 to 60 mol%; and
the structural unit derived from (c): 40 to 98 mol%,
and more preferably the following:
the structural unit derived from (a): 10 to 50 mol%; and
the structural unit derived from (c): 50 to 90 mol%.

The resin [K3] can be produced in a similar manner to the producing method of the resin [K1], for example.

The resin [K4] can be produced by producing a copolymer of (a) and (c) and then adding a C₂-C₄ cyclic ether contained in (b) to a carboxylic acid and/or a carboxylic anhydride contained in (a).

First, the copolymer of (a) and (c) is produced in a similar manner to the producing method of the resin [K1]. In this case, the ratio of the structural unit derived from each of (a) and (c) is preferably the same ratio as that described in the resin [K3].

Next, the C₂-C₄ cyclic ether contained in (b) is reacted with a part of the carboxylic acid and/or the carboxylic anhydride derived from (a) in the copolymer.

Subsequent to the production of the copolymer of (a) and (c), atmosphere in the flask is replaced from a nitrogen to air, and (b), a reaction catalyst for reaction of a carboxylic acid or a carboxylic anhydride and a cyclic ether (for example, tris(dimethylaminomethyl)phenol), and a polymerization inhibitor (for example, hydroquinone) are placed in the flask, followed by reacting, for example, at 60 to 130°C for 1 to 10 hours, whereby the resin [K4] can be produced.

The amount of (b) used is preferably 5 to 80 mol, and more preferably 10 to 75 mol, relative to 100 mol of (a). When the amount of (b) used falls within the above-mentioned range, there is a tendency that the storage stability of the colored composition, the developability thereof during the formation of a pattern, and the balance of the solvent resistance, heat resistance, mechanical strength, and sensitivity of the pattern obtained are good. Since the reactivity of the cyclic ether is high, and the unreacted (b) is less likely to remain, (b) used for the resin [K4] is preferably (b1), and more preferably (b1-1).

The amount of the reaction catalyst used is preferably 0.001 to 5 parts by mass relative to 100 parts by mass of the total amount of (a), (b), and (c). The amount of the polymerization inhibitor used is preferably 0.001 to 5 parts by mass relative to 100 parts by mass of the total amount of (a), (b), and (c).

Reaction conditions such as a feeding method, a reaction temperature, and time can be appropriately adjusted in consideration of a production equipment, an amount of heat generation due to polymerization, and the like. In consideration of the production equipment, the amount of heat generation due to polymerization, and the like, the feeding method and the reaction temperature can be appropriately adjusted like the polymerization conditions.

A producing method of the resin [K5] contains a step of producing a copolymer of (b) and (c) in a similar manner to the producing method of the resin [K1] as a first step. In the same manner as in the above, the obtained copolymer may be used directly in the form of a solution after reaction. Alternatively, a solution obtained by concentrating or diluting the solution after reaction may be used, or a solid (powder) taken out from the solution after reaction by a method such as reprecipitation may be used. The ratio of the structural unit derived from each of (b) and (c) relative to the total number of moles of the total structural units constituting the copolymer is preferably the following:
the structural unit derived from (b): 5 to 95 mol%; and
the structural unit derived from (c): 5 to 95 mol%,
and more preferably the following:
the structural unit derived from (b): 10 to 90 mol%; and
the structural unit derived from (c): 10 to 90 mol%.

The producing method of the resin [K5] further contains a step of reacting a carboxylic acid or a carboxylic anhydride contained in (a) with the cyclic ether derived from (b) contained in the copolymer of (b) and (c) under the same conditions as those of the producing method of the resin [K4], whereby the resin [K5] can be produced.

The amount of (a) used that is reacted with the copolymer is preferably 5 to 80 mol relative to 100 mol of (b). Since the reactivity of the cyclic ether is high, and the unreacted (b) is less likely to remain, (b) used for the resin [K5] is preferably (b1), and more preferably (b1-1).

The resin [K6] is a resin produced by further reacting a carboxylic anhydride with the resin [K5]. The carboxylic anhydride is reacted with a hydroxy group generated by the reaction between the cyclic ether and the carboxylic acid or a carboxylic anhydride.

Examples of the carboxylic anhydride include maleic anhydride, citraconic anhydride, itaconic anhydride, 3-vinylphthalic anhydride, 4-vinylphthalic anhydride, 3,4,5,6-tetrahydrophthalic anhydride, 1,2,3,6-tetrahydrophthalic anhydride, dimethyltetrahydrophthalic anhydride, and 5,6-dicarboxybicyclo[2.2.1]hept-2-ene anhydride. The amount of the carboxylic anhydride used is preferably 0.5 to 1 mol relative to 1 mol of the amount of (a) used.

Specific examples of the resin (B) include a resin [K1] such as a 3,4-epoxycyclohexylmethyl(meth)acrylate/(meth)acrylic acid copolymer or a 3,4-epoxytricyclo[5.2.1.0^{2,6}]decyl acrylate/(meth)acrylic acid copolymer; a resin [K2] such as a glycidyl(meth)acrylate/benzyl(meth)acrylate/(meth)acrylic acid copolymer, a glycidyl(meth)acrylate/styrene/(meth)acrylic acid copolymer, a 3,4-epoxytricyclo[5.2.1.0^{2,6}]decyl acrylate/(meth)acrylic acid/N-cyclohexylmaleimide copolymer, a 3,4-epoxytricyclo[5.2.1.0^{2,6}]decyl acrylate/(meth)acrylic acid/N-cyclohexylmaleimide/2-hydroxyethyl(meth)acrylate copolymer, or a 3-methyl-3-(meth)acryloyloxymethyl oxetane/(meth)acrylic acid/styrene copolymer; a resin [K3] such as a benzyl(meth)acrylate/(meth)acrylic acid copolymer or a styrene/(meth)acrylic acid copolymer; a resin [K4] such as a resin produced by adding glycidyl(meth)acrylate to a benzyl(meth)acrylate/(meth)acrylic acid copolymer, a resin produced by adding glycidyl(meth)acrylate to a tricyclodecyl(meth)acrylate/styrene/(meth)acrylic acid copolymer, or a resin produced by adding glycidyl(meth)acrylate to a tricyclodecyl(meth)acrylate/benzyl(meth)acrylate/(meth)acrylic acid copolymer; a resin [K5] such as a resin produced by reacting a tricyclodecyl(meth)acrylate/glycidyl(meth)acrylate copolymer with (meth)acrylic acid, or a resin produced by reacting a tricyclodecyl(meth)acrylate/styrene/glycidyl(meth)acrylate copolymer with (meth)acrylic acid; and a resin [K6] such as a resin produced by reacting a tricyclodecyl(meth)acrylate/glycidyl(meth)acrylate copolymer with (meth)acrylic acid to produce a resin and then reacting this resin with a tetrahydrophthalic anhydride.

Among them, the resin (B) is preferably at least one selected from the group consisting of the resin [K1] and the resin [K2], and more preferably the resin [K2].

The weight average molecular weight of the resin (B) in terms of polystyrene is preferably 3,000 or more and 100,000 or less, more preferably 5,000 or more and 50,000 or less, and still more preferably 5,000 or more and 30,000 or less. When the molecular weight falls within the above-mentioned range, there is a tendency that the hardness of the color filter is improved, that the residual film ratio is increased, that the solubility of an unexposed area by a developing solution becomes good, and that the resolution of a colored pattern is improved.

The degree of dispersion [weight average molecular weight (Mw)/number average molecular weight (Mn)] of the resin (B) is preferably 1.1 or more and 6 or less, and more preferably 1.2 or more and 4 or less.

The acid value of the resin (B) is preferably 50 mg-KOH/g or more and 170 mg-KOH/g or less, more preferably 60 mg-KOH/g or more and 150 mg-KOH/g or less, and still more preferably 70 mg-KOH/g or more and 135 mg-KOH/g or less, in terms of solid content. The acid value is a value which is measured as an amount (mg) of potassium hydroxide required for neutralizing 1 g of the resin (B), and which can be determined by, for example, titration with an aqueous potassium hydroxide solution.

The content of the resin (B) is preferably 7% by mass or more and 85% by mass or less, more preferably 13% by mass or more and 80% by mass or less, and still more preferably 15% by mass or more and 70% by mass or less, relative to the whole amount of the solid content. When the content of the resin (B) falls within the above-mentioned range, there is a tendency that the colored pattern can be formed, and that the resolution of the colored pattern and the residual film ratio are improved.

### <Polymerizable Compound (C)>

The polymerizable compound (C) is a compound capable of being polymerized by the action of an active radical and/or an acid generated from the polymerization initiator (D). Examples of the polymerizable compound (C) include a compound having a polymerizable ethylenically unsaturated bond, and a (meth)acrylic acid ester compound is preferable.

Among these, the polymerizable compound (C) is preferably a polymerizable compound having three or more ethylenically unsaturated bonds. Examples of such a polymerizable compound include trimethylolpropane tri(meth)acrylate, pentaerythritol tri(meth)acrylate, pentaerythritol tetra(meth)acrylate, dipentaerythritol penta(meth)acrylate, dipentaerythritol hexa(meth)acrylate, tripentaerythritol octa(meth)acrylate, tripentaerythritol hepta(meth)acrylate, tetrapentaerythritol deca(meth)acrylate, tetrapentaerythritol nona(meth)acrylate, tris(2-(meth)acryloyloxyethyl)isocyanurate, ethylene glycol-modified pentaerythritol tetra(meth)acrylate, ethylene glycol-modified dipentaerythritol hexa(meth)acrylate, propylene glycol-modified pentaerythritol tetra(meth)acrylate, propylene glycol-modified dipentaerythritol hexa(meth)acrylate, caprolactone-modified pentaerythritol tetra(meth)acrylate, and caprolactone-modified dipentaerythritol hexa(meth)acrylate.

Among these, the polymerizable compound (C) is preferably at least one selected from the group consisting of dipentaerythritol penta(meth)acrylate and dipentaerythritol hexa(meth)acrylate.

The weight average molecular weight of the polymerizable compound (C) is preferably 150 or more and 2,900 or less, and more preferably 250 or more and 1,500 or less.

The content of the polymerizable compound (C) is preferably 5% by mass or more and 75% by mass or less, more preferably 7% by mass or more and 70% by mass or less, and still more preferably 15% by mass or more and 70% by mass or less, relative to the whole amount of the solid content. When the content of the polymerizable compound (C) falls within the above-mentioned range, there is a tendency that the residual film ratio during the formation of the colored pattern and the chemical resistance of the color filter are improved.

### <Polymerization Initiator (D)>

The polymerization initiator (D) is not particularly limited, as long as the polymerization initiator (D) is a compound capable of generating active radicals, an acid or the like by the action of light or heat to initiate polymerization. Any known polymerization initiator can be used.

Examples of the polymerization initiator capable of generating active radicals include an alkylphenone compound, a triazine compound, an acylphosphine oxide compound, an O-acyloxime compound, and a biimidazole compound.

The O-acyloxime compound is a compound having a partial structure represented by formula (d1). Hereinafter, * represents a point of attachment.

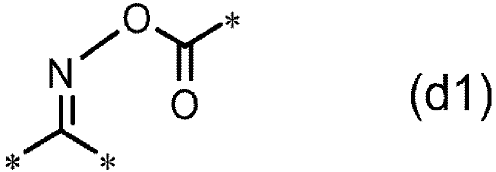

Examples of the O-acyloxime compound include N-benzoyloxy-1-(4-phenylsulfanylphenyl)butane-1-one-2-imine, N-benzoyloxy-1-(4-phenylsulfanylphenyl)octane-1-one-2-imine, N-benzoyloxy-1-(4-phenylsulfanylphenyl)-3-cyclopentylpropane-1-one-2-imine, N-acetoxy-1-[9-ethyl-6-(2-methylbenzoyl)-9H-carbazole-3-yl]ethane-1-imine, N-acetoxy-1-[9-ethyl-6-{2-methyl-4-(3,3-dimethyl-2,4-dioxacyclopentanylmethyloxy)benzoyl}-9H-carbazole-3-yl]ethane-1-imine, N-acetoxy-1-[9-ethyl-6-(2-methylbenzoyl)-9H-carbazole-3-yl]-3-cyclopentylpropane-1-imine, N-benzoyloxy-1- [9-ethyl-6-(2-methylbenzoyl)-9H-carbazole-3-yl]-3-cyclopentylpropane-1-one-2-imine, and N-acetyloxy-1-(4-phenylsulfanylphenyl)-3-cyclohexylpropane-1-one-2-imine. Commercially available products such as Irgacure OXE01 and OXE02 (all manufactured by BASF Corporation), N-1919 (manufactured by ADEKA Corporation), and PBG-327 (manufactured by Changzhou Tronly New Electronic Materials Co., Ltd.) may be used. Among these, the O-acyloxime compound is preferably at least one selected from the group consisting of N-benzoyloxy-1-(4-phenylsulfanylphenyl)butane-1-one-2-imine, N-benzoyloxy-1-(4-phenylsulfanylphenyl)octane-1-one-2-imine, N-acetyloxy-1-(4-phenylsulfanylphenyl)-3-cyclohexylpropane-1-one-2-imine, and N-benzoyloxy-1-(4-phenylsulfanylphenyl)-3-cyclopentylpropane-1-one-2-imine; and more preferably N-benzoyloxy-1-(4-phenylsulfanylphenyl)octane-1-one-2-imine and N-acetyloxy-1-(4-phenylsulfanylphenyl)-3-cyclohexylpropane-1-one-2-imine. There is a tendency that using above O-acyloxime compound make the color filter obtained have a high brightness.

The alkylphenone compound is preferably a compound having a partial structure represented by formula (d2) or (d3). In these partial structures, the benzene ring optionally has a substituent.

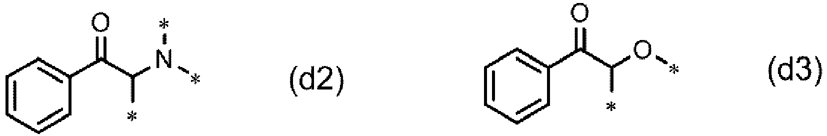

Examples of the compound having a partial structure represented by formula (d2) include 2-methyl-2-morpholino-1-(4-methylsulfanylphenyl)propane-1-one, 2-dimethylamino-1-(4-morpholinophenyl)-2-benzylbutane-1-one, and 2-(dimethylamino)-2-[(4-methylphenyl)methyl] -1- [4-(4-morpholinyl)phenyl]butane-1-one. Commercially available products such as Irgacures 369, 907, and 379 (all manufactured by BASF Corporation) may be used.

Examples of the compound having a partial structure represented by formula (d3) include 2-hydroxy-2-methyl-1-phenylpropane-1-one, 2-hydroxy-2-methyl-1-[4-(2-hydroxyethoxy)phenyl]propane-1-one, 1-hydroxycyclohexylphenylketone, an oligomer of 2-hydroxy-2-methyl-1-(4-isopropenylphenyl)propane-1-one, α,α-diethoxyacetophenone, and benzyl dimethyl ketal.

The alkylphenone compound is preferably the compound having a partial structure represented by formula (d2) from the viewpoint of sensitivity.

Examples of the triazine compound include 2,4-bis(trichloromethyl)-6-(4-methoxyphenyl)-1,3,5-triazine, 2,4-bis(trichloromethyl)-6-(4-methoxynaphthyl)-1,3,5-triazine, 2,4-bis(trichloromethyl)-6-piperonyl-1,3,5-triazine, 2,4-bis(trichloromethyl)-6-(4-methoxystyryl)-1,3,5-triazine, 2,4-bis(trichloromethyl)-6-[2-(5-methylfuran-2-yl)ethenyl]-1,3,5-triazine, 2,4-bis(trichloromethyl)-6-[2-(furan-2-yl)ethenyl]-1,3,5-triazine, 2,4-bis(trichloromethyl)-6-[2-(4-diethylamino-2-methylphenyl)ethenyl]-1,3,5-triazine, and 2,4-bis(trichloromethyl)-6-[2-(3,4-dimethoxyphenyl)ethenyl]-1,3,5-triazine.

Examples of the acylphosphine oxide compound include 2,4,6-trimethylbenzoyldiphenylphosphine oxide. Commercially available products such as Irgacure (registered trademark) 819 (manufactured by BASF Corporation) may be used.

Examples of the biimidazole compound include 2,2'-bis(2-chlorophenyl)-4,4',5,5'-tetraphenylbiimidazole, 2,2'-bis(2,3-dichlorophenyl)-4,4',5,5'-tetraphenylbiimidazole (for example, see Japanese Patent Laid-Open No. H6-75372 and Japanese Patent Laid-Open No. H6-75373), 2,2'-bis(2-chlorophenyl)-4,4',5,5'-tetraphenyl biimidazole, 2,2'-bis(2-chlorophenyl)-4,4',5,5'-tetra(alkoxyphenyl)biimidazole, 2,2'-bis(2-chlorophenyl)-4,4',5,5'-tetra(dialkoxyphenyl)biimidazole, 2,2'-bis(2-chlorophenyl)-4,4',5,5'-tetra(trialkoxyphenyl)biimidazole (for example, see Japanese Patent Publication No. S48-38403 and Japanese Patent Laid-Open No. S62-174204), and an imidazole compound in which a phenyl group at the 4,4'5,5' position is substituted with a carboalkoxy group (for example, see Japanese Patent Laid-Open No. H7-10913).

Furthermore, examples of the polymerization initiator (D) include benzoin compounds such as benzoin, benzoin methyl ether, benzoin ethyl ether, benzoin isopropyl ether, and benzoin isobutyl ether; benzophenone compounds such as benzophenone, methyl o-benzoylbenzoate, 4-phenylbenzophenone, 4-benzoyl-4'-methyldiphenyl sulfide, 3,3',4,4'-tetra(tert-butylperoxycarbonyl)benzophenone, and 2,4,6-trimethylbenzophenone; quinone compounds such as 9,10-phenanthrene quinone, 2-ethylanthraquinone, and camphorquinone; 10-butyl-2-chloroacridone, benzyl, methyl phenylglyoxylate, and a titanocene compound. These are preferably used in combination with a polymerization initiation aid (D1) (particularly, amines) to be described later.

Examples of a polymerization initiator that generates an acid include onium salts such as 4-hydroxyphenyldimethylsulfonium p-toluenesulfonate, 4-hydroxyphenyldimethylsulfoniumhexafluoroantimonate, 4-acetoxyphenyldimethylsulfonium p-toluenesulfonate, 4-acetoxyphenylmethylbenzylsulfoniumhexafluoroantimonate, triphenylsulfonium p-toluenesulfonate, triphenylsulfonium hexafluoroantimonate, diphenyliodonium p-toluenesulfonate, and diphenyliodoniumhexafluoroantimonate; nitrobenzyl tosylates; and benzoin tosylates.

The polymerization initiator (D) is preferably a polymerization initiator containing at least one selected from the group consisting of an alkylphenone compound, a triazine compound, an acylphosphine oxide compound, an O-acyloxime compound, and a biimidazole compound, and more preferably a polymerization initiator containing an O-acyloxime compound.

The content of the polymerization initiator (D) is preferably 0.1 parts by mass or more and 30 parts by mass or less, and more preferably 1 part by mass or more and 20 parts by mass or less, relative to 100 parts by mass of the total amount of the resin (B) and the polymerizable compound (C). When the content of the polymerization initiator (D) falls within the above-mentioned range, there is a tendency that the sensitivity is increased and the time of exposure to light is shortened, resulting in the improvement in productivity of the color filter.

### <Polymerization Initiation Aid (D1)>

The polymerization initiation aid (D1) is a compound to be used for accelerating polymerization of a polymerizable compound, the polymerization of which has been started by the polymerization initiator, or a sensitizer. When the polymerization initiation aid (D1) is contained, it is usually used in combination with the polymerization initiator (D).

Examples of the polymerization initiation aid (D1) include an amine compound, an alkoxyanthracene compound, a thioxanthone compound, and a carboxylic acid compound.

Examples of the amine compound include triethanolamine, methyldiethanolamine, triisopropanolamine, methyl 4-dimethylaminobenzoate, ethyl 4-dimethylaminobenzoate, isoamyl 4-dimethylaminobenzoate, 2-dimethylaminoethyl benzoate, 2-ethylhexyl 4-dimethylaminobenzoate, N,N-dimethylparatoluidine, 4,4'-bis(dimethylamino)benzophenone (common name: Michler's ketone), 4,4'-bis(diethylamino)benzophenone, and 4,4'-bis(ethylmethylamino)benzophenone. Among these, 4,4'-bis(diethylamino)benzophenone is preferable. Commercially available products such as EAB-F (manufactured by Hodogaya Chemical Co., Ltd.) may be used.

Examples of the alkoxyanthracene compound include 9,10-dimethoxyanthracene, 2-ethyl-9,10-dimethoxyanthracene, 9,10-diethoxyanthracene, 2-ethyl-9,10-diethoxyanthracene, 9,10-dibutoxyanthracene, and 2-ethyl-9,10-dibutoxyanthracene.

Examples of the thioxanthone compound include 2-isopropylthioxanthone, 4-isopropylthioxanthone, 2,4-diethylthioxanthone, 2,4-dichlorothioxanthone, and 1-chloro-4-propoxythioxanthone.

Examples of the carboxylic acid compound include phenylsulfanylacetic acid, methylphenylsulfanylacetic acid, ethylphenylsulfanylacetic acid, methylethylphenylsulfanylacetic acid, dimethylphenylsulfanylacetic acid, methoxyphenysulfanylacetic acid, dimethoxyphenylsulfanylacetic acid, chlorophenylsulfanylacetic acid, dichlorophenylsulfanylacetic acid, N-phenylglycine, phenoxyacetic acid, naphthylthioacetic acid, N-naphthylglycine, and naphthoxyacetic acid.

When the polymerization initiation aid (D1) is used, the content thereof is preferably 0.1 parts by mass or more and 30 parts by mass or less, and more preferably 1 part by mass or more and 20 parts by mass or less, relative to 100 parts by mass of the total amount of the resin (B) and the polymerizable compound (C). When the amount of the polymerization initiation aid (D1) falls within the above-mentioned range, there is a tendency that the colored pattern can be formed with higher sensitivity, resulting in the improvement in productivity of the color filter.

### <Solvent (E)>

The solvent (E) is not particularly limited, and any solvent that has been used conventionally in the art can be used. Examples of the solvent (E) include an ester solvent (a solvent that contains -COO- but does not contain -O- in its molecule), an ether solvent (a solvent that contains -O-but does not contain -COO- in its molecule), an ether ester solvent (a solvent that contains -COO- and -O- in its molecule), a ketone solvent (a solvent that contains -CO- but does not contain -COO- in its molecule), an alcohol solvent (a solvent that contains OH but does not contain -O-, -CO-nor -COO- in its molecule), an aromatic hydrocarbon solvent, an amide solvent, and dimethyl sulfoxide.

Examples of the ester solvent include methyl lactate, ethyl lactate, butyl lactate, methyl 2-hydroxy isobutanoate, ethyl acetate, n-butyl acetate, isobutyl acetate, pentyl formate, isopentyl acetate, butyl propionate, isopropyl butyrate, ethyl butyrate, butyl butyrate, methyl pyruvate, ethyl pyruvate, propyl pyruvate, methyl acetoacetate, ethyl acetoacetate, cyclohexanol acetate, and γ-butyrolactone.

Examples of the ether solvent include ethylene glycol monomethyl ether, ethylene glycol monoethyl ether, ethylene glycol monopropyl ether, ethylene glycol monobutyl ether, diethylene glycol monomethyl ether, diethylene glycol monoethyl ether, diethylene glycol monobutyl ether, propylene glycol monomethyl ether, propylene glycol monoethyl ether, propylene glycol monopropyl ether, propylene glycol monobutyl ether, 3-methoxy-1-butanol, 3-methoxy-3-methylbutanol, tetrahydrofuran, tetrahydropyran, 1,4-dioxane, diethylene glycol dimethyl ether, diethylene glycol diethyl ether, diethylene glycol methyl ethyl ether, diethylene glycol dipropyl ether, diethylene glycol dibutyl ether, anisole, phenetol, and methyl anisole.

Examples of the ether ester solvent include methyl methoxyacetate, ethyl methoxyacetate, butyl methoxyacetate, methyl ethoxyacetate, ethyl ethoxyacetate, methyl 3-methoxypropionate, ethyl 3-methoxypropionate, methyl 3-ethoxypropionate, ethyl 3-ethoxypropionate, methyl 2-methoxypropionate, ethyl 2-methoxypropionate, propyl 2-methoxypropionate, methyl 2-ethoxy propionate, ethyl 2-ethoxypropionate, methyl 2-methoxy-2-methylpropionate, ethyl 2-ethoxy-2-methylpropionate, 3-methoxybutyl acetate, 3-methyl-3-methoxybutyl acetate, propylene glycol monomethyl ether acetate, propylene glycol monoethyl ether acetate, propylene glycol monopropyl ether acetate, ethylene glycol monomethyl ether acetate, ethylene glycol monoethyl ether acetate, diethylene glycol monoethyl ether acetate, and diethylene glycol monobutyl ether acetate.

Examples of the ketone solvent include 4-hydroxy-4-methyl-2-pentanone (that is, diacetone alcohol), acetone, 2-butanone, 2-heptanone, 3-heptanone, 4-heptanone, 4-methyl-2-pentanone, cyclopentanone, cyclohexanone, and isophorone.

Examples of the alcohol solvent include methanol, ethanol, propanol, butanol, hexanol, cyclohexanol, ethylene glycol, propylene glycol, and glycerin.

Examples of the aromatic hydrocarbon solvent include benzene, toluene, xylene, and mesitylene.

Examples of the amide solvent include N,N-dimethylformamide, N,N-dimethylacetamide, and N-methylpyrrolidone.

Among the solvents, preferred is an organic solvent having a boiling point of 120°C or higher and 180°C or lower at 1 atm from the viewpoint of ease of application and drying. The solvent is preferably a solvent containing at least one selected from the group consisting of propylene glycol monomethyl ether acetate, ethyl lactate, propylene glycol monomethyl ether, ethyl 3-ethoxypropionate, ethylene glycol monomethyl ether, diethylene glycol monomethyl ether, diethylene glycol monoethyl ether, 4-hydroxy-4-methyl-2-pentanone, and N,N-dimethylformamide, and more preferably a solvent containing at least one selected from the group consisting of propylene glycol monomethyl ether acetate, propylene glycol monomethyl ether, ethyl lactate, ethyl 3-ethoxypropionate, and 4-hydroxy-4-methyl-2-pentanone.

The content of the solvent (E) is preferably 55% by mass or more and 95% by mass or less, and more preferably 60% by mass or more and 92% by mass or less, relative to the whole amount of the colored composition of the present invention. In other words, the content of the solid content of the colored composition is preferably 5% by mass or more and 45% by mass or less, and more preferably 8% by mass or more and 40% by mass or less. When the content of the solvent (E) falls within the above-mentioned range, there is a tendency that the flatness during application becomes good and the color density of the color filter formed becomes not insufficient, resulting in the achievement of good displaying properties.

### <Leveling Agent (F)>

Examples of the leveling agent (F) include a silicone-based surfactant, a fluorine-based surfactant, and a silicone-based surfactant having a fluorine atom. These may have a polymerizable group at its side chain.

Examples of the silicone-based surfactant include a surfactant having a siloxane bond in its molecule. Specific examples thereof include Toray Silicone DC3PA, Toray Silicone SH7PA, Toray Silicone DC11PA, Toray Silicone SH21PA, Toray Silicone SH28PA, Toray Silicone SH29PA, Toray Silicone SH30PA, and Toray Silicone SH8400 (trade name; manufactured by Toray Dow Corning Co., Ltd.); KP321, KP322, KP323, KP324, KP326, KP340, and KP341 (manufactured by Shin-Etsu Chemical Co., Ltd.); and TSF400, TSF401, TSF410, TSF4300, TSF4440, TSF4445, TSF4446, TSF4452, and TSF4460 (manufactured by Momentive Performance Materials Inc.).

Examples of the fluorine-based surfactant include a surfactant having a fluorocarbon chain in its molecule. Specific examples thereof include Fluorad (registered trademark) FC430 and Fluorad FC431 (manufactured by Sumitomo 3M, Ltd.); Megafac (registered trademark) F142D, Megafac F171, Megafac F172, Megafac F173, Megafac F177, Megafac F183, Megafac F554, Megafac R30, and Megafac RS-718-K (manufactured by DIC Corporation); Eftop (registered trademark) EF301, Eftop EF303, Eftop EF351, and Eftop EF352 (manufactured by Mitsubishi Materials Electronic Chemicals Co., Ltd.); Surflon (registered trademark) S381, Surflon S382, Surflon SC101, and Surflon SC105 (manufactured by AGC Inc.); and E5844 (manufactured by Daikin Fine Chemical Laboratory).

Examples of the silicone-based surfactant having a fluorine atom include a surfactant having a siloxane bond and a fluorocarbon chain in its molecule. Specific examples thereof include Megafac (registered trademark) R08, Megafac BL20, Megafac F475, Megafac F477, and Megafac F443 (manufactured by DIC Corporation).

The content of the leveling agent (F) is preferably 0.00001% by mass or more and 0.2% by mass or less, more preferably 0.00002% by mass or more and 0.1% by mass or less, and still more preferably 0.0001% by mass or more and 0.05% by mass or less, relative to the whole amount of the colored composition. This content does not include the content of the pigment dispersant. When the content of the leveling agent (F) falls within the above-mentioned range, the flatness of the color filter can be improved.

### <Other Components>

If required, the colored composition may contain an additive known in the art, such as a filler, other polymeric compounds, an adhesion promoter, an antioxidant, a light stabilizer, or a chain transfer agent.

### <Method for Producing Colored Composition>

The colored composition can be prepared by, for example, mixing a colorant (A) and a resin (B), as well as a polymerizable compound (C), a polymerization initiator (D), a solvent (E), a leveling agent (F), and other components to be used if necessary. The mixing can be performed using a known or commonly used device under known or commonly used conditions.

The colorant (A) may be mixed with a part or the whole of the solvent (E) in advance and dispersed using a bead mill or the like until the average particle size reaches about 0.2 µm or less. In this operation, a part or the whole of the dispersant and the resin (B) may also be blended therewith, if necessary. The dispersion liquid thus obtained is preferably mixed with the remaining components such that predetermined concentrations are attained to prepare a desired colored composition. When using a bead mill, beads preferably have a diameter of 0.05 mm or more and 0.5 mm or less and may be made of glass, ceramic, metal, or the like.

### < Method for Producing Color Filter>

Examples of the method for producing a colored pattern of a color filter from the colored composition of the present invention include a photolithography method, an inkjet method, and a printing method. Among these methods, a photolithography method is preferable. The photolithography method is a method in which the colored composition is applied onto a substrate and then dried to form a composition layer, and the composition layer is then developed by exposing the composition layer to light through a photomask. In the photolithography method, a colored coating film, which is a cured material of the composition layer, can be formed when the photomask is not used during the exposure to light and/or the composition layer is not developed.

The film thickness of the color filter (cured film) is not particularly limited, and may be selected appropriately depending on the purpose and application. The film thickness thereof is, for example, 0.1 µm or more and 30 µm or less, preferably 0.1 µm or more and 20 µm or less, more preferably 0.5 µm or more and 6 µm or less.

Examples of the substrate to be used include glass substrates such as quartz glass, borosilicate glass, alumina silicate glass, and soda lime glass of which the surface is coated with silica; resin substrates such as polycarbonate, polymethyl methacrylate, and polyethylene terephthalate; silicon; and a substrate obtained by forming thin film of an aluminum, silver, or a silver/copper/palladium alloy or the like on any of the aforementioned substrates. On such a substrate, another color filter layer, a resin layer, a transistor, a circuit, and the like may be formed. A substrate obtained by subjecting a silicon substrate to HMDS treatment may also be used.

The formation of each color pixel by a photolithography method can be carried out using a known or conventional device under known or conventional conditions. For example, the color pixel can be prepared in the following manner. First, a colored composition is applied onto a substrate, and then dried by heat-drying (prebaking) and/or drying under reduced pressure to remove volatile components such as a solvent from the composition, thereby producing a smooth composition layer. Examples of the application method include a spin coat method, a slit coat method, and a slit-and-spin coat method. The temperature at heat-drying is preferably 30°C or higher and 120°C or lower, and more preferably 50°C or higher and 110°C or lower. The time for the heating is preferably 10 seconds or more and 60 minutes or less, and more preferably 30 seconds or more and 30 minutes or less. When drying under reduced pressure is carried out, the drying procedure is preferably carried out at a temperature range of 20 to 25°C under a pressure of 50 to 150 Pa. The film thickness of the composition layer is not particularly limited, and may be selected appropriately depending on the desired film thickness of the color filter.

Next, the composition layer is exposed to light through a photomask for forming a desired colored pattern. The pattern on the photomask is not particularly limited, and a pattern suitable for the intended application is used. A light source to be used for the exposure to light is preferably a light source capable of generating light having a wavelength of 250 to 450 nm. For example, light having a wavelength of shorter than 350 nm may be cut with a filter capable of cutting light having this wavelength region, or light having a wavelength of around 436 nm, around 408 nm, or around 365 nm may be extracted selectively with a band-pass filter capable of extracting light having those wavelength regions. Specific examples of the light source include a mercury lamp, a light-emitting diode, a metal halide lamp, and a halogen lamp. A reduction projection exposure apparatus such as a mask aligner and a stepper, or a proximity exposure apparatus is preferably used because these apparatuses are capable of emitting a parallel light beam uniformly over the whole area of the exposed surface or accurately aligning the photomask to the substrate.

A colored pattern is formed on the substrate by bringing the exposed composition layer into contact with a developing solution to develop the composition layer. By developing, an unexposed area in the composition layer is dissolved in the developing solution and therefore removed. The developing solution is preferably an aqueous solution of an alkaline compound such as potassium hydroxide, sodium hydrogen carbonate, sodium carbonate, or tetramethylammonium hydroxide. The concentration of the alkaline compound in the aqueous solution is preferably 0.01% by mass or more and 10% by mass or less, and more preferably 0.03% by mass or more and 5% by mass or less. The developing solution may further contain a surfactant. The developing method may be any of a paddle method, a dipping method, a spray method, and the like. Furthermore, during the developing process, the substrate may be inclined at any angle.

After the developing process, the resultant product is preferably washed with water.

Furthermore, the resultant colored pattern is preferably subjected to post-baking. The temperature for the post-baking is preferably 80°C or higher and 250°C or lower, and more preferably 100°C or higher and 245°C or lower. The time for the post-baking is preferably 1 minute or more and 120 minutes or less, and more preferably 2 minutes or more and 30 minutes or less.

The colored pattern and the colored coating film thus produced are useful as a color filter. The color filter is useful as a color filter used for a display device such as a liquid crystal display device or an organic EL device; an electronic paper; a solid-state image sensor; and the like.

This application claims benefit of priority based on Japanese Patent No. 2020-162452 filed on September 28, 2020. The entire content of the specification of Japanese Patent No. 2020-162452 filed on September 28, 2020 is incorporated herein by reference.

### EXAMPLES

Hereinafter, the present invention will be described in more detail with reference to Examples. However, the present invention is not limited to the following Examples. In Examples and Comparative Examples, the terms "%" and "parts" that represent a content or an amount used are based on mass unless otherwise specified.

In the following examples, the structures of compounds were identified by mass spectrometry (LC: Model 1200 manufactured by Agilent Technologies, Inc., MASS: LC/MSD Model 6130 manufactured by Agilent Technologies, Inc.).

### [Colorant Synthesis Example]

### Synthesis Example 1

### <Synthesis of Colorant (A-1)>

To 5.0 parts of 2,5-dichloro-4-nitroaniline were added 4.0 parts of water, 10 parts of acetic acid, 10 parts of methanol, and 25 parts of 98% sulfuric acid, followed by stirring. Under ice cooling, to the resulting reaction solution was added an aqueous solution prepared by dissolving 2.0 parts of sodium nitrite in 3.0 parts of water, followed by stirring for 2 hours, to obtain a suspension containing a diazonium salt. To 3.0 parts of barbituric acid (α) was added 15 parts of methanol, separately from above. Then, 100 parts of a 25% sodium hydroxide aqueous solution was added thereto under ice cooling, followed by stirring. To the resultant was added dropwise the suspension containing a diazonium salt. After completion of the dropwise addition, the resulting mixture was further stirred at room temperature for one hour to obtain an orange suspension. Orange solids obtained by filtering the suspension were dried at 60°C under reduced pressure to produce a compound represented by formula (1).

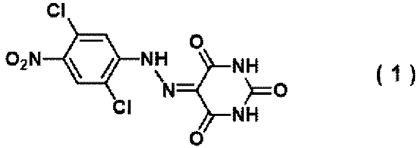

Subsequently, to 8.4 parts of the compound represented by formula (1) were added 97 parts of water, 4.1 parts of sodium hydrogen carbonate, and 3.8 parts of sodium sulfide nonahydrate, followed by stirring at 85°C for 2 hours. The resulting reaction solution was cooled to room temperature and then neutralized to pH 6 with 35% hydrochloric acid, and precipitated solids were collected by filtration. The obtained solids were washed with water, and red solids obtained by filtration were dried at 60°C under reduced pressure to produce 6.3 parts of a compound represented by formula (2).

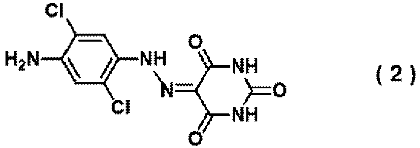

Then, to 2.1 parts of the compound represented by formula (2) were added 20 parts of water, 6.7 parts of acetic acid, and 3.3 parts of 98% sulfuric acid, followed by stirring. Under ice cooling, to the resulting reaction solution was added an aqueous solution prepared by dissolving 0.6 parts of sodium nitrite in 3.3 parts of water, followed by stirring for 2 hours, to obtain a suspension containing a diazonium salt. To 0.8 parts of barbituric acid (β) was added 0.8 parts of methanol, separately from above. Then, 15 parts of a 25% sodium hydroxide aqueous solution was added thereto under ice cooling, followed by stirring. To the resultant was added dropwise the suspension containing a diazonium salt. After completion of the dropwise addition, the resulting mixture was further stirred at room temperature for one hour to obtain a red suspension. Red solids obtained by filtering the suspension were dispersed and washed with acetic acid for 30 minutes, then collected by filtration, and dried at 60°C under reduced pressure to produce 1.7 parts of a compound represented by formula (A-1) (yield 57%).
MS(ESI) m/z = 453.0 [M-H]⁻

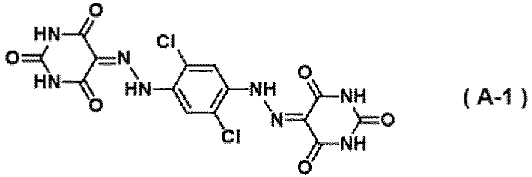

### Synthesis Example 2

### <Synthesis of Colorant (A-2)>

0.4 parts of a compound represented by formula (A-2) was produced (yield 15%) in the same manner as in Synthesis Example 1, except that 5.1 parts of 1,3-dicyclohexylbarbituric acid (α) was used instead of 3.0 parts of barbituric acid (α), and that 0.7 parts of 1,3-dicyclohexylbarbituric acid (β) was used instead of 0.8 parts of barbituric acid (β).
MS(ESI) m/z = 783.4 [M+H]⁺

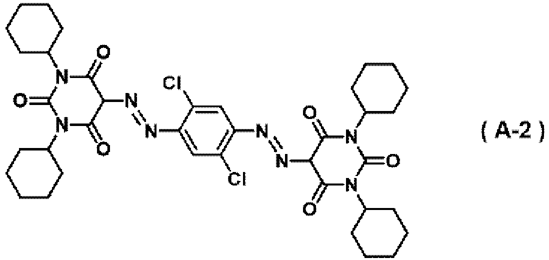

### Synthesis Example 3

### <Synthesis of Colorant (A-3)>

3.9 parts of a compound represented by formula (A-3) was produced (yield 66%) in the same manner as in Synthesis Example 1, except that 1.8 parts of 3-cyano-1-butyl-6-hydroxy-4-methyl-2-pyridone (α) was used instead of 3.0 parts of barbituric acid (α), and that 1.4 parts of 3-cyano-1-butyl-6-hydroxy-4-methyl-2-pyridone (B) was used instead of 0.8 parts of barbituric acid (B).
MS(ESI) m/z = 609.2 [M-H]⁻

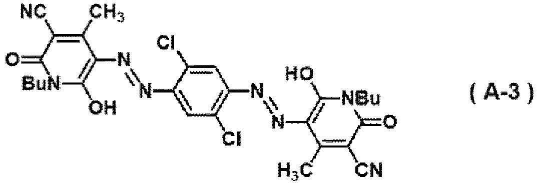

### Synthesis Example 4

### <Synthesis of Colorant (A-4)>

0.8 parts of a compound represented by formula (A-4) was produced (yield 53%) in the same manner as in Synthesis Example 1, except that 4.2 parts of 3-methyl-1-phenyl-5-pyrazolone (α) was used instead of 3.0 parts of barbituric acid (α), and that 0.5 parts of 3-methyl-1-phenyl-5-pyrazolone (B) was used instead of 0.8 parts of barbituric acid (B).
MS(ESI) m/z = 547.2 [M+H]⁺

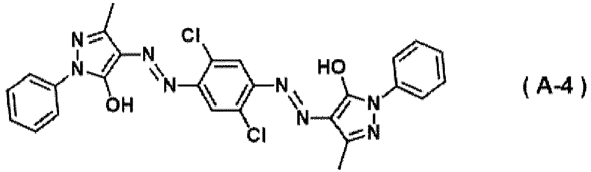

### Synthesis Example 5

### <Synthesis of Colorant (A-5)>

1.2 parts of a compound represented by formula (A-5) was produced (yield 58%) in the same manner as in Synthesis Example 1, except that 4.9 parts of 3-methyl-1-(4-sulfophenyl)-2-pyrazolin-5-one (α) was used instead of 3.0 parts of barbituric acid (α), and that 0.7 parts of 3-methyl-1-(4-sulfophenyl)-2-pyrazolin-5-one (6) was used instead of 0.8 parts of barbituric acid (β).
MS(ESI) m/z = 705.0 [M-H]⁻

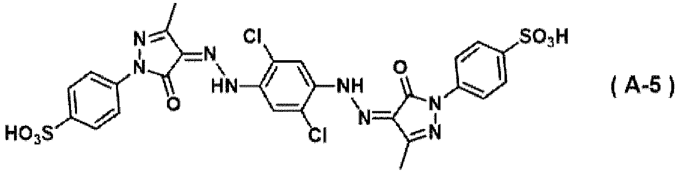

### Synthesis Example 6

### <Synthesis of Colorant (A-6)>

1.9 parts of a compound represented by formula (A-6) was produced (yield 56%) in the same manner as in Synthesis Example 1, except that 1.2 parts of 3-cyano-1-butyl-6-hydroxy-4-methyl-2-pyridone was used instead of 0.8 parts of barbituric acid (B).
MS(ESI) m/z = 533.0 [M+H]⁺

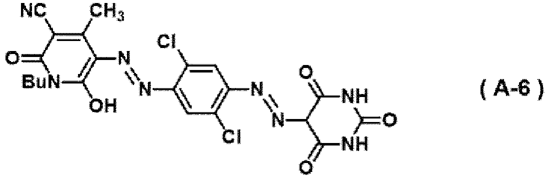

### Synthesis Example 7

### <Synthesis of Colorant (A-7)>

1.5 parts of a compound represented by formula (A-7) was produced (yield 54%) in the same manner as in Synthesis Example 1, except that 1.0 part of 3-methyl-1-phenyl-5-pyrazolone was used instead of 0.8 parts of barbituric acid (6).
MS(ESI) m/z = 499.1 [M-H]⁻

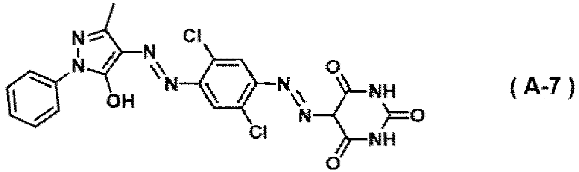

### Synthesis Example 8

### <Synthesis of Colorant (A-8)>

1.2 parts of a compound represented by formula (A-8) was produced (yield 37%) in the same manner as in Synthesis Example 1, except that 0.5 parts of 3-methyl-1-(4-sulfophenyl)-2-pyrazolin-5-one was used instead of 0.8 parts of barbituric acid (B).
MS(ESI) m/z = 579.0 [M-H]⁻

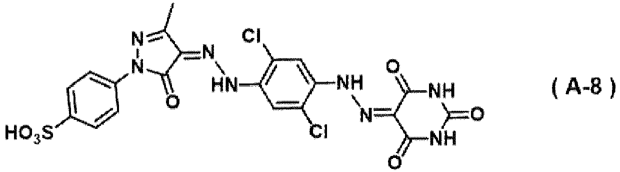

### Synthesis Example 9

### <Synthesis of Colorant (A-9)>

0.3 parts of a compound represented by formula (A-9) was produced (yield 31%) in the same manner as in Synthesis Example 2, except that 0.2 parts of 3-methyl-1-phenyl-5-pyrazolone was used instead of 0.7 parts of 1,3-dicyclohexylbarbituric acid (β).
MS(ESI) m/z = 664.0 [M]⁻

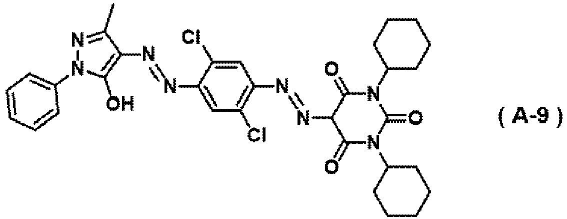

### Synthesis Example 10

### <Synthesis of Colorant (A-10)>

35 parts of a compound represented by formula (A-10) was produced (yield 73%) in the same manner as in Synthesis Example 4, except that 18 parts of 3-methyl-1-(4-sulfophenyl)-2-pyrazolin-5-one was used instead of 4.2 parts of 3-methyl-1-phenyl-5-pyrazolone (α).
MS(ESI) m/z = 625.1 [M-H]⁻

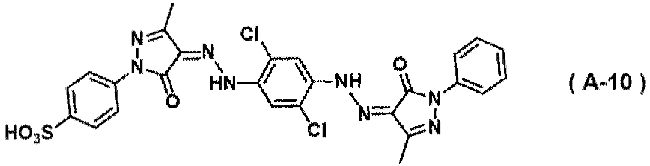

### Synthesis Example 11

### <Synthesis of Colorant (A-11)>

To 1.5 parts of the compound represented by formula (A-10) were added 15 parts of chloroform and 0.4 parts of N,N-dimethylformamide. To the resulting mixture was added dropwise 0.6 part of thionyl chloride with stirring while the temperature was kept at 20°C or lower. After completion of the dropwise addition, the resultant was heated to 50°C, reacted at the same temperature for 3 hours, and then cooled to 20°C. While the temperature of the reaction solution after cooling was kept at 20°C or lower with stirring, to the reaction solution was added dropwise a mixture of 0.5 parts of 2-methylcyclohexylamine and 1.9 parts of triethylamine. After that, the resulting mixture was reacted at the same temperature for 5 hours. Then, after distilling off the solvent from the resulting reaction mixture using a rotary evaporator, a small amount of methanol was added thereto, followed by vigorous stirring. The mixture thus obtained was added to 45 parts of a 20% sodium chloride aqueous solution with stirring to precipitate crystal. The precipitated crystal was separated by filtration, washed with water, and dried at 60°C under reduced pressure to produce 1.2 parts of a compound represented by formula (A-11) (yield 74%).
MS(ESI) m/z = 720.2 [M-H]⁻

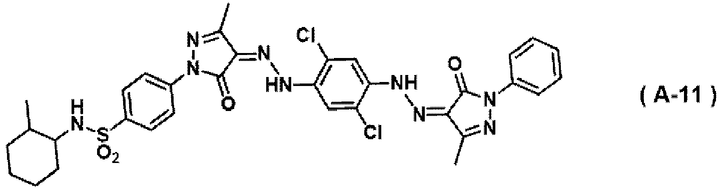

### Synthesis Example 12

### <Synthesis of Colorant (A-12)>

0.8 parts of a compound represented by formula (A-12) was produced (yield 58%) in the same manner as in Synthesis Example 11, except that 2.1 parts of 3,5-di-tert-butylaniline was used instead of 0.5 parts of 2-methylcyclohexylamine.
MS(ESI) m/z = 813.2 [M]⁻

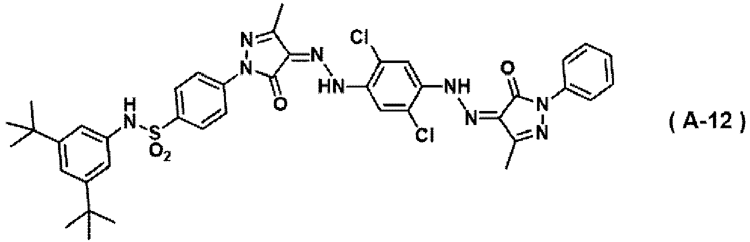

### Synthesis Example 13

### <Synthesis of Colorant (A-13)>

1.2 parts of a compound represented by formula (A-13) was produced (yield 74%) in the same manner as in Synthesis Example 11, except that 1.3 parts of aniline was used instead of 0.5 parts of 2-methylcyclohexylamine. MS(ESI) m/z = 701.1 [M]⁻

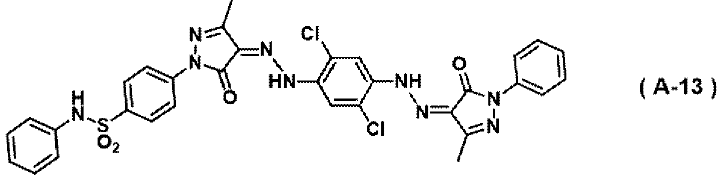

### Synthesis Example 14

### <Synthesis of Colorant (A-14)>

0.9 parts of a compound represented by formula (A-14) was produced (yield 59%) in the same manner as in Synthesis Example 11, except that 1.8 parts of 1-adamantanamine was used instead of 0.5 parts of 2-methylcyclohexylamine.
MS(ESI) m/z = 759.2 [M]⁻

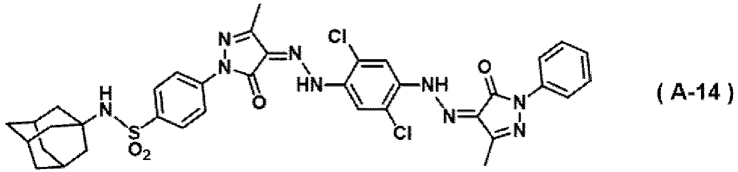

### Synthesis Example 15

### <Synthesis of Colorant (A-15)>

0.9 parts of a compound represented by formula (A-15) was produced (yield 62%) in the same manner as in Synthesis Example 11, except that 1.2 parts of 1,3-dimethylbutylamine was used instead of 0.5 parts of 2-methylcyclohexylamine.
MS(ESI) m/z = 709.2 [M]⁻

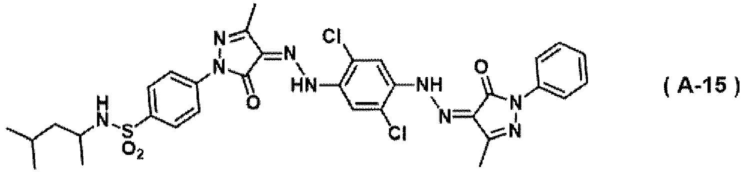

### Synthesis Example 16

### <Synthesis of Colorant (A-16)>

To 0.5 parts of the compound represented by formula (A-10) were added 60 parts of water and 60 parts of N,N-dimethylformamide, and to this mixture was added 1.2 parts of barium acetate with stirring. The resulting mixture was heated to 60°C, reacted at the same temperature for 2 hours, and then cooled to 20°C. The reaction solution after cooling was filtered, the collected solids were washed with methanol and then dried at 60°C under reduced pressure, to produce 0.4 parts of a compound represented by formula (A-16) (yield 76%).

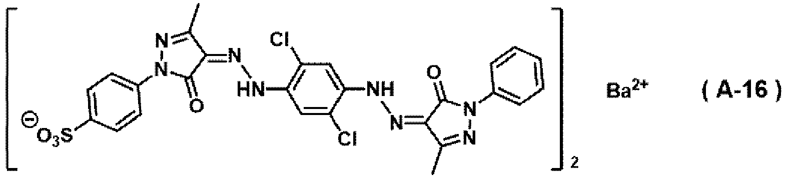

### Synthesis Example 17

### <Synthesis of Colorant (A-17)>

0.4 parts of a compound represented by formula (A-17) was produced (yield 28%) in the same manner as in Synthesis Example 11, except that 1.2 parts of the compound represented by formula (A-5) was used instead of 1.5 parts of the compound represented by formula (A-10), that the amount of N,N-dimethylformamide was replaced from 0.4 parts to 0.3 parts, the amount of thionyl chloride was replaced from 0.6 parts to 9.4 parts, that the amount of 2-methylcyclohexylamine was replaced from 0.5 parts to 2.3 parts, and that the amount of triethylamine was replaced from 1.9 parts to 5.3 parts.
MS(ESI) m/z = 895.2 [M-H]⁻

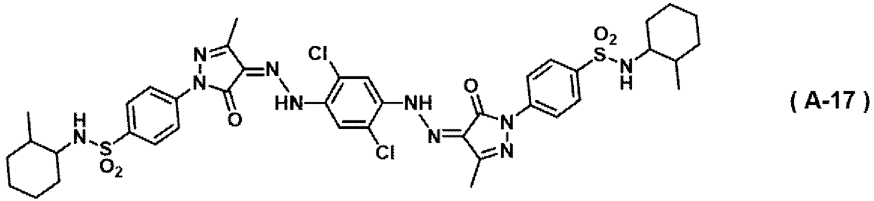

### Synthesis Example 18

### <Synthesis of Colorant (A-18)>

3.2 parts of a compound represented by formula (A-18) was produced (yield 65%) in the same manner as in Synthesis Example 7, except that 3.0 parts of 2-methyl-4-nitroaniline was used instead of 5.0 parts of 2,5-dichloro-4-nitroaniline.
MS(ESI) m/z = 445.2 [M-H]⁻

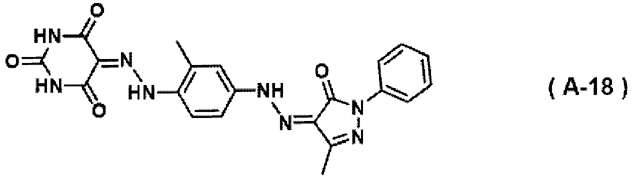

### Synthesis Example 19

### <Synthesis of Colorant (A-19)>

4.0 parts of a compound represented by formula (A-19) was produced (yield 90%) in the same manner as in Synthesis Example 10, except that 6.0 parts of 2-methyl-4-nitroaniline was used instead of 5.0 parts of 2,5-dichloro-4-nitroaniline.
MS(ESI) m/z = 571.2 [M-H]⁻

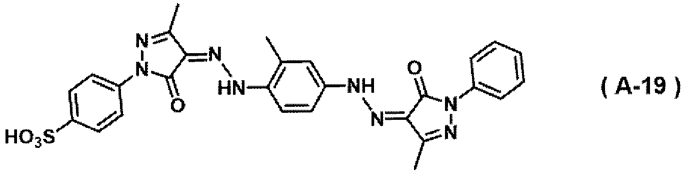

### Synthesis Example 20

### <Synthesis of Colorant (A-20)>

0.3 parts of a compound represented by formula (A-20) was produced (yield 20%) in the same manner as in Synthesis Example 11, except that 1.5 parts of the compound represented by formula (A-19) was used instead of 1.5 parts of the compound represented by formula (A-10).
MS(ESI) m/z = 666.3 [M-H]⁻

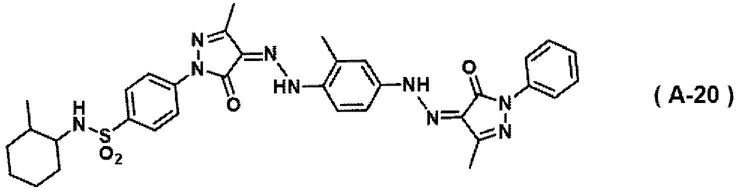

### Synthesis Example 21

### <Synthesis of Colorant (A-21)>

1.3 parts of a compound represented by formula (A-21) was produced (yield 40%) in the same manner as in Synthesis Example 4, except that 3.0 parts of 2-chloro-4-nitroaniline was used instead of 5.0 parts of 2,5-dichloro-4-nitroaniline.
MS(ESI) m/z = 513.3 [M+H]⁺

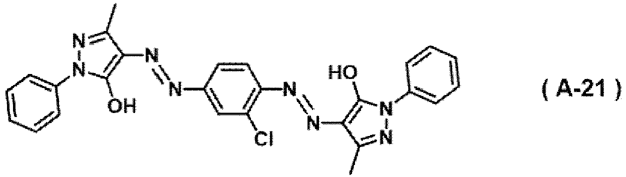

### Synthesis Example 22

### <Synthesis of Colorant (A-22)>

0.3 parts of a compound represented by formula (A-22) was produced (yield 21%) in the same manner as in Synthesis Example 4, except that 3 parts of 2,6-dichloro-4-nitroaniline was used instead of 5.0 parts of 2,5-dichloro-4-nitroaniline.
MS(ESI) m/z = 545.3 [M-H]⁻

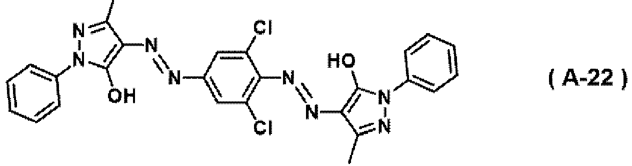

### Synthesis Example 23

### <Synthesis of Colorant (A-23)>

2.4 parts of a compound represented by formula (A-23) was produced (yield 73%) in the same manner as in Synthesis Example 4, except that 2.0 parts of 4-nitroaniline was used instead of 5.0 parts of 2,5-dichloro-4-nitroaniline.
MS(ESI) m/z = 479.5 [M+H]⁺

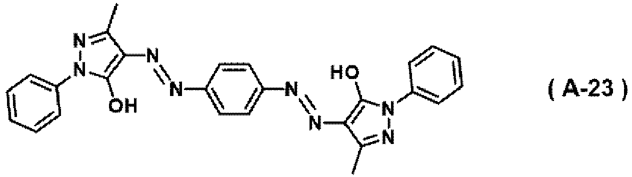

### Synthesis Example 24

### <Synthesis of Colorant (A-24)>

0.3 parts of a compound represented by formula (A-24) was produced (yield 15%) in the same manner as in Synthesis Example 4, except that 1.0 part of 2,5-dimethoxy-4-nitroaniline was used instead of 5.0 parts of 2,5-dichloro-4-nitroaniline.
MS(ESI) m/z = 537.2 [M-H]⁻

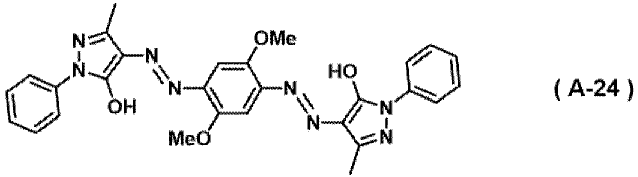

### <Synthesis of Colorant (I-1)>

A compound represented by formula (a) was produced according to the method described in Japanese Patent Laid-Open No. 2002-179979.

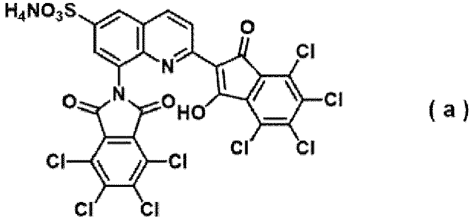

### <Synthesis of Colorant (x1)>

A compound represented by formula (x1) was produced according to the method described in Japanese Patent Laid-Open No. 2015-61907.

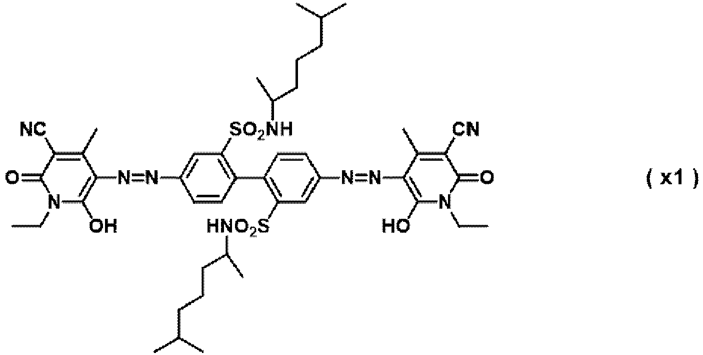

### [Resin Synthesis Example]

### <Resin Synthesis Example 1>

A proper amount of nitrogen was passed into a flask equipped with a reflux condenser, a dropping funnel, and a stirrer to replace the atmosphere with nitrogen. Then, 141 parts of ethyl lactate and 178 parts of propylene glycol monomethyl ether acetate were added into the flask, and then heated to 85°C while stirring. Subsequently, a mixed solution containing 38 parts of acrylic acid, 25 parts of a mixture of 3,4-epoxytricyclo[5.2.1.0^{2,6}]decan-8-ylacrylate and 3,4-epoxytricyclo[5.2.1.0^{2,6}]decan-9-ylacrylate (the content ratio was 1:1), 137 parts of cyclohexylmaleimide, 50 parts of 2-hydroxyethyl methacrylate, and 338 parts of propylene glycol monomethyl ether acetate was added dropwise into the flask over 5 hours. Meanwhile, a solution prepared by dissolving 5 parts of 2,2-azobisisobutyronitrile in 88 parts of propylene glycol monomethyl ether acetate was added dropwise over 6 hours. After the completion of the dropwise addition, the solution was retained at the same temperature for 4 hours, and then cooled to room temperature to obtain a copolymer (resin B-1) solution having a solid content of 25.6%. The produced copolymer had a weight average molecular weight (Mw) of 8000, a degree of dispersion of 2.1, and an acid value of 111 mg-KOH/g in terms of solid content. The resin B-1 has the following structural units.

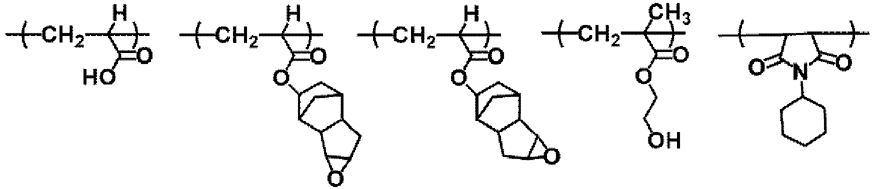

### <Resin Synthesis Example 2>

A proper amount of nitrogen was passed into a flask equipped with a reflux condenser, a dropping funnel, and a stirrer to replace the atmosphere with nitrogen. Then, 280 parts of propylene glycol monomethyl ether acetate was added into the flask, and then heated to 80°C while stirring. Subsequently, a mixed solution containing 38 parts of acrylic acid, 289 parts of a mixture of 3,4-epoxytricyclo[5.2.1.0^{2,6}]decan-8-ylacrylate and 3,4-epoxytricyclo[5.2.1.0^{2,6}]decan-9-ylacrylate (the content ratio was 1:1 by mole), and 125 parts of propylene glycol monomethyl ether acetate was added dropwise into the flask over 5 hours. Meanwhile, a solution prepared by dissolving 33 parts of 2,2-azobis(2,4-dimethylvaleronitrile) in 235 parts of propylene glycol monomethyl ether acetate was added dropwise over 6 hours. After the completion of the dropwise addition, the solution was retained at 80°C for 4 hours, and then cooled to room temperature to obtain a copolymer (resin B-2) solution having a solid content of 35.1% and a viscosity of 125 mPas as measured at 23°C with a Type-B viscometer. The produced copolymer had a weight average molecular weight (Mw) of 9.2 × 10³, a degree of dispersion of 2.08, and an acid value of 77 mg-KOH/g in terms of solid content. The resin B-2 has the following structural units.

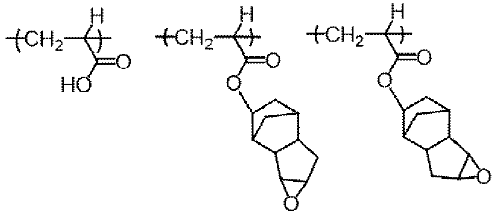

The weight average molecular weight (Mw) and the number average molecular weight (Mn) of the resin in terms of polystyrene were measured using the GPC method under the following conditions.
Device; HLC-8120GPC (manufactured by Tosoh Corporation)
Column; TSK-GELG2000HXL
Column temperature; 40°C
Solvent; THF
Flow rate; 1.0 mL/min
Solid content concentration of sample solution; 0.001 to 0.01% by mass
Injected amount; 50 µL
Detector; RI
Reference substance for correction; TSK STANDARD POLYSTYRENE F-40, F-4, F-288, A-2500, A-500 (manufactured by Tosoh Corporation)
The ratio (Mw/Mn) of the weight average molecular weight to the number average molecular weight in terms of polystyrene as determined above was defined as a degree of dispersion.

### <Dispersion Preparation Example 1>

4.5 parts of the compound represented by formula (A-1) produced in Synthesis Example 1, 0.5 parts of the compound represented by formula (a), 5.7 parts of a dispersant (BYKLPN-6919 manufactured by BYK) (in terms of solid content), 9.9 parts of the resin B-2 (in terms of solid content), 74.3 parts of propylene glycol monomethyl ether acetate, and 5.0 parts of diacetone alcohol were mixed, 300 parts of 0.2 mm zirconia beads were added thereto, and this mixture was shaken. Subsequently, the zirconia beads were removed by filtration to prepare a dispersion (P-1).

### <Dispersion Preparation Examples 2 to 9>

Dispersions (P-2) to (P-9) were prepared in the same manner as in Dispersion Preparation Example 1, except that the compound represented by formula (A-1) was replaced with the following compounds.
Dispersion (P-2): the compound represented by formula (A-3) produced in Synthesis Example 3
Dispersion (P-3): the compound represented by formula (A-4) produced in Synthesis Example 4
Dispersion (P-4): the compound represented by formula (A-6) produced in Synthesis Example 6
Dispersion (P-5): the compound represented by formula (A-7) produced in Synthesis Example 7
Dispersion (P-6): the compound represented by formula (A-11) produced in Synthesis Example 11
Dispersion (P-7): the compound represented by formula (A-18) produced in Synthesis Example 18
Dispersion (P-8): the compound represented by formula (A-21) produced in Synthesis Example 21
Dispersion (P-9): the compound represented by formula (A-23) produced in Synthesis Example 23

### [Examples 1 to 9, Comparative Example 1]

### [Preparation of Colored Composition]

The dispersion (P), colorant (x1), resin (B), polymerizable compound (C), polymerization initiator (D), solvent (E), and leveling agent (F) were mixed such that the composition shown in Table 8 was attained to prepare a colored composition.

**[Table 8]**

| **Unit: part(s)** | | **Example 1** | **Example 2** | **Example 3** | **Example 4** | **Example 5** | **Example 6** | **Example 7** | **Example 8** | **Example 9** | **Comparative Example 1** |
|---|---|---|---|---|---|---|---|---|---|---|---|
| **Dispersion (P)** | **(P-1)** | **253** | | | | | | | | | |
| | **(P-2)** | | **253** | | | | | | | | |
| | **(P-3)** | | | **253** | | | | | | | |
| | **(P-4)** | | | | **253** | | | | | | |
| | **(P-5)** | | | | | **253** | | | | | |
| | **(P-6)** | | | | | | **253** | | | | |
| | **(P-7)** | | | | | | | **253** | | | |
| | **(P-8)** | | | | | | | | **253** | | |
| | **(P-9)** | | | | | | | | | **253** | |
| **Colorant (x1)** | | | | | | | | | | | **12** |
| **Resin (B)** | **(B-1)** | **51** | **51** | **51** | **51** | **51** | **51** | **51** | **51** | **51** | **60** |
| **Polymerizable compound (C)** | **(C-1)** | **40** | **40** | **40** | **40** | **40** | **40** | **40** | **40** | **40** | **40** |
| **Polymerization Initiator (D)** | **(D-1)** | **5.0** | **5.0** | **5.0** | **5.0** | **5.0** | **5.0** | **5.0** | **5.0** | **5.0** | **5.0** |
| **Solvent (E)** | **(E-1)** | **495** | **495** | **495** | **495** | **495** | **495** | **495** | **495** | **495** | **662** |
| | **(E-2)** | **28** | **28** | **28** | **28** | **28** | **28** | **28** | **28** | **28** | **33** |
| **Leveling agent (F)** | **(F-1)** | **0.1** | **0.1** | **0.1** | **0.1** | **0.1** | **0.1** | **0.1** | **0.1** | **0.1** | **0.1** |

In Table 8, each component represents the following compounds.
Resin (B-1): Resin B-1 (in terms of solid content)
Polymerizable compound (C-1): Dipentaerythritol polyacrylate: trade name A-9550, manufactured by Shin-Nakamura Chemical Co., Ltd.
Polymerization initiator (D-1): N-acetyloxy-1-(4-phenylsulfanylphenyl)-3-cyclohexylpropane-1-one-2-imine: trade name PBG-327: O-acyloxime compound, manufactured by Changzhou Tronly New Electronic Materials Co., Ltd.
Solvent (E-1): Propylene glycol monomethyl ether acetate
Solvent (E-2): Ethyl lactate
Leveling agent (F-1): Polyether modified silicone oil: trade name Toray silicone SH8400, manufactured by Toray Dow Corning Co., Ltd.

### [Formation of Color Filter (Colored Coating Film)]

Onto a 2-inch square glass substrate (Eagle XG; manufactured by Corning Inc.), the colored composition prepared in each of Examples 1 to 9 and Comparative Example 1 was applied by a spin coating method and then pre-baked at 100°C for 3 minutes to form a colored composition layer. After being allowed to cool, the colored composition layer was irradiated with light without a photomask using an exposure machine (TME-150RSK manufactured by Topcon Corporation) in ambient atmosphere at an exposure dose of 60 mJ/cm² (365 nm standard). The colored composition layer that had been irradiated with light was post-baked in an oven at 230°C for 20 minutes to obtain a colored coating film. After being allowed to cool, the film thickness of the obtained colored coating film was measured using a film thickness measurement device (DEKTAK3 manufactured by Japan Vacuum Engineering Co., Ltd.).

### [Chromaticity Evaluation]

The obtained colored coating film was subjected to spectrometry with a colorimeter (OSP-SP-200 manufactured by Olympus Corporation), and xy chromaticity coordinates (x, y) and tristimulus value Y in the CIE-XYZ color system were measured using the characteristic function for a C light source.

### [UV Ashing Resistance Evaluation]

UV ashing resistance was evaluated by irradiating the obtained colored coating film with UV of 2000 mW/cm³ using an ultraviolet ozone cleaner (UV-312 manufactured by Technovision, inc.). The xy chromaticity coordinates (x, y) and Y were measured before and after the irradiation, and the color difference ΔEab* was calculated from the measurement values by the method described in JIS Z 8730:2009 (7. Method for calculating color difference). The results are shown in Table 9. A smaller ΔEab* value means that the degree of change in color is smaller. The colored coating film having ΔEab* of 5 or less can be practically used as a color filter without any problem. In addition, when the colored coating film has good UV ashing resistance, a colored pattern made from the same colored composition as the colored coating film also has good UV ashing resistance.

**[Table 9]**

| | **ΔEab*** |
|---|---|
| **Example 1** | **1.2** |
| **Example 2** | **1.6** |
| **Example 3** | **1.3** |
| **Example 4** | **1.9** |
| **Example 5** | **1.7** |
| **Example 6** | **3.3** |
| **Example 7** | **3.7** |
| **Example 8** | **0.8** |
| **Example 9** | **2.4** |
| **Comparative Example 1** | **8.6** |

### INDUSTRIAL APPLICABILITY

The colored composition of the present invention can form a color filter having excellent UV ashing resistance.

## Claims

1. A colored composition comprising a colorant and an alkali soluble resin,
wherein the colorant comprises a compound represented by formula (I):
A-L¹-B (I)
wherein
L¹ represents a group represented by formula (ph1);
A represents a group represented by formula (ia); and
B represents a group represented by formula (ib), 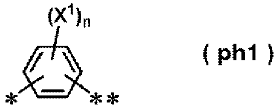 wherein
X¹ represents a substituent or a hydrocarbon group optionally having a substituent, -CH₂- contained in the hydrocarbon group may be replaced with -O-, -CO- or -NH-, and -CH= contained in the hydrocarbon group may be replaced with -N=;
n represents an integer of 0 to 4, when n is an integer of 2 or more, X¹s are the same or different, and when n is an integer of 2 or more and X¹s are bonded to adjacent carbon atoms, X¹s bonded to the adjacent carbon atoms may be combined with each other to form a ring; and
* represents a point of attachment to A, and ** represents a point of attachment to B, 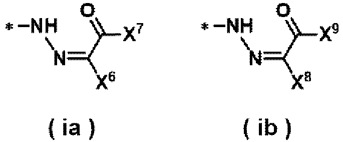 wherein
X⁶ to X⁹ each independently represent a hydrocarbon group optionally having a substituent, -CH₂- contained in the hydrocarbon group may be replaced with -O-, -CO- or -NH-, -CH= contained in the hydrocarbon group may be replaced with -N=, and -C< contained in the hydrocarbon group may be replaced with -N<;
X⁶ and X⁷ may be combined with each other to form a ring, and X⁸ and X⁹ may be combined with each other to form a ring; and
* represents a point of attachment to L¹.

2. The colored composition according to claim 1, wherein L¹ is a group represented by formula (ph2): 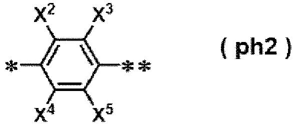 wherein
X² to X⁵ each independently represent a hydrogen atom, an alkyl group having 1 to 4 carbon atoms, an amino group, an amido group, a carboxyl group, an alkoxy group having 1 to 4 carbon atoms, an alkylthio group having 1 to 4 carbon atoms, a cyano group, or a halogen atom;
X² and X³ may be combined with each other to form a ring, and X⁴ and X⁵ may be combined with each other to form a ring; and
* represents a point of attachment to A, and ** represents a point of attachment to B.

3. The colored composition according to claim 1 or 2, wherein the group represented by the formula (ia) and the group represented by the formula (ib) are each independently any of groups represented by formulas (t1) to (t5): 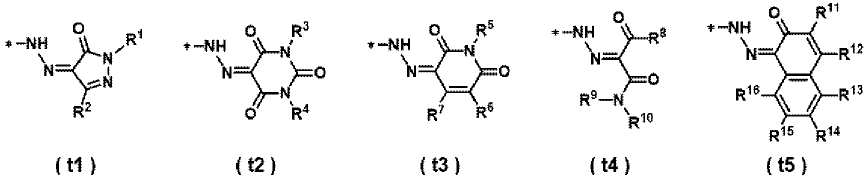 wherein
R¹ to R¹⁶ each independently represent a hydrogen atom, a hydrocarbon group optionally having a substituent, a heterocyclic group, a cyano group, or a halogen atom; and
* represents a point of attachment to L¹.

4. The colored composition according to any one of claims 1 to 3, further comprising a polymerizable compound and a polymerization initiator.

5. A color filter formed from the colored composition according to any one of claims 1 to 4.

6. A display device comprising the color filter according to claim 5.
